(19) Europäisches Patentamt
European Patent Office
Office européen des brevets

(11) EP 1 014 429 A1

(12) **EUROPEAN PATENT APPLICATION**
published in accordance with Art. 158(3) EPC

(43) Date of publication:
**28.06.2000 Bulletin 2000/26**

(21) Application number: **98914077.7**

(22) Date of filing: **17.04.1998**

(51) Int. Cl.$^7$: **H01L 21/027**, G03F 7/20

(86) International application number:
**PCT/JP98/01777**

(87) International publication number:
**WO 98/48452 (29.10.1998 Gazette 1998/43)**

(84) Designated Contracting States:
**AT BE CH CY DE DK ES FI FR GB GR IE IT LI LU MC NL PT SE**

(30) Priority: **18.04.1997 JP 11625597**
**25.04.1997 JP 10974897**
**14.05.1997 JP 12452797**

(71) Applicant: **Nikon Corporation**
**Tokyo 100-8831 (JP)**

(72) Inventors:
- **TANAKA, Yasuaki**
  **Nikon Corporation**
  **Tokyo 100-8331 (JP)**
- **NOBORU, Michio**
  **Nikon Corporation**
  **Tokyo 100-8331 (JP)**

(74) Representative:
**Rackham, Stephen Neil et al**
**GILL JENNINGS & EVERY,**
**Broadgate House,**
**7 Eldon Street**
**London EC2M 7LH (GB)**

(54) **METHOD AND DEVICE FOR EXPOSURE CONTROL, METHOD AND DEVICE FOR EXPOSURE, AND METHOD OF MANUFACTURE OF DEVICE**

(57) A method for exposure control comprising the steps of measuring the change of the transmissivity or transmittance for the light incident to the projection optical system prior to the exposure operation effected by illuminating a pattern on a reticle to form an image of the pattern on a photosensitive wafer through the projection optical system, storing the measured change of the transmissivity, sequentially measuring the amount of the light incident to the projection optical system during the exposure operation, calculating the exposure light amount for the photosensitive wafer from the exposure light amount based on the stored change of the transmissivity, and integrating the exposure from the start of the exposure operation to terminate the exposure operation when the total exposure light amount has reached a predetermined value. The total exposure light amount for the wafer surface can be controlled even if the transmissivity of the projection optical system fluctuates.

FIG. 1

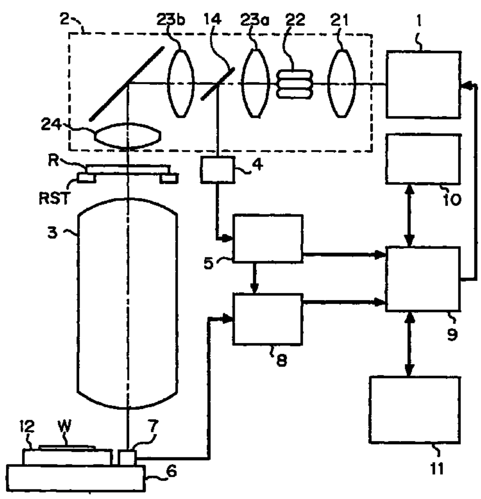


EP 1 014 429 A1

## Description

### TECHNICAL FIELD

The present invention relates to a projection exposure apparatus for use in a lithography process in a manufacture line for manufacturing semiconductor devices, liquid crystal display devices, and so on. Further, the present invention relates to a projection exposure method which uses such a projection exposure apparatus in the lithography process. Moreover, the present invention relates to a method for the manufacture of a device such as, for example, semiconductor elements, image pickup elements (CCDs, etc.), liquid crystal display elements, thin film magnetic heads, and so on, by transcribing a device pattern on a mask onto a photosensitive substrate by means of the projection exposure apparatus.

### BACKGROUND TECHNOLOGY

There are known plural types of projection exposure apparatuses for transcribing a pattern of a reticle as a mask onto each shot region on a wafer with a photoresist coated thereon, upon manufacturing, for example, semiconductor elements, and so on. The projection exposure apparatuses of plural types may include, for example, a reduced projection exposure apparatus (a stepper) of a step-and-repeat type (of an overall exposure type) and a projection exposure apparatus of a so-called step-and-scan type which is so adapted as to transcribe a reduced image of the pattern on the reticle sequentially on each of shot regions on the wafer by scanning the reticle and the wafer in synchronization with a projection optical system in such a state that a portion of the pattern on the reticle onto the wafer through the projection optical system in a reduced manner.

In exposing the wafer by means of such a projection exposure apparatus, it is necessary to irradiate the wafer with an exposure light at a predetermined exposure light amount sufficient to expose a photoresist to light and sense it on the basis of characteristics such as, for example, sensitivity of the photoresist coated on the wafer. In the case where the light amount of the exposure light to be irradiated on a wafer during exposure is known, a predetermined total exposure light amount can be provided in an exposure region on the wafer by controlling the exposure time, on the one hand, in the case where the projection exposure apparatus is of a step-and-repeat type, and by controlling the scanning velocity or the like, on the other hand, in the case where the projection exposure apparatus is of a step-and-scan type.

For conventional projection exposure apparatuses, a total exposure light amount on the wafer surface is obtained by computation from an incident light amount incident to a projection optical system and a transmittance or transmissivity of the projection optical system, assuming that a transmittance of the projection optical system does not fluctuate and is always stayed constant during the exposure.

The transmittance of the projection optical system is computed from an leaving light amount of the light leaving from the projection optical system and an incident light amount of the light incident to the projection optical system, by measuring the leaving light amount, prior to starting the exposure operation, by means of an irradiation amount monitor disposed in a region separate from a wafer on a wafer stage.

Recently, a degree of integration for semiconductor devices and so on has become higher and higher, so that it is required to shorten a wavelength of the exposure light for use in projection exposure, in order to compete with a degree of minuteness of a line width of a pattern to be exposed. Thus, projection exposure apparatuses have been launched, which use an illumination light of an ultraviolet wavelength region, such as, for example, a Krf excimer laser having an oscillating wavelength of 248 nm or an ArF excimer laser having an oscillating wavelength of 193 nm. It has now been found by us, however, that in the case where such projection exposure apparatuses use a projection optical system of a reflection-refraction type or of a refraction type, a transmittance of quartz which is used for an optical element of the projection optical system thereof and a transmittance of a coating formed on surfaces of quartz and a lens may fluctuate in such ultraviolet wavelength, upon irradiation with such a laser light.

Therefore, when such a light in an ultraviolet wavelength region (for example, KrF excimer laser having a wavelength of 248 nm or ArF excimer laser having a wavelength of 193 nm, etc.) is irradiated as an illumination light, the irradiation of such an illumination light may cause the problem with fluctuation of a transmittance of an optical element or an coating material (for example, a thin film such as a reflection preventive film, etc.) for the optical element. Further, new problems may arise such that a transmittance of the projection optical system may be caused to fluctuate due to foreign materials which may be generated from gases (e.g., air. etc.) present in a space interposed among plural optical elements, or from adhesive for use in fixing the, optical elements to barrels of mirrors, or from foreign materials (e.g., water, hydrocarbons or other substances for diffusing an illumination light. etc.) derived from an inner wall of the barrel, and which are attached on the optical element or enter in an illumination light path or are floating therein.

Therefore, even if the total actual exposure light amount to the wafer would be controlled by measuring only the incident light amount of the illumination light incident to the projection optical system during the exposure on the basis of the assumption that the transmittance of the projection optical system would be stayed at a constant level as in conventional techniques, the problem may be caused such that an error in the total actual exposure light amount in the wafer surface is caused to occur by a portion corresponding to a fluctuation of the projection optical system during the exposure and an optical exposure light amount cannot be provided on a photoresist on the wafer.

Further, when the attached materials is detached from the surface of the optical system by irradiation of a light in an ultraviolet region, a transmittance of the optical system is allowed to rise by an actual exposure (i.e., by irradiating the mask with an exposure light by an illumination optical system and projecting a pattern on a mask onto a photosensitive substrate by the projection optical system).

A brief description will be made of the such phenomenon with reference to Fig. 31. Fig. 31 shows a graph showing a distribution of transmittances in states after passage of the exposure light through the optical element for a predetermined period of time. In the graph of Fig. 31 which the coordinates on an image plane (a wafer plane) in an original section are indicates by representing a transmittance (%) on the Y-axis and representing a light axis as an original point on the X-axis. Fig. 31(a) shows a transmittance distribution in a reference state; Fig. 31(b) shows a state in which a predetermined period of time (duration A) has elapsed since the stop of the exposure; Fig. 31(c) shows a state in which the exposure light has passed through the optical element after an elapse of another period of time (duration B) from the state as shown in Fig. 31(b); Fig. 31(d) shows a state in which the exposure light has further passed through the optical element after an elapse of a further additional period of time (duration C) from the state as shown in Fig. 31(c); and Fig. 31(e) shows a state in which the exposure light has further passed through the optical element after an elapse of a still further additional period of time (duration D) from the state as shown in Fig. 31(d).

As shown in Figs. 31(a) to 31(e), inclusive, the problems may also arise such that a distribution of transmittances of the optical system may fluctuate as well as transmittances of the optical system in the projection exposure apparatus may fluctuate.

The fluctuation of the transmittance and the distribution of the transmittances may cause the problems that a deviation of the exposure light amount to be provided on the photosensitive substrate from an appropriate value to a great extent and an irregularity of the exposure light amounts (an irregularity of illuminance) is caused to occur in an exposure region on the photosensitive substrate (a distribution of the exposure light amount (a distribution of illuminance) being deviated from a desired state) in the exposure region). If such an irregularity of the illuminance is caused to occur in the exposure region, the exposure light amounts cannot be distributed in the exposure region in an appropriate manner so that the problems may arise in that line widths may become irregular and devices may become poor in quality.

DISCLOSURE OF THE INVENTION

The present invention has the object to prevent a fluctuation of an imaging characteristic of a projection optical system due to a variation in transmittance.

The present invention has another object to provide a method for controlling an exposure light amount and a device for controlling an exposure light amount as well as an exposure method and an exposure apparatus, each being so adapted as to control an accumulated exposure light amount of light to be irradiated on a wafer, without undergoing an influence from a variation in transmittance of the projection optical system.

The present invention has a further object to provide a manufacture method for manufacturing a circuit element (a device), which can form a pattern on a substrate in a favorably imaging state always at an optimal exposure light amount, even if the such fluctuation of the transmittance would be caused to occur during transferring the mask and the substrate in synchronism with each other.

The present invention has a still further object to provide a manufacture method for manufacturing a circuit element device, which can form an image of a pattern on a substrate in a favorably imaging state always at an optimal exposure light amount, even if the such fluctuation of the transmittance would be caused to occur.

The present invention has a still further object to provide a method for transcribing a device pattern formed on a mask onto a photosensitive substrate without undergoing an influence from an irregularity of illuminance over an entire area of an exposure region.

In order to achieve the objects as described above, the present invention provides an exposure light amount control method for controlling an exposure light amount on a substrate upon projecting and exposing an image of the pattern on the table onto the substrate through the projection optical system by illuminating the pattern on the reticle, which is characterized by the step of computing an exposure light amount on the substrate on the basis of a variation in an attenuation factor (a variation in transmittance of an incident light amount incident to the projection optical system) of a light amount of light passing through the projection optical system. It is to be noted herein that, in the transmittance of the projection optical system as referred to in connection with the present invention, a reflectance or reflectivity of a reflecting member is also taken into account, in the case where the projection optical system contains the reflecting member. Moreover, the exposure light amount control method is characterized by further containing the step of comparing the exposure light amount with a predetermined exposure light amount. In addition, an illumination light for illuminating a reticle is characterized by having a wavelength of 250 nm or less. The illumination light has a wavelength of, preferably, 220 nm and, more preferably, 200 nm or less. The method further comprises the step of measuring a variation in transmittance of the incident light amount of the light incident to the projection optical system and the step of saving the variation in transmittance thereof.

Further, the present invention provides the exposure light amount control method for controlling the exposure light amount on the substrate upon projecting and exposing a pattern on the reticle onto the substrate through the projection optical system by illuminating the reticle with a pulse light and scanning the reticle and the substrate in synchronism with each other, the exposure light amount control method being characterized further by the step of computing the exposure light amount on the substrate on the basis of a variation in transmittance of the incident light amount incident to the projection optical system. Moreover, the exposure light amount control method is characterized by the step of controlling the exposure light amount on the substrate by varying at least one of a scanning velocity of the reticle and the substrate, a timing of emitting the pulse light, an intensity of the pulse light, and a magnitude of the scanning directional of the pulse light.

Furthermore, the present invention provides the exposure method for projecting an image of the pattern onto the substrate through the projection optical system by illuminating the pattern on the reticle, the exposure method being characterized by the step of computing the exposure light amount on the substrate and the step of accumulating the exposure light amount and terminating the exposure as the accumulated exposure light amount has reached a predetermined exposure light amount.

In addition, the present invention provides the exposure light amount control apparatus for controlling the exposure light amount for projecting and exposing the pattern on the reticle onto the substrate through the projection optical system, the exposure light amount control apparatus comprising a memory section for saving a variation in transmittance of the projection optical system and a control unit for computing the exposure light amount on the substrate on the basis of the variation in transmittance saved in the memory section.

The present invention further provides the manufacture method for manufacturing circuit elements by illuminating the pattern on the reticle and projecting an image of the pattern on the substrate through the projection optical system, the manufacture method being characterized by controlling the exposure light amount on the substrate on the basis of a variation in transmittance of the projection optical system.

The present invention utilizes the concept that the variation in transmittance from the start of irradiation of a laser light indicates a predetermined variation amount in accordance with the amount of irradiation. The total exposure light amount on the photosensitive substrate can be controlled, for instance, by measuring the variation in transmittance and saving it in advance and computing the light amount on the photosensitive substrate sequentially and accumulating the light amounts, while the incident light amount incident to the projection optical system from the start of exposure, i.e., from the start of irradiation of the laser light upon the actual exposure, by multiplying the incident light amount by the variation in transmittance saved. Therefore, the present invention can compute the light amount irradiated on the photosensitive substrate always with high precision during a period of time from the start of the exposure to the termination of the exposure and control the accumulated exposure light amount on the photosensitive substrate, even if the transmittance of the projection optical system would vary with the exposure light amount.

The present invention is directed to the device manufacture method for manufacturing devices, including the step of illuminating the mask with the exposure light of ultraviolet rays through the illumination optical system and projecting a device pattern on the mask onto the photosensitive substrate through the projection optical system, the method comprising the first step of deciding to determine whether an amount of an attenuation factor (a transmittance or transmissivity of the illumination optical system and the projection optical system) of a light amount from the illumination optical system and the projection optical system varies or not, the second step of irradiating the projection optical system with the exposure light for a predetermined period of time, when it is decided in the first step that the attenuation factor (transmittance) varies, and the third step of projecting the device pattern onto the photosensitive substrate after the second step.

The present invention is further directed to the projection exposure apparatus for carrying out an actual exposure that comprises illuminating the mask with the illumination optical system supplying the exposure light of an ultraviolet region and projecting the device pattern on the mask onto the photosensitive substrate by means of the projection optical system, the projection exposure apparatus being provided with a control means for controlling the illumination optical system by deciding to determine whether the transmittance of the illumination optical system and the projection optical system varies and by irradiating the illumination optical system and the projection optical system with the exposure light for a predetermined period of time prior to the actual exposure, when it is decided that the transmittance of the illumination optical system and the projection optical system varies.

In accordance with the present invention, the control means provided in the projection exposure apparatus is so adapted as to confirm a status of the projection exposure apparatus and a history of the status thereof, prior to starting the operation of the actual exposure. The control means is saved with a condition in which a state of attachments on a lens surface (a reflecting surface) of the optical system varies, and the condition is associated with the status of the projection exposure apparatus and the history thereof. Further, the control means is adapted to irradiate the optical system (the illumination optical system and the projection optical system) of the projection exposure apparatus with a light source of light having a wavelength substantially equal to the exposure light, prior to the start of the operation of the actual exposure, when the confirmed status and history agree with the saved condition as a result of comparison of the confirmed status and history with the saved condition. This removes the attachments of foreign materials, etc. on the surface of the optical system, so that the exposure light amount can be controlled with high precision because an output of a sensor for sensing the exposure light amount corresponds to the exposure light amount on the photosensitive substrate in order to stabilize the transmittance of the optical system ranging from the sensor for sensing the exposure light amount disposed in an intermediate position of the projection optical system to the photosensitive substrate.

It is to be noted herein that, as it is preferred that the time for irradiation of the optical system of the projection exposure apparatus with a light varies with a state of the attached materials, the control means is preferably saved with information relating to the time for irradiation with the light that is associated with the status of the projection exposure apparatus and the history thereof.

A description will be made of the condition in which the state of the attached materials varies.

The conditions of a variation in the state of the attached materials include, among others:

(1) No irradiation of the optical system of the projection exposure apparatus with the exposure light or the like for a predetermined period of time;
(2) Changes of the condition for illumination;
(3) Exchanges for reticles (masks);
(4) Practice of maintenance;
(5) Termination of the operation of an air conditioning device;
(6) Termination of the operation of an entire exposure apparatus;
(7) Variation in a state of an atmosphere around the illumination optical system and the projection optical system;
(8) Variation of transmittance of the illumination optical system and the projection optical system themselves;
(9) Changes of optical characteristics of the projection optical system; and
(10) Changes of a reflectance of the surface of a photosensitive substrate.

A description will now be made of the instance in which, as the condition (1) above, the optical system of the projection optical system is not irradiated with an exposure light or the like for a predetermined period of time or longer. In this instance, there is the risk that transmittance of the optical system itself is decreased to a lower level than the time when the irradiation has been previously been effected, because there is the possibility that foreign materials etc. would be attached in an amount larger than they have been at the previous irradiation. Moreover, in this instance, the extent to which the foreign materials etc. attached are removed as the irradiation with the actual exposure light starts and develops, so that the risk may be caused to occur that the controls of the exposure light amount suffer from the difficulty due to a fluctuation of the transmittance of the optical system itself in accordance with the irradiating period of time. Therefore, in order to compete with the difficulty, the attached foreign materials etc. are removed by irradiating the optical system with the light prior to the actual exposure, so that the transmittance of the optical system is improved to stabilize the transmittance of the optical system. In this instance, it is preferred that a duration during which the irradiation of the optical system has been suspended is determined and the period of time for irradiating the optical system with the light before the actual exposure is adjusted in accordance with the determined duration. This configuration can avoid the irradiation with the light more than necessary, so that the duration of the irradiation with light can be shortened and damages against the optical system can be minimized.

Then, a description will be made of the instance where the condition (2) for illumination is changed. The illumination conditions may include, for example, a state of a distribution of images of a light source on a pupil plane (for example, a large σ value, a small σ value, a zonal illumination, a special oblique illumination. etc.). In such an instance, the way of passage of a light flux passing through the inside of the optical system changes, so that a distribution of the intensity of the light may vary with each portion of the optical system. Therefore, the effect to be achieved by removal of the attached materials, etc. by the irradiation with light may vary with each portion of the optical system, so that the risk may be caused to occur that the transmittance of the entire optical system may fluctuate. For instance, when the illumination condition is changed from a small σ value to a large σ value, there may be the instance where no attached materials are removed at a portion where no light flux passes upon the actual exposure and yet where the light flux passes upon the actual exposure at the large σ value. There is the risk that the transmittance of the optical system may fluctuate upon the actual exposure at the large σ value.

Therefore, in the case of the condition (2) above, too, the attached materials are removed by the irradiation of the optical system with light prior to the actual exposure, so that the transmittance of the optical system can be improved and the transmittance of the optical system can be stabilized. In this instance, the optical system can be stabilized in a more effective way by investigating illumination conditions prior and after the change of the illumination condition and adjusting the duration of the irradiation with light prior to the start of the actual exposure in accordance with a combination of the illumination conditions investigated. In such an instance, if the illumination condition is changed, for example, from the small σ value to the large σ value, the irradiation would not be required.

The condition (3) above where the reticles (masks) are exchanged will be described. The pattern formed on the reticle varies with kinds of reticles, so that the state in which a diffraction light is created from the pattern varies for each kind of the reticle. At this time, the way of passage of the light flux passing through the inside of the projection optical system varies, so that a distribution of the intensity of the light varies at each portion of the projection optical system. Therefore, the effect to be produced by the removal of the attached materials by means of the irradiation with light may vary at each portion of the projection optical system, so that the risk may occur such that the transmittance of the entire projection optical system is caused to fluctuate. Accordingly, in this instance, too, the attached materials are removed by irradiation of the optical system with light prior to the actual exposure, so that the transmittance of the optical system is improved and the transmittance of the optical system is stabilized. At this time, it is preferred that the projection exposure apparatus is further provided with an ID number reading device for reading an ID number formed on a reticle and database for the reticle. With this configuration, the duration for the irradiation with light prior to the start of the actual exposure can be adjusted in accordance with the kind of the reticle prior and after the exchange, thereby stabilizing the optical system in a more effective way.

A description will be made of the condition (4) above where maintenance has been performed. During maintenance, coverings for the optical system and other parts may be detached, so that the atmosphere inside the optical system is exchanged for the ambient atmosphere outside the optical system. As a result, there is the possibility that a concentration of attaching foreign materials etc. in the atmosphere inside the optical system may vary. Further, at this time, the risk may occur such that the transmittance of the optical system may be caused to fluctuate from the previous irradiation, due to attachment or detachment of the attached materials to or from the optical system. In this instance, too, the attached materials etc. are to be removed by the irradiation of the optical system with light prior to the actual exposure, thereby improving the transmittance of the optical system and as a result stabilizing the transmittance of the optical system. In this case, it is preferred that a covering or other part is provided with a switch for deciding to determine whether the maintenance has been performed or not. Moreover, it is preferred to vary a duration for the irradiation with light prior to the start of the actual exposure in accordance with a duration of time when the covering is being kept open by accumulating the open duration or otherwise. This configuration can stabilize the optical system in a more efficient way. If the duration when the covering has been kept open is shorter than a particular duration, the irradiation prior to the exposure can be omitted.

Then, a description will be made of the condition (5) where the operation of the air conditioning device is suspended. Under this condition, the state of the atmosphere around the optical element constituting the illumination optical system and the projection optical system changes, so that the risk may occur that the state of attached materials etc. may be changed. In this instance, too, the attached materials are removed by irradiation of the optical system with light prior to the actual exposure, thereby improving the transmittance of the optical system and consequently stability the transmittance of the optical system. Upon this irradiation with light, it is preferred to adjust the duration of the irradiation with light prior to the actual exposure in accordance with the period of time during which the operation of the air conditioning device has been suspended.

A description will be made of the condition (6) where the operation of the entire system of the projection exposure apparatus has been suspended. Under this condition, the irradiation of the laser light has been suspended as in the case of the condition (2) above and the operation of the air conditioning device has been suspended as in the case of the condition (5) above, so that the risk may occur such that the state of the attached materials, etc. fluctuates. In this instance, too, the attached materials etc. are removed by the irradiation of the optical system with light prior to the actual exposure, so that the transmittance of the optical system is improved and as a result the transmittance of the optical system is stabilized. Upon this irradiation with light, it is preferred to adjust the duration of the irradiation with light prior to the actual exposure in accordance with the period of time during which the operation of the exposure apparatus has been suspended.

Moreover, a description will be made of the condition (7) where the state of the atmosphere around the illumination optical system and the projection optical system has been changed. The state of the atmosphere may include, for example, a temperature, moisture or pressure of the atmosphere, a flow rate of gases flowing inside the optical system in a state that the illumination optical system and the projection optical system has been closed in an airtight fashion, among others. In the case where the state of the atmosphere has varied in such a manner, there is the risk that the state of the attached materials, etc. has changed, too, so that the irradiation with light is to be effected prior to the actual exposure. Upon this irradiation with light, it is preferred that the duration for the irradiation with light prior to the actual exposure be adjusted in accordance with a degree of the change of the atmosphere.

Now, a description will be made of the case under the condition (8) where the transmittance of the illumination optical system and the projection optical system themselves has been changed. It is to be noted herein that, in each of the cases of the conditions (1) to (7), inclusive, the state of the attached materials etc. is regarded as being changed when the projection exposure apparatus has been brought into a particular state, however, the configuration can be modified so as to detect a pollution of the optical system and to make a decision as to whether the irradiation with light should be effected or not prior to the actual exposure on the basis of a result of detection of the pollution. Such a configuration may include, for example, a direct measurement of the transmittance of the illumination optical system and the projection optical system themselves, a measurement of a sample for use in measuring a transmittance thereof, disposed at a position in the vicinity of those optical systems, and a measurement of a concentration of pollutants in the atmosphere around those optical systems. In this configuration, for instance, the irradiation with light is to be effected prior to the actual exposure to stabilize the optical systems, when the transmittance of the optical system is lower than a predetermined value, or when the concentration of the pollutants exceeds a predetermined value, or when a value obtained by integrating the concentration of the pollutants by time is larger than a predetermined value. In addition, the duration of the irradiation with light prior to the actual exposure can be adjusted in accordance with the transmittance measured or the concentration of the pollutants measured.

Further, a description will be made of the condition (9) where the optical characteristic of the projection optical system has been changed. For instance, in the case where a size of an opening diaphragm in the projection optical system is changed in a manner as will be described hereinafter or where a pupil filter is inserted or detached, there is the risk that the state of the attached materials etc. is changed, too. In such an instance, the irradiation with light is effected prior to the actual exposure.

In addition, a description will be made of the condition (10) where the reflectance on the surface of the photosensitive substrate has been changed. In this instance, the light amount of the light to be returned to the surface of the photosensitive substrate upon the actual exposure is changed, too, so that the effect to be achieved upon the actual exposure by the removal of the attached materials, etc. may produce different effects. In this instance, the transmittance of the optical system also varies, so that the irradiation with light is effected prior to the actual exposure, thereby stabilizing the optical system.

The present invention is further directed to the projection exposure apparatus having a light source for generating an exposure light having a wavelength of a ultraviolet region, an illumination optical system for leading the exposure light from the light source to a pattern on the mask, and a projection optical system for forming an image of the pattern on the mask in a predetermined exposure region on a photosensitive substrate, the projection exposure apparatus comprising a memory means for saving information relating to a variation in a distribution of transmittances resulting from passage of the exposure light from the light source through at least the projection optical system; an illuminance distribution adjustment means for adjusting a distribution of illuminance in the exposure region; and a control means for controlling the illuminance distribution adjustment means so as to maintain the distribution of illuminance in the exposure region on the basis of the information from the memory means, the control means being connected to the memory means and the illuminance distribution adjustment means.

The information relating to the variation in the distribution of illuminance saved in the memory means for use in accordance with the present invention is not restricted to the variation in the distribution of transmittance and may include any information corresponding to a variation in the distribution of transmittance. In accordance with the present invention, as the information relating to the variation in the distribution of transmittance, it is preferred to use, for example, information relating to a distribution of illuminance in the exposure region.

In a first preferred mode of the embodiment of the present invention, the projection exposure apparatus is further provided with a measurement means for measuring the distribution of illuminance in the exposure region, wherein the control means amends at least a portion of the information from the memory means on the basis of the information from the measuring means and controls the illuminance distribution adjustment means on the basis of the information so amended.

In this configuration, an amendment on the basis of the information from the measuring means is made at predetermined number of times per unit time, and the predetermined number of times of amendments may preferably be determined in accordance with a magnitude of the amount of the variation per unit time of the distribution of transmittance saved in the memory means.

In a second preferred mode of the embodiment of the present invention, the information on the variation in the distribution of transmittance is saved in the memory means in association with at least one of a period of time during which the exposure light passes through the illumination optical system and the projection optical system, a condition for illuminating the mask, a kind of masks, an optical characteristic of the projection optical system, and a light amount of the light reflected at the photosensitive substrate and returned to the projection optical system.

In a third preferred mode of the embodiment of the present invention, the memory means is arranged so as to save information relating to the variation in the distribution of transmittance resulting from passage of the light through the illumination optical system.

Moreover, the present invention provides the projection exposure apparatus having a measurement means for measuring the distribution of illuminance in the exposure region by means of the exposure light through the mask, a memory means for saving information relating to the distribution of illuminance in the exposure region by means of the exposure light through the mask in a predetermined initial state, an illuminance distribution adjustment means for adjusting the distribution of illuminance in the exposure region, and a control means for controlling the illuminance distribution adjustment means for maintaining the distribution of illuminance in the exposure region at a constant level on the basis of a result of measurement by the measurement means and the information from the memory means.

In this configuration, the information relating to the distribution of illuminance in the memory means may preferably be information relating to a distribution of illuminance in the exposure region in a state in which the distribution of transmittance of the mask (the distribution of reflectance in the case of a reflective mask) is uniform. The state in which the distribution of transmittance of the mask is uniform, so referred to herein, may also include, for example, a state in which the mask is detached from the light path.

The projection exposure apparatus according to the present invention in the configuration as described above is adapted to acquire a variation in the distribution of transmittance of the illumination optical system and the projection optical system, which results upon passage of the exposure light from the light source through the illumination optical system and the projection optical system on the basis of an experiment in advance and save the variation in the distribution of transmittance in the memory means. Upon the actual exposure, a distribution of transmittance in the exposure region is estimated on the basis of the information saved in the memory means, and the illuminance distribution adjustment means is controlled so as to correct an irregularity of illuminance in the exposure region resulting from the distribution of transmittance. In this configuration, the irregularity of illuminance can be corrected without measuring the irregularity of illuminance on the exposure region even if the actual exposure is being effected.

At this time, the distribution of illuminance in the exposure region may be measured at a predetermined time interval and an estimated value of the distribution of transmittance in the exposure region may be amended on the basis of a result of measurement. This allows the estimated value of the distribution of transmittance in the exposure region to become closer to an actual value on the basis of the result of measurement, thereby further improving a precision of the correction of the irregularity of illuminance.

The time interval referred to herein may be set to become a shorter interval when an amount of the variation in the distribution of transmittance per unit time is larger and to become a longer interval when the amount of the variation in the distribution of transmittance per unit time. This allows an improvement in precision of the correction of the irregularity of illuminance without increasing the number of measurements so much (in other words, without decreasing a throughput).

In the instance as shown in Fig. 31, the variation in the distribution of transmittance is based on only the period of time (the period of time during which no exposure light passes) during which the exposure light passes through the illumination optical system and the projection optical system, as a parameter. As a parameter for causing the distribution of transmittance to vary, an illumination condition may also be used, in addition to the period of time during which the exposure light has passed through the illumination optical system and the projection optical system. This configuration will be described hereinafter with reference to Fig. 32. In Fig. 32, there is shown a state of a light flux passing through a projection optical system PL. Further, Fig. 32 shows the state of the light flux in the case of the large σ value, as shown in Fig. 32(a), in the case of the small σ value, as shown in Fig. 32(b), and in the case of a modified illumination such as a zonal illumination or a special oblique inclination illumination, etc, as shown in Fig. 32(c). Moreover, in Figs. 32(a) to (c), the light flux on the axes ranging from the point on the light axis of the projection optical system PL in the reticle R is indicated by hatching the area, and the main light rays intersecting with the light axis at the position of an opening diaphragm AS is indicated by broken line. As is apparent from Figs. 32(a) to 32(c), the position of the light flux passing through the projection optical system PL may vary with the condition (large σ value, small σ value, and a varied illumination) of illuminating the reticle R, and the distribution in intensity of the light flux of each of the optical elements constituting the projection optical system PL may vary (in a strict sense, it may vary in the illumination optical system). Therefore, the attached materials, etc. to be removed by passage of the exposure light through the illumination optical system and the projection optical system at the time of exposure are not removed in a uniform manner at each of the optical elements and are removed in an irregularly distributed manner. Accordingly, as shown in Figs. 33 and 34, the distribution of variations in transmittance may vary with the illuminating condition.

Fig. 33 shows a variation in transmittance in the case of the small σ value as indicated in Fig. 32(b), and Fig. 34 shows a variation in transmittance in the case of a varied illumination as shown in Fig. 32(c). In each of Figs. 33 and 34, the Y-axis represents transmittance (%) and the X-axis represents the coordinate on an image plane (a wafer plane) in a meridional section in which the light axis is set as an original point. Figs. 33(a) and 34(a) show each a distribution of transmittance in the reference state; Figs. 33(b) and 34(b) show each the state after the exposure has been suspended for a predetermined time (duration A); Figs. 33(c) and 34(c) show each the state in which the exposure light has passed through the optical system for a predetermined time (duration B) after the state as shown in Figs. 33(b) and 34(b); Figs. 33(d) and 34(d) show each the state in which the exposure light has passed through the optical system for a predetermined time (duration C) after the state as shown in Figs. 33(c) and 34(c); and Figs. 33(e) and 34(e) show each the state in which the exposure light has passed through the optical system for a predetermined time (duration D) after the state as shown in Figs. 33(d) and 34(d).

The variation in the distribution of transmittance of the illumination optical system and the projection optical system, which results from passage of the exposure light through the illumination optical system and the projection optical system may also be changed by a parameter other than the time during which the exposure light has passed through the illumination optical system and the projection optical system.

It is thus preferred that the variation in the distribution of transmittance of the illumination optical system and the projection optical system resulting from passage of the exposure light through the illumination optical system and the projection optical system is saved in association with a least one of parameters as will be described hereinafter. For the entire projection exposure apparatus, at least one of the parameters is detected and information saved in the memory means corresponding to a result of detection is read, thereby controlling the illuminance distribution adjustment member on the basis of the information.

The parameters include, among others:

(1) A time during which the exposure light passes through the illumination optical system and the projection optical system;
(2) An illuminating condition for illuminating a mask (a magnitude of a σ value, a zonal illumination, and a special oblique illumination);
(3) A kind of a mask (a density of patterns, etc.);
(4) An optical characteristic of the projection optical system (a size of an opening diaphragm, an ambient environment (pressure, temperature, moisture, an environment of purge, a presence or absence of a filter, etc.); and
(5) A light amount reflected at a photosensitive substrate and returned to the projection optical system (corresponding to a reflectance of a wafer).

In another mode of the projection exposure apparatus according to the present invention, the distribution of illuminance is measured by the exposure light through the mask (reticle) in a state in which the illumination optical system and the projection optical system are located each in a predetermined condition and the measured distribution in illuminance is saved in the memory means, in order to measure the distribution of illuminance in the exposure region in a state in which the mask (reticle) is loaded. In this configuration, an actual distribution of illuminance can be determined by comparing the distribution of illuminance measured in the state in which the mask is loaded with the distribution of illuminance saved in the memory means. The projection exposure apparatus in another mode according to the present invention can provide the advantages that the time required for measurement can be shortened and further a throughput can be improved, because the distribution of illuminance in the exposure region can be measured without departing the mask from the light path.

The information relating to the distribution of illuminance to be saved in the memory means may be saved in accordance with classifications, for example, each of kinds of the masks and each of kinds of illumination conditions. The such information is read from the memory means in accordance with the kinds of the masks loaded on the apparatus or the illuminating conditions, upon making a comparison of the kinds and the illuminating conditions. In the case of a scanning exposure apparatus, the state of diffraction light generated from a mask may vary in accordance with the position of the illumination region on the mask, and the distribution of illuminance by the exposure light through the mask may vary, too. Therefore, the information in the memory means may preferably be associated with the scanning position (the position of the mask with respect to the illumination region), because the distribution of illuminance by the exposure light through the mask may vary.

It can be noted herein that, upon measurement in advance, for instance, there is used a mask having no pattern uniform in a distribution of transmittance, or the measurement may be effected in a state in which the mask is detached from the light path.

BRIEF DESCRIPTION OF THE ACCOMPANYING DRAWINGS

Fig. 1 is a view showing a brief configuration of a projection exposure apparatus which uses an exposure light amount control method according to a first embodiment of the present invention.
Fig. 2 is a view showing a variation of transmittance of the projection optical system with an elapse of time.
Fig. 3 is a view showing procedures for controlling an exposure light amount upon exposure in the exposure light amount control method according to this embodiment of the present invention.

Fig. 4 is a view showing a brief configuration of a projection exposure apparatus according to a second embodiment of the present invention, using an exposure light amount control method.

Fig. 5 is a view for explaining details of an operation section 45 in Fig. 4.

Fig. 6 is a view showing a flow of steps for manufacturing semiconductor elements.

Fig. 7 is a view showing schematically a projection exposure apparatus according to a third embodiment of the present invention.

Fig. 8 is a view showing the configuration of a stage portion of the projection exposure apparatus as shown in Fig. 7.

Fig. 9 is a view for explaining techniques for measuring a transmittance according to a modification in a mode of the embodiment of the present invention.

Fig. 10 is a view showing a brief configuration of a projection exposure apparatus according to a fourth embodiment of the present invention.

Fig. 11 is a view showing an example of an illuminance distribution adjustment means of the projection exposure apparatus of Fig. 10.

Fig. 12 is a view showing a configuration of a reticle stage of the projection exposure apparatus of Fig. 10.

Fig. 13 is a view showing a configuration of an X-Y stage of the projection exposure apparatus of Fig. 10.

Fig. 14 is a schematic construction view showing a relationship of the reticle stage with the X-Y stage of the projection exposure apparatus of Fig. 10.

Fig. 15 is a view showing an example of a measurement means of the projection exposure apparatus of Fig. 10.

Fig. 16 is a view showing a configuration of a projection optical system of the projection exposure apparatus of Fig. 10.

Fig. 17 is a flow chart showing an example of an exposure sequence of the projection exposure apparatus of Fig. 10.

Fig. 18 is a view for explaining techniques for adjusting a distribution of illuminance for the projection exposure apparatus of Fig. 10.

Fig. 19 is a table showing an example of a history table of the projection exposure apparatus of Fig. 10.

Fig. 20 is a table showing an example of a history table of the projection exposure apparatus of Fig. 10.

Fig. 21 is a table showing an example of a history table of the projection exposure apparatus of Fig. 10.

Fig. 22 is a table showing an example of a history table of the projection exposure apparatus of Fig. 10.

Fig. 23 is a flow chart showing an example of a sequence of an illuminance distribution adjustment of the projection exposure apparatus of Fig. 10.

Fig. 24 is a view showing a periodical variation by irradiation of illuminance at a certain one point on an exposure region.

Fig. 25 is a view showing another example of the measurement means of the projection exposure apparatus of Fig. 10.

Fig. 26 is a view showing a brief configuration of the projection exposure apparatus according to a fifth embodiment of the present invention.

Fig. 27 is a view showing the configuration of a reticle stage of the projection exposure apparatus of Fig. 26.

Fig. 28 is a view showing the configuration of an X-Y stage of the projection exposure apparatus of Fig. 26.

Fig. 29 is a view showing a portion of the measurement means of the projection exposure apparatus of Fig. 26.

Fig. 30 is a view showing an example of the illuminance distribution adjustment means according to another embodiment of the present invention.

Fig. 31 is a view showing a manner of a variation in distribution of transmittance.

Fig. 32 is a view showing a state of a light flux passing through the projection optical system PL.

Fig. 33 is a view showing a variation in transmittance in a state as shown in Fig. 32(b).

Fig. 34 is a view showing a variation in transmittance in a state as shown in Fig. 32(c).

## BEST MODE FOR CARRYING OUT THE INVENTION

A description will be made of an exposure light amount control method according to the first embodiment of the present invention with reference to Fig. 1 to 3. Fig. 1 shows a brief configuration of the projection exposure apparatus of a step-and-repeat type, which uses the exposure light amount control method according to the first embodiment of the present invention. Fig. 2 shows a periodical variation of transmittance of the projection optical system. Fig. 3 shows the procedures of the controls of the exposure light upon exposure in the exposure light amount control method according to this embodiment.

In Fig. 1, the illumination light emitting from an illumination light source 1 composed of KrF excimer laser (a wavelength of 248 nm) or ArF excimer laser (a wavelength of 193 nm) passes through an illumination optical system 2. composed of an input lens 21, a fly-eye lens 22, a relay lens system 23a, a relay lens system 23b and a condenser lens 24, and so on, and irradiates an entire area of a circuit pattern drawn on the reticle R at a uniform light amount. The illumination light passed through the reticle R on a reticle stage RST is incident to a projection optical system 3 and condensed to form an image of a circuit pattern on an imaging plane of the projection optical system 3. The projection optical system 3 may be of a reflection-refraction type or of a refraction type, and the projection optical system 3 comprises an optical element made of quartz or fluorite.

A wafer holder 12 for holding a wafer W by means of vacuum adsorption or any other means is disposed on the imaging plane side of the projection optical system 3. The wafer holder 12 is held on a wafer stage 6 that is disposed so as to be movable in a direction substantially perpendicular to the light flux of the projection optical system 3, and moved by a drive system (not shown) in the light flux direction of the projection optical system 3, thereby enabling the surface of the wafer W to agree with the imaging plane of the projection optical system. Further, the wafer stage 6 can be transferred in a two-dimensional direction perpendicular to the light flux of the projection optical system 3, thereby enabling a predetermined exposure region of the wafer W to be transferred to an imaging position of the projection optical system 3. Moreover, the wafer stage 6 is provided on its upper surface with a sensor 7 for measuring the passed light amount of the illumination light passed through the projection optical system 3. The passed light amount measurement sensor 7 is aligned in a projection region of the projection optical system 3 by transferring the wafer stage 6 to measure the passed light amount of the illumination light passed through the projection optical system 3. The passed light amount measured by the passed light amount measurement sensor 7 is transmitted to a transmittance measurement device 8.

On the other hand, a half mirror 14 is disposed in the light path of the illumination optical system 2, and the illumination light is branched by the half mirror 14. A portion of the illumination light branched by the half mirror 14 is then incident to an incident light amount measurement sensor 4 for measuring an incident light amount. The incident light amount measurement sensor 4 then outputs a signal in accordance with the intensity of the incident light to an incident light amount measurement device 5. The incident light amount measurement device 5 gives the incident light amount of the illumination light incident to the projection optical system 3, on the basis of the intensity of the light obtained by the incident light measurement sensor 4, and the given incident light amount is input in a transmittance measurement device 8.

The transmittance measurement device 8 is configured such that a transmittance of the projection optical system 3 is determined from the passed light amount of the illumination light passed through the projection optical system 3, which is obtained by the passed light amount measurement sensor 7, and from the incident light amount of the incident light incident to the projection optical system 3, which is obtained by the incident light amount measurement device 5.

Fig. 2 is a graph showing the relationship of the incident light amount of the illumination light incident to the projection optical system 3 with the transmittance of the projection optical system 3. In Fig. 2, the Y-axis represents the transmittance and the X-axis represents time for irradiation of the laser light. The curved line indicating the transmittance in this figure is given as a value obtained by dividing the output of the passed light amount measurement sensor 7 by the output of the incident light amount measurement sensor 4, and plots a variation in the transmittance that varies in a state in which the laser beams are turned on and off under the substantially identical conditions as at the time of exposure. The transmittance varies slightly within a very short period of time whenever the laser is turned on and off, however, when the variation is shown in a macro way as in this figure, it can be found that the transmittance tends to decrease during the period of time ranging from the start of irradiation of the laser light to 500 seconds and then it tends to increase thereafter up to 3,000 seconds. The decrease of the transmittance after the start of irradiation of the laser light is considered to be based on properties of a lens material for each of the lens elements of the projection optical system 3, and the increase of the transmittance thereafter is considered to be caused by the cleaning action by the excimer laser light, which removes attached materials such as water and other pollutants attached to each optical element in the projection optical system 3.

The transmittance measurement device 8 outputs a transmittance variation characteristic of the projection optical system 3 with respect to a time elapse to a transmittance variation memory device 10 for saving the transmittance variation characteristic through an exposure light amount control unit 9 on the basis of the curved line indicating the variation in transmittance, as shown in Fig. 2, and the transmittance variation characteristic of the projection optical system 3 is saved by means of the transmittance variation memory device 10. It is now to be noted herein that, although the time for irradiation of the laser light is given ob the X-axis in this embodiment, a number of irradiated pulses of the laser light or a total amount of irradiated energy can be used instead, and a curved line indicating a variation of transmittance obtained by using such a parameter can also be used for the identical purposes.

The exposure light amount control unit 9 can compute a light amount of the light arrived at the wafer W plane from the incident light amount of the illumination light incident to the projection optical system 3 during the exposure obtained by the incident light amount measurement device 5 and from the transmittance of the projection optical system 3. The resulting light amount is sequentially accumulated after the start of exposure, and the radiation and the suspension of the radiation of the ArF excimer laser light from the illumination light source 1 are controlled so as to terminate the exposure as the accumulated light amount reaches a predetermined value. The exposure light amount control unit 9 is connected to a main control unit 11 for controlling the entire system of the projection exposure apparatus. The main control unit 11 manages the state of each part of the device and to make a decision, for instance, as to whether the alignment of the wafer stage has been finished, and it provides the exposure light amount control unit 9 with a signal for starting the exposure when it is decided that the wafer stage has already been aligned and the device is ready for exposure.

Fig. 3 shows the procedures for controlling the exposure light amount, and a description will be made of the procedures for controlling the exposure light amount on the basis of the exposure light amount control method according to the embodiment of the present invention, with reference to Fig. 3.

First, a variation in transmittance of the projection optical system 3 is measured prior to the exposure to the wafer W in accordance with the procedures from step S1 to step S6. The main control unit 11 transfers the wafer stage 6 to locate the passed light amount measurement sensor 7 in a projection region of the projection optical system 3. Then, the exposure light amount control unit 9 starts emission of laser light from an excimer laser of the illumination light source 1 on the basis of an instruction from the main control unit 11 (step S2). As the illumination light has been emitted from the illumination light source 1, the light amount is measured on both of the incident side and the leaving side of the projection optical system 3 by the incident light amount measurement sensor 4 and the passed light amount measurement sensor 7, respectively, in a state that the reticle R is not loaded thereon (step S3).

The incident light amount and the passed light amount so measured are then sent to the transmittance measurement device 8, and the transmittance measurement device 8 gives a transmittance of the projection optical system 3 by dividing the passed light amount by the incident light amount (step S4). At step S5, it is then decided to determine whether the measurement has been conducted at a predetermined number of times, and the process is returned to step S3 for effecting an additional measurement for a next transmittance, when it is decided that the measurement is not yet conducted at the predetermined number of times. Once the measurement has been conducted at the predetermined number of times and the transmittance has been given for the predetermined times of measurements, then the value for each transmittance is saved in the transmittance variation memory device 10, together with information on the time measured (i.e., an elapse of time after the start of emission of the laser light) (step S6). The resulting variation of transmittance of the projection optical system 3 indicates a predetermined variation of transmittance in accordance with the irradiated light amount of the illumination light.

The interval of measurement is set so as to become small enough for an error in the exposure light amount, which is acceptable for the variation of transmittance as described above at the measurement interval. Further, the measurement for a variation in the transmittance at the procedures from step S3 to step S6 is not always required to be effected before the start of exposure of the wafer W at every exposure, and the such measurement is sufficient at the time when the operation of the projection exposure apparatus is started or at an appropriate time interval (for example, once per day or at every time of checking an interval between the center of a pattern of the reticle R and the center of an alignment sensor (not shown), i.e. a so-called baseline checking)).

Once the variation in transmittance of the projection optical system 3 has been determined in the manner as described above, then the process is transferred to the operation of the exposure of the wafer W (step S10). Once the exposure of the wafer W has been started on the basis of an instruction from the main control unit 11, the illumination light is emitted from the illumination light source 1 (step S11). A portion of the illumination light is then incident to the incident light amount measurement sensor 4, and the incident light amount of the illumination light incident to the projection optical system 3 is computed by the incident light amount measurement device 5 on the basis of the output of the incident light amount measurement sensor 4 (step S12).

The incident light amount computed is then sent to the exposure light amount control unit 9, and the exposure light amount control unit 9 measures an elapse of time after the start of exposure (step S13). The exposure light amount control unit 9 reads data of the transmittance at the corresponding time elapse from the measured data on the variation in transmittance in a time series of the projection optical system 3 saved in the transmittance variation memory device 10 measured by the procedures starting with step S1 and ending with step S6 (step S14), and the light amount on the current wafer W surface is computed on the basis of a result of the current measurement of the incident light amount and the value of the transmittance read (step S15). The frequency of this computation is set to be substantially equal to the intervals of measurement as described above. The computation of the light amount on the wafer W surface in the above manner is repeated, and a value close to the light amount on the wafer W surface is obtained always at the current point of time.

Further, the exposure light amount control unit 9 accumulates the light amount on the wafer W surface determined in the manner as described above sequentially from the start of exposure (step S16), and determines as to whether the accumulated exposure light amount reaches a predetermined accumulated exposure light amount by comparing the accumulated exposure light amount with the accumulated exposure light amount determined in advance from a sensitivity of a resist or the like on the wafer W (step S17). If the accumulated exposure light amount would not reach the predetermined accumulated exposure light amount, the process returns to step S12 from which the procedures for measuring the incident light amount are to be repeated.

Once the accumulated exposure light amount has reached the predetermined accumulated exposure light amount, the exposure light amount control unit 9 suspends the emission of the laser light from the excimer laser of the illumination light source 1 (step S18), and the exposure for one shot is finished (step S19). Then, if a shot region would be left non-exposed, the main control unit 11 transfers the wafer stage 6 in a predetermined distance to transfer the wafer W to a next shot position at which the processes from step S11 to step S19 are repeated for exposing the shot region of the wafer W, and the process has been finished when the exposure of all the shot regions on the wafer W has been completed (step S20).

Next, a description will be made of the exposure light amount control method in the second embodiment of the present invention, with reference to Figs. 4 and 5. In this embodiment, a description will be made of the case in which the exposure light amount control method according to the present invention is applied to a scanning projection exposure apparatus of a so-called step-and-repeat type, in which a scanning exposure for effecting the exposure by transferring the reticle stage RST and the wafer stage 6 in synchronism with each other is combined with a stepping operation. The scanning projection exposure apparatus of the step-and-scan type for use in this embodiment differs from the projection exposure apparatus of the step-and-scan type according to the first embodiment of the present invention in that the accumulated exposure light amount can be controlled by controlling the scanning velocity, making the number of pulses variable, and so on.

The scanning projection exposure apparatus of the step-and-scan type is disclosed in Japanese Patent Application Laid-Open No. 6-232,030, and a brief configuration of the scanning projection exposure apparatus of the step-and-scan type will be described hereinafter with reference to Fig. 4. As shown in Fig. 4, a laser light (having a wavelength of 250 nm or less) emitting from the light source 1 of a pulse oscillation type, such as, e.g., KrF excimer laser or ArF excimer laser, has its sectional beam form shaped by a beam shaping optical system 32 so as to become efficiently incident to a fly-eye lens 34 connected thereto, the beam shaping optical system 32 being composed of a cylinder lens, a beam expander, and so on. The laser light leaving from the beam shaping optical system 32 is incident to a light extinction means 33 which in turn comprises a coarse adjustment section and a fine adjustment section of transmittance. The laser light leaving the light extinction means 33 is incident to a fly-eye lens 34.

The fly-eye lens 34 is to illuminate a vision field diaphragm 37 disposed behind and the reticle R at a uniform illuminance. The laser light leaving from the fly-eye lens 34 is incident to a beam splitter 35 having a small reflectance and a large transmittance, and the laser light passed through the beam splitter 35 illuminates a vision field diaphragm 37 at a uniform illuminance through a first relay lens 36. The shape of an opening portion of the vision field diaphragm 37 in this embodiment may be, for example, a rectangle, or the like.

The laser light passed through the vision field diaphragm 37 travels through a second relay lens 38, a turning mirror 39 and a main condenser lens 40 and then illuminates the reticle R on a reticle stage 41 at a uniform illuminance. The vision field diaphragm 37 and the pattern-forming surface of the reticle R are conjugated with each other, and the laser light is irradiated on a slit-shaped rectangular illumination region 56 on the reticle R conjugated with the opening portion of the vision field diaphragm 37. The shape of the opening portion of the vision field diaphragm 37 may be changed through a drive section 42 to adjust the shape of the slit-shaped illumination region 56.

The pattern image in the slit-shaped illumination region 56 on the reticle R is projected and exposed to the wafer W through the projection optical system 3. The reticle stage 41 is scanned in the X-direction by a reticle stage drive section 43, when the Z-axis is set so as to become parallel to the light axis of the projection optical system 3, and the scanning direction of the reticle R with respect to the slit-shaped illumination region 56 and on a flat plane perpendicular to the light axis thereof is set as an X-direction. The reticle stage drive section 43 is controlled by an operation section 45 operable by an instruction of the main control system 11 for controlling the operation of the entire system of the device.

On the other hand, the wafer W is loaded on an XY-stage 48 that can be scanned at least in the X-direction (in the left-and-right direction in Fig. 4) through a wafer holder 47. Although, illustration of a Z-stage for alignment of the wafer W in the Z-direction, and so on is omitted in Fig. 4, they are disposed between the XY-stage 48 and the wafer stage 47. The wafer W is scanned in the -X-direction by means of the XY-stage 48 in synchronism with scanning the reticle R in the X-direction, and the like. The operation of the XY-stage 48 is driven by a wafer stage drive section 49. The XY-stage 48 is loaded thereon with the passed light amount measurement sensor 7.

The laser light reflected at the beam splitter 35 is received by the incident light amount measurement sensor 4 and supplied to the operation section 45 which in turn is provided with the incident light amount measurement device 5, the transmittance measurement device 8, the exposure light amount control unit 9, and the transmittance variation memory device 10, as shown in Fig. 5.

The main control unit 11 can adjust an output power of the illumination light source 1, as needed, and a transmittance in the light extinction means 33.

The operator can input information of a pattern of the reticle R to the main control unit 11 through the input-output means 54, information of a variation in transmittance of the projection optical system 3, and so on, and the main control unit 11 is provided with a memory 55 for storing a variety of information.

Then, a description will be made of the exposure light amount control method in this embodiment of the present invention, in which the scanning projection exposure apparatus having the configuration as described above is used. First, when one point on the wafer W loaded on the wafer holder 47 is considered, the light amount determined by the sensitivity of the resist and so on for a period of time during which the one point passes through a projection field of the projection optical system controls the velocity of the stage during the exposure so as to irradiate the point with the light. This can be represented briefly by the formulas as will be described hereinafter.

The exposure time t (in second) can be represented by the following formula:

$$t = S/I = D/v \quad (1)$$

where the illuminance on an exposure plane (the illuminance on the image plane) of the wafer W is indicated by I (mW/cm$^2$); the desired exposure light amount (a sensitivity of a photosensitive material on the wafer W) is indicated by S (mJ/cm$^2$); the width in the scanning direction on the exposure plane of the wafer W in the slit-shaped illumination region is indicated by D (mm); and the scanning velocity of the reticle R and the wafer W, when translated into the exposure plane of the wafer W, is indicated by v (mm/second).

And the pulse energy Pw on the exposure plane of the wafer W (represented in mJ/cm$^2$.pulse) has a relationship with a transmittance T and a pulse output PL (represented in mJ/cm$^2$.pulse) as follows:

$$Pw = T \times PL \quad (2).$$

In this case, the illuminance I (mW/cm$^2$) on the exposure plane of the wafer W can be represented by the relationship as follows:

$$I = T \times PL \times f \quad (3)$$

where reference symbol f represents a frequency of oscillation of the illumination light source 1 (in Hz).

Then, the pulse number N required for exposure can be represented as follows:

$$N = f \times t \quad (4).$$

Therefore, the equation can be obtained from the formulas (1), (3) and (4) as follows:

$$N = S/(T \times PL) = D \times f/v \quad (5).$$

From this formula (5), it is found necessary to make some controls in order to make the value obtained each by S/T x PL and D x f/v an integer.

It is to be noted herein that the projection field length D in the scanning direction is an inherent constant for each projection exposure apparatus and that the required exposure light amount S is a value to be determined by the resist used, and the like. Moreover, the passed light amount I of the projection optical system per unit time can be obtained by measuring a variation in transmittance of the projection optical system from the start of irradiation in advance by the like procedures as have been previously described in connection with the projection exposure apparatus of the step-and-repeat type and by computing a current light amount on a wafer surface on the basis of the previous result of measurement, the current result of measurement; and the time elapse measured from the start of the exposure. The frequency of this computation is set so as to become as short as possible for the exposure time for one shot (a duration from the start of scanning to the end of finishing scanning).

In other words, in scanning one shot region, a computation of the light amount on the wafer surface is repeated at several times to give a value close to the light amount on the wafer surface always at the current point of time. The stage is controlled by computing an appropriate scanning velocity (v) at that point of time from the above formulas. In this configuration as described above, the scanning projection exposure apparatus can effect an optimal exposure even if transmittance of the projection optical system would vary during exposure, like the projection exposure apparatus of the step-and-repeat type as described above. In the above instances, the scanning velocity (v) is optimized in accordance with the variation in transmittance; however, the optimal exposure for the variation in transmittance can be effected in accordance with the variation in transmittance, for instance, even if the frequency (f) of an oscillating pulse of the laser light source varies with a variation in transmittance or the width (a slit width) (D) of the exposure region in the scanning direction (the X-direction) varies with a variation in transmittance by making the vision field diaphragm 37 variable. Further, the optimal exposure can also be effected in accordance with the variation in transmittance by varying the pulse output (intensity) PL of the laser in accordance with the variation of transmittance T so as to make the pulse energy on the exposure plane of the wafer W constant. The pulse output PL can be adjusted by controlling the voltage to be applied to the illumination light source 1 or by adjusting the light extinction means 33.

In the above embodiments, the variation in transmittance is measured and saved in advance by utilizing the phenomenon that the variation in the transmittance of the projection optical system from the start of irradiation with laser indicates a predetermined variation in accordance with the amount of irradiation of the illumination light. Therefore, the exposure light amount on the wafer plane can be given sequentially in an accurate way from the start of exposure simply by measuring the light amount of the light incident to the projection optical system at the actual exposure by using the light having a wavelength of 250 nm or less. Further, the accumulated exposure light amount can be determined accurately by accumulating the light amounts sequentially acquired in the above manner, so that a decrease in a precision of controlling the exposure light amount can be prevented.

As shown in Fig. 2, the transmittance can be increased once it has been decreased with an elapse of time. Therefore, a so-called dummy irradiation for irradiating an excimer laser is effected up to the irradiation time (for example, 500 seconds in Fig. 2) that starts increasing the transmittance on the basis of the variation in the transmittance saved, prior to the actual exposure of the wafer W, and thereafter the light amount of the light on the wafer W is computed on the basis of the irradiation time, the characteristic of the periodical variation in transmittance saved, and the light amount of the light measured by the incident light amount measurement sensor 4, and the exposure light amount may be controlled by using the light amount computed in the above manner.

Moreover, even if the transmittance of the projection optical system would vary by the incident light amount, the exposure light amount can be controlled with high precision without measuring the light amount of the light on the wafer plane during exposure, so that it is not needed to install a new sensor for measuring the light amount of the light on the wafer plane during exposure. Therefore, this configuration has the advantage in that a space above the wafer stage can be utilized more effectively, for instance, by installing sensors and so on.

Then, a description will be made of the manufacture method for manufacturing semiconductor elements, including the exposure step using the exposure light amount control method in the first and second embodiments of the present invention, with reference to the flow chart as shown in Fig. 6. First, at step S100, a design of a logic circuit and a pattern is drawn. Then, at step S102, a reticle R is formed by drawing the circuit pattern for each layer on the basis of the design drawing. Concurrently with the step of forming the reticle R, a wafer W is prepared from a material such as silicone or the like having a high purity, at step S104, and a photoresist (a photosensitive resin) is coated on the entire surface area of the wafer W at step S106.

Then, in an exposure process (a photolithographic process) at step S108, the reticle R prepared at the above step and the wafer W coated with the photoresist at the above step are transferred to the exposure apparatus as described in each of the embodiments above, and then they are loaded, followed by sequential exposure of an image of the pattern drawn on the reticle R to the exposure region on the wafer W in the manner as described above and by transcription of the image of the pattern thereof onto the exposure region of the wafer W. Upon transcribing the image of the pattern of the reticle R onto the exposure region of the wafer W, the exposure light amount control method in the above embodiments is used.

Then, at step S110, the exposed wafer W is placed in a thermostat vessel and then immersed in a developing liquid. This permits a resist image to be formed in such a manner that the resist portion sensitized by the exposure light is caused to dissolve while the resist portion non-sensitized is left unsolved, when the photoresist is of a positive type. The photoresist image can be formed in a reverse manner when the photoresist is of a negative type.

The process further advances to step S112, an nitride film (for example, $Si_3N_4$) in the region from which the photoresist on the wafer W has been removed by patterning is subjected to etching with an etching liquid.

Then, at step S114, a doping operation is carried out for injecting a material such as, e.g.. phosphorus or arsenic, into the region of the wafer W in which the resist has been removed for forming elements such as, e.g., transistors, diodes, etc. After doping, the resist on the wafer W is removed, for example, by a plasma asher (an ashing device).

Thereafter, the processes from steps S106 to S114 are repeated to superimpose another upper circuit pattern over the lower circuit pattern in plural layers on the surface of the wafer W in substantially the same manner as described above.

At step S116, a chip is assembled by using the wafer W with the desired circuit patterns formed in the manner as described above. More specifically, an aluminum electrode is deposited on the wafer W and each of the elements is connected to one another as a circuit, followed by forming a chip. The chip so formed is then assembled by means of steps for dicing, bonding, molding, and so on.

Then, at step S118, the semiconductor elements prepared at step S116 are then subjected to, for example, experiments for electrical features, inspection of their structures and experiments for reliability. The semiconductor element can be prepared as a final product by means of the manufacturing processes as described above (step S120).

It is to be understood that the present invention is not restricted to the embodiments and modes as described above and may encompass various modifications and variations.

For instance, in the first and second embodiments, the exposure light amount is arranged so as to be controlled on the basis of the transmittance characteristics of the projection optical system 3, which have been measured and saved. When the illumination light is kept being irradiated onto the projection optical system 3 as shown in Fig. 2, the variation in transmittance may become small to a certain extent within short. Therefore, the exposure light amount can be controlled on the basis of the characteristics of the periodical variation in transmittance measured and saved in the manner as described above, until the variation in the transmittance becomes small to that extent. The exposure light amount on the wafer W is then computed on the basis of the transmittance (a transmittance with its variation reduced to a small extent) at that time and the light amount of the light measured by the incident light amount measurement sensor 4, after the mount of a variation in transmittance by irradiation of the optical elements with the laser light become smaller. Then, the exposure light amount may be controlled by using the computed light amount. When the excimer laser is continued being irradiated until the variation in transmittance becomes small enough in the manner as described above, the exposure light amount on the wafer W can be made constant.

In addition, in the case where the throughput is acceptable, the transmittance of the projection optical system 3 may be confirmed at a predetermined timing and the exposure light amount may be controlled on the basis of the confirmed transmittance. For instance, the passed light amount may be measured by the passed light amount measurement sensor 7 by transferring the wafer stage 6 at the time of exchanging wafers, at the time of conducting a so-called baseline checking or at every shot, and the transmittance is computed on the basis of the passed light amount measured by the passed light amount measurement sensor 7 and the light amount of the light measured by the incident light amount measurement sensor 4, thereby controlling the exposure light amount on the basis of the transmittance and the light amount of the light measured by the incident light amount measurement sensor 4.

Now, a specific description will be made of the third embodiment of the present invention with reference to Figs. 7 to 9. In this embodiment, the present invention is applied to the projection exposure apparatus of a step-and-scan type.

Fig. 7 shows a brief configuration of the projection exposure apparatus in this embodiment of the present invention. In Fig. 7, the illumination light comprising pulse laser light is emitted from an excimer laser light source 112 with its emission state controlled by an exposure light amount control unit 111. In this embodiment, as the excimer laser light source 112, there may be used an ArF excimer laser light source narrow-banded so as to avoid art absorption of oxygen, having a wavelength between 192 nm and 194 nm. In this embodiment and the examples as shown in Figs. 1 to 6, however, an exposure light source may include, for example, a KrF excimer laser light source (a wavelength of 248 nm), $F_2$ excimer laser light source (a wavelength of 157 nm), a metallic vapor laser light source, a higher harmonics generating device for generating higher harmonics of YAG laser, or a bright line lamp such as a mercury lamp, etc., or the like. Moreover, the laser light source is not restricted to a narrow-banded laser light source.

The illumination light from the excimer laser light source 112 passes through a beam matching unit (BMU) 113, including a beam shaping optical system for shaping the section of the illumination light leaving from the excimer laser into a predetermined shape in section, a beam expander, and so on, and is incident to a first illumination optical unit 115 through a variable light extinction device 114. The variable light extinction device 114 can adjust a light extinction ratio of a pulse laser light in a stepwise or non-stepwise way in accordance with an instruction from the exposure light amount control unit 111. The first illumination optical unit 115 contains a first fly-eye lens and forms a planer light source as a secondary light source in the position in the vicinity of the leaving plane of the first fly-eye lens.

The illumination light from the first illumination optical unit 115 is incident to a second illumination optical unit 117 through a vibrating mirror 116 for preventing a formation of a speckle pattern on the reticle R or the wafer W as a plane to be irradiated. The detailed configuration and operation of the vibrating mirror 116 is disclosed, for example, in Japanese Patent Application Laid-Open No. 1-257,327 (U. S. Patent No. 4,970,546), so that the explanation of the mirror 116 is omitted herein.

The second illumination optical unit 117 contains a second fly-eye lens and forms a planar light source acting as a tertiary light source in the position in the vicinity of the leaving plane of the second fly-eye lens. An opening diaphragm unit 118 is disposed in the vicinity of the planar light source by the second illumination optical unit. The opening diaphragm unit 118 is formed with a circular opening diaphragm having a first diameter, a circular opening diaphragm for a small σ value having a diameter smaller than the first diameter, an opening diaphragm for a varied illumination (a special oblique illumination) composed of plural openings eccentric from the light axis or a zonal opening diaphragm in the form of a turret. An opening diaphragm control unit 119 controls the opening diaphragm unit 118 so as to locate one of the plural openings disposed in the form of a turret selectively in a light path.

On the leaving side of the opening diaphragm unit 118 is obliquely disposed a beam splitter 120 having a high transmittance and a low reflectance, and an integrator sensor 121 composed of photoelectrical elements such as, for example, photodiodes, etc. is disposed on the reflecting direction of the beam splitter 120. The output from the integrator sensor 121 is transmitted to the main control unit 100 in a manner as will be described hereinafter. The configuration of the integrator sensor 121 is disclosed in Japanese Patent Application Laid-Open No. 8-203,803, so that a description thereof will be omitted.

The illumination light passed through the beam splitter 120 is condensed with a third illumination optical unit 122 and illuminates an illumination vision field diaphragm unit (a reticle blind system) 123 in a superimposed manner. The illumination vision field diaphragm unit 123 is disposed in a position conjugated with the incident plane of the first fly-eye lens in the first illumination optical unit 115 and the incident plane of the second fly-eye lens in the second illumination optical unit 117. In this configuration, the illumination region in the illumination vision field diaphragm unit 123 is of a shape resembling generally the sectional shape of each of the lens elements of the second fly-eye lens in the second illumination optical unit. The illumination vision field diaphragm unit 123 is divided into a movable blind and a fixed blind. The fixed blind is a fixed vision field diaphragm having a rectangular opening, and the movable blind comprises a pair of movable blades each being movable in the scanning direction of the reticle R and in the direction intersecting at a right angle with the scanning direction thereof and being openable. The shape of the illumination region on the reticle is determined by the fixed blind, and a covering for the opening of the fixed blind is gradually opened or closed by the movable blind at the time of the start and the termination of the scanning exposure. This prevents the illumination light from being irradiated in a region on the wafer W other than a shot region as an original object for exposure.

The operation of the movable blind in the illumination vision field diaphragm unit 123 is controlled by a movable blind drive unit 124. The main control unit 100 drives the movable blind in the scanning direction in synchronism therewith through the movable blind drive unit 124, upon scanning the reticle R and the wafer W in synchronism with each other in a manner as will be described hereinafter. The illumination light passed through the illumination vision field diaphragm unit 123 illuminates a rectangular illumination region of the pattern plane (the bottom plane) of the reticle R at a uniform illumination distribution through a fourth illumination optical unit 125, an eccentric mirror 126 and a fifth illumination optical unit 127. The fourth and fifth illumination optical units 125 and 127 have each the function to make the position of the fixed blind in the illumination vision field diaphragm unit 123 and the pattern plane of the reticle R conjugated with each other, and the shape of the illumination region on the reticle R is defined by the opening of the fixed blind.

The following is a description by referring to the axis on the plane parallel to the pattern plane of the reticle R and perpendicular to the paper plane of Fig. 7 as the X-axis, to the axis parallel to the paper plane of Fig. 7 as the Y-axis, and to the axis perpendicular to the pattern plane of the reticle R as the Z-axis. In this instance, the illumination region on the reticle R is a rectangular region elongated in the X-direction, and the reticle R is in turn scanned in the +Y-direction or the -Y-direction with respect to the illumination region, upon the scanning exposure. In other words, the scanning direction is set to be the Y-direction.

The pattern in the illumination region on the reticle R is reduced at a projection magnification $\beta$ ($|\beta|$ being, for example, 1/4, 1/5, etc.) through the projection optical system PL that is telecentric at both ends (or at one end on the wafer side), and the pattern is projected and imaged in the exposure region on the surface of the wafer W with the photoresist coated thereon.

The reticle R is held on a reticle stage 131, and the reticle stage 131 is mounted on a guide extending in the Y-direction on a reticle support table 132 through an air bearing. The reticle stage 131 can scan on a reticle support table 132 in the Y-direction at a constant velocity by means of a linear motor, and is provided with an adjustment mechanism that can adjust the position of the reticle R in the X-direction, the Y-direction, and a rotation ($\theta$) direction. By a moving mirror 133M fixed to the end portion of the reticle stage 131 and a laser interferometer (no axis but Y-axis being shown) fixed to a column 133 (not shown), the positions of the reticle stage 131 (the reticle R) in the X-direction and the Y-direction are measured always at a resolution of approximately 0.001 μm, and an angle of rotation of the reticle stage 131 is also measured. The measured values are then supplied to a reticle stage control unit 134 that in turn controls the operation of the linear motor and the like on the reticle support table 132 in accordance with the measured values supplied.

On the other hand, the wafer W is held on a wafer holder 135, and the wafer holder 135 is mounted on a wafer stage 136 that in turn is mounted on a guide on a base, not shown, through an air bearing. The wafer stage 136 scans the wafer W on the base in the Y-direction at a constant velocity by means of a linear motor and is transferred in a stepwise manner as well as is transferred stepwise in the X-direction. Moreover, a Z-stage mechanism for transferring the wafer holder 135 in the Z-direction in a predetermined scope and a tilt mechanism (a leveling mechanism) for adjusting an inclination angle of the wafer holder 135 are incorporated in the wafer stage 136.

The positions of the wafer stage 136 (wafer W) in its X-direction and Y-direction are measured always at a resolution of about 0.001 μm by a moving mirror 137M fixed to the side surface portion of the wafer stage 136 and a laser interferometer (no axes but Y-axis being shown) fixed to a column, although not shown. An angle of the rotation of a sample table 137 is also measured. The measured values are supplied to a wafer stage control unit 138 that in turn control the operations of a linear motor for driving the wafer stage 136, and so on, in accordance with the measured values supplied to the wafer stage 136.

A light path extending from the excimer laser light source 112 to the fifth illumination optical unit 127 is closed in an airtight way with an illumination system cover 141. In this embodiment, the illumination system cover 141 is filled with inert gases (e.g., nitrogen, helium, argon, etc.), and the inert gases with their oxygen content controlled to an extremely low level and to a low moisture level are supplied by means of a first gas supply unit 142 at a predetermined flow rate through a chemical filter, an electrostatic filter, or the like. Further, a sensor 143 is disposed within a space closed with the illumination system cover 141, which sensor being to detect the state (temperature, moisture, etc.) of the inert gases to be filled in the light path extending from the excimer laser light source 112 to the fifth illumination optical unit 127. The illumination system cover 141 has a door portion disposed so as to be opened or closed for readiness to perform maintenance of an inner optical system, and a sensor 144 for detecting the opening and closing of the door portion is disposed. The information on a flow rate of the inert gases to be supplied from the first gas supply unit and other information as well as the outputs from the sensors 143 and 144 are transmitted to the main control unit 100.

The projection optical system PL is provided with a variable opening diaphragm 151 which have its opening size arranged so as to be variable, and a variable opening diaphragm control unit 152 for controlling the variable opening diaphragm is disposed to control the operation of the opening of the variable opening diaphragm 151 on the basis of an instruction from the main control unit 100. In the case of adjusting the opening size of the variable opening diaphragm 151 manually, the variable opening diaphragm control unit 152 transmits information relating to the opening size of the variable opening diaphragm to the main control unit 100. Moreover, a pupil filter 153 is disposed in the vicinity of the variable opening diaphragm 151 which pupil filter being to vary an eccentric state between a light flux passing through a portion above the pupil region of the projection optical system PL and a light flux passing through another portion thereof. The pupil filter 153 is disposed so as to transfer the position outside and inside the light path of the projection optical system PL selectively. This transfer operation can be controlled by means of a pupil filter control unit 154 on the basis of an instruction from the main control unit 100. The pupil filter control unit 154 transmits information relating to the position (inside the light path or outside the light path of the projection optical system PL) of the pupil filter 153 to the main control unit 100. The configuration of the pupil filter 153 itself is disclosed, for example, in Japanese Patent Application Laid-Open No. 6-120,110, U. S. Patent No. 5,552,856, or U. S. Patent No. 5,610,684.

The projection optical system PL is composed of plural lens elements and provided with a second gas supply unit 155 for supplying dry inert gases into a space between the plural lens elements, the dry inert gases being processed in advance so as to reduce the oxygen content to an extremely low level and the moisture content to a low level. The second gas supply unit 155 is also arranged to control the temperature, moisture, flow rate and pressure of the dry inert gases to be flown into the inside of the projection optical system PL, and the temperature, moisture, flow rate and pressure of the dry inert gases inside the projection optical system PL are detected by means of a sensor 156 disposed in the projection optical system PL. The output from this sensor 156 is transmitted to the main control unit 100. The second gas supply unit 155 is also provided with a chemical filter or an electrostatic filter for removing impurities contained in the dry inert gases to be flown into the inside of the projection optical system PL.

In order to control the temperature, moisture and so on of an atmosphere around the projection optical system PL in an accurate way, a chamber 157 is disposed around the projection optical system PL. The chamber 157 is provided with a door portion, although not shown, and a sensor 158 for detecting the opening and closing of the door portion is disposed inside the chamber 157. The output from the sensor 158 is transmitted to the main control unit 100.

In this embodiment, in order to determine an influence of the reflected light reflected from the wafer W and returning to the projection optical system PL during the actual exposure, a beam splitter 128 having, for example, a reflectance of several percentage is interposed between the third illumination optical unit and the fourth illumination optical unit in the illumination optical system, and the light to be returned through the projection optical system and the reticle R after reflection at the wafer W during the actual exposure is led to a reflectance sensor 129 composed of photoelectrical detection elements such as photodiodes and so on. The reflectance sensor 129 is disposed in the position conjugated with the reticle R (conjugated with the illumination vision field diaphragm unit 123). The configuration of the reflectance sensor 129 of this type is disclosed, for example, in Japanese Patent Application Laid-Open No. 8-250,398. The output from the reflectance sensor 129 is transmitted to the main control unit 100.

In this embodiment, a bar cord reader 159 is disposed in a reticle conveyer path extending from a reticle stocker (not shown) to the reticle stage 131, in order to distinguish the kinds of the reticles R to be loaded on the reticle stage 131. The reticle R is recorded with information relating to ID numbers of the reticles by means of bar cords, and the bar cord reader 159 transmits information relating to the ID numbers of the reticles to the main control unit 100.

Then, the main control unit 100 will be described.

Among information to be transmitted to the main control unit from the sensors disposed at the portions of the main body of the projection exposure apparatus, the information for use in determining whether the transmittance (an attenuation factor) of the optical system of the projection exposure apparatus will be as follows:

(1) information from the opening diaphragm control unit 118 relating to kinds of opening diaphragms;

(2) information from the integrator sensor 121 relating to the exposure light amount;

(3) information from the first gas supply unit 142 relating to the flow rate of inert gases to be flown into the illumination system cover 141;

(4) information from the sensor 143 relating to the state (temperature, moisture, etc.) of the inert gases in the illumination system cover 141;

(5) information from the sensor 144 relating to the opening and closing of the illumination system cover 141;

(6) information from the variable opening diaphragm control unit 152 relating to the opening size of the variable opening diaphragm 151;

(7) information from the pupil filter control unit 154 relating to the insertion and detachment of the pupil filter 153;

(8) information from the second gas supply unit 155 relating to the flow rate of the inert gases to be flown into the projection optical system PL;

(9) information from the sensor 156 relating to the state (temperature, moisture, etc.) of the inert gases in the projection optical system PL;

(10) information from the reflectance sensor 129 relating to the light amount of the reflected light to be returned to the projection optical system PL; and

(11) information relating to the kind of the reticle R from the bar cord reader 159.

To the main control unit 100 is connected a memory 105 which saves information relating to a variation in transmittance obtained by experiments in a form corresponding to each of the information (1) to (11), inclusive, as described above. A specific example of each of the such information will be described hereinafter.

First, as the information (1) above, information is saved which relates to a variation in transmittance when the plural openings disposed in the opening diaphragm unit 118 are shifted to one another.

As the information (2) above, a periodical variation in the relationship of the period of time during which no light is irradiated with the transmittance, in which the period of time during which the integrator sensor 121 have output is set as a irradiation with light time, because the presence or absence of the output from the integrator sensor 121 is associated with the irradiation of light to the optical system.

As each of the information (3) and (8) above, a periodical variation in the relationship of the flown amount of the inert gases with the transmittance is saved for each of the gas supply units.

As each of the information (4) and (9) above, a periodical variation in the relationship of the state (temperature, moisture, etc.) of the inert gases with the transmittance is saved for each.

As the information (5) above, a periodical variation in the relationship of the opening and closing time of the illumination system cover 141 with the transmittance is saved.

As the information (6) above, a relationship of the opening size of the variable opening diaphragm 151 with the transmittance is saved.

As the information (7) above, information relating to a relationship of the insertion and detachment of the pupil filter 153 with the transmittance is saved.

As the information (10) above, information relating to a relationship of the output value from the reflectance sensor 129 with the transmittance is saved.

As the information (11) above, information relating to a relationship of the ID number of the reticle R with the transmittance is saved.

In this embodiment, the information relating to each of items (1) to (11), inclusive, is saved in combination with each of all the remaining items (for instance, in combination of the information (1) above relating to each of the kinds of the opening diaphragms with each of the remaining information (2) to (11), inclusive). It can be noted herein, however, that in the case where no problems may be caused from a practical point of view, it is not necessary to save the information in all combination and the items other than the items that are not governing transmittance may be omitted in order to reduce an amount of memory.

Then, the main control unit 100 determines the transmittance of the projection exposure apparatus at that time on the basis of the information relating to each of the items (1) to (11) above of the projection exposure apparatus detected by each of the sensors and the information saved in the memory 105, and makes a decision whether there is any problem in carrying out the actual exposure. In the case where it is decided herein that there is the problem with the actual exposure, the light is irradiated onto the illumination optical system and the projection optical system. The cases where it is decided herein that the actual exposure causes the problem are the instances where there is a difference of the transmittance from a reference transmittance by a predetermined amount or there is a variation in transmittance between before and after the shift of the openings by a predetermined amount.

At this instance, the time and the intensity (corresponding to the exposure light amount) for the irradiation with light required for recovering the transmittance are associated with the information relating to the transmittance saved, and they are saved in the memory 105.

Then, a description will be made of the operation of the main control unit 100 upon the irradiation of light.

First, the main control unit 100 gives an instruction to the wafer stage control unit 138 to transfer the wafer stage 136 so as for the wafer W to be evacuated from the exposure region of the projection optical system PL in a distance sufficiently apart therefrom. At this time, the wafer stage 136 may be controlled in such a manner that the wafer W is placed in a resting position at the wafer stage 136 before it is loaded with the wafer W. A region 136A for absorbing light may be disposed on t the wafer stage 136, for instance, as shown in Fig. 8, in order to prevent the light leaving from the projection optical system PL from being diffused on the wafer stage 136 or the like upon the irradiation of the light and from exerting influences upon the wafer W. Further, in place of the light absorbing region 136A, a reflecting plane may also be disposed so as for the light to return to the projection optical system PL.

Turning now to Fig. 7, the main control unit 100 gives an instruction to the exposure light amount control unit 111 to minimize the light extinction rate in the light extinction device 114. This can shorten the time for which the light is being irradiated. This configuration is not restricted to this so long as the irradiation with light is required to the optical element constituting the light extinction device 114.

Concerning the opening size of the opening diaphragm, the opening for use in the actual exposure after the irradiation with light may be located in the light path of the projection optical system. In this instance, the main control unit 100 may provide the opening diaphragm control unit 119 with an instruction so as to allow the opening having the largest size (the largest area) among the openings set in the opening diaphragm unit 118 to be located in the light path or so as to use a different opening having a σ value larger than 1 at the time of the irradiation with light prior to the actual exposure, the different opening being disposed at the opening diaphragm unit 118 separately from the opening for use in exposure.

Thereafter, the main control unit 100 gives the movable blind drive unit 124 an instruction to operate the movable blind in the illumination vision field diaphragm unit 123 so as to become full open. In this instance, the fixed blind in the illumination vision field diaphragm unit 123 may be disposed so as to be evacuated to a position outside the light path of the illumination optical system, and it can be evacuated at the time of irradiation with light prior to the actual exposure. In this embodiment, the fixed blind may be used in combination with the movable blind, however, if only the fixed blind is disposed, it is preferably configured so as to be evacuated at the time of irradiation with light prior to the actual exposure. On the other hand, if only the movable blind is disposed, it is preferred to open it to a full extent at the time of irradiation with light prior to the actual exposure.

Moreover, the main control unit 100 gives the reticle stage control unit 134 an instruction to detach the reticle R from the reticle stage 131 and operates it to locate the opening portion of the reticle stage 131 in a position between the illumination optical system and the projection optical system. This operation can be effected while the reticle R is stayed loaded on the reticle stage 131 depending upon the kind of a pattern formed on the reticle R.

In this case, the variable opening diaphragm may be set to have an opening size for use at the time of the actual exposure after the irradiation with light. In this instance, the main control unit 100 sends an instruction to the variable opening diaphragm control unit 152 so that the opening size of the variable opening diaphragm 151 becomes the largest opening diameter.

Next, the main control unit 100 gives an instruction to the pupil filter control unit 154 to operate the pupil filter 153 so as to be evacuated toward a position outside the light path of the projection optical system PL. It is not required to allow the pupil filter 153 to evacuate, however, when the light is irradiated onto the pupil filter 153 itself, for instance, in the case where the pupil filter is used at the time of the actual exposure after the irradiation with light.

It may be possible to mix an assistant gas with the inert gases for use in promoting the removal of the attached materials by the irradiation with light. At this end, the main control unit 100 gives an instruction to the first and second gas supply units 142 and 153 to mix the assistance gas with the inert gases and flow the mixture into a space in the illumination system cover 141 and inside the projection optical system PL. Such an assistance gas may include, for example, highly oxidative gases such as, e.g., oxygen, ozone, active oxygen or the like.

After the above operations have been finished, then the main control unit 100 gives an instruction to the exposure light amount control unit 111 to oscillate the excimer laser light source 112 and irradiate the illumination optical system and the projection optical system PL with the illumination light. At this instance, the light amount is detected by means of the integrator sensor 121 through the beam splitter 120, and the detected light amount is transmitted to the main control unit 100.

Then, the main control unit 100 compares the irradiation with light time from the start of the irradiation with light and the light amount of the light required for recovering the transmittance, saved in the memory 105, with the time elapse from the start of the irradiation with light and the light amount of the light, detected by the integrator sensor 121, and transmits an instruction to stop oscillating the excimer laser light source 112 to the exposure light amount control unit 111, when the irradiation with light time and the light amount of the light exceed the values saved therein.

In the above operation, if the state of the inert gases in the spaces in the light extinction device 114, the opening diaphragm unit 118, the illumination vision field diaphragm unit 123, the variable opening diaphragm 151, the pupil filter 153 and the illumination system cover 141 and inside the projection optical system PL is different from the state upon the actual exposure to be carried out thereafter, the main control unit 100 gives an instruction each to the exposure light amount control unit 111, the opening diaphragm control unit 119, the movable blind drive unit 124, the variable opening diaphragm control unit 152, the pupil filter control unit 154, the first gas supply unit 142, and the second gas supply unit 153 to recover the state of the inert gases in the light extinction device 114, the opening diaphragm unit 118, the illumination vision field diaphragm unit 123, the variable opening diaphragm 151, the pupil filter 153 and the illumination system cover 141 and inside the projection optical system PL, respectively, to the state at the time of the actual exposure.

In this instance, the main control unit 100 is provided with an input section 110 for implementing an input relating to the condition at the time of the actual exposure, and the condition upon the actual exposure is set in each of the units on the basis of this input or the information from the bar cord reader 158 for reading the ID number of the reticle.

At the time of the irradiation with light in the manner as described above, the reticle R is loaded on the reticle stage 131 when the reticle R has been detached from the reticle stage 131, and it is transferred to the position at which it is subjected to the actual exposure. On the other hand, when the wafer W is located at the evacuating position, the wafer W is loaded on the wafer holder 135 of the wafer stage 136.

Thereafter, the reticle R and the wafer W are aligned relatively with each other by means of an alignment system, although not shown.

As the alignment has been completed, the main control unit 100 sends a command to start the actual exposure to the reticle stage control unit 134, the wafer stage control unit 138 and the exposure light amount control unit 111. Upon receipt of the instruction from the main control unit 100, the reticle stage control unit 134 and the wafer stage control unit 138 start scanning the wafer W at the velocity VW in the Y-direction through the wafer stage 136 in synchronism with the scanning of the reticle R at the velocity VR in the Y-direction through the reticle stage 131. Further, the exposure light amount control unit 111 starts oscillating the excimer laser light source 112. In this embodiment, the relationship of the scanning velocity of the wafer W with the projection magnification β for the wafer W is set so as to satisfy: $VW = \beta \times VR$ , wherein VW is the scanning velocity of the wafer W; β is the projection magnification for the wafer W; and VR is the scanning velocity of the reticle R.

In the embodiment as described above, it is decided to determine whether the irradiation with light is to be effected on the basis of the history of exposure. It is possible to use different techniques, in place of the above technique. The different techniques for use in this embodiment may include, for example, the technique for measuring the transmittance of the optical system itself, the technique for measuring the transmittance of a sample which in turn is disposed in a position in the vicinity of the optical system for measurement of the transmittance; and the technique for measuring a concentration of pollutants in the atmosphere around the optical system.

As the technique for measuring the transmittance (the attenuation factor) of the optical system itself, there may be mentioned, for example, the technique for measuring the transmittance (the attenuation factor) thereof on the basis of a difference between the output from the integrator sensor 121 and the output from an illuminance meter 136D disposed on the wafer stage 136. In this instance, the timing of measuring the transmittance may be selected at least in the case of each of the conditions (1) to (10) above. Further, in order to improve an estimated precision of transmittance on the basis of the history of exposure, the transmittance is measured at a predetermined timing, and the estimated transmittance on the basis of the history of the exposure may be calibrated.

The technique for locating the sample for measurement of the transmittance may involve leading the exposure light from the excimer laser light source 112 to a sample 160, for example, as shown in Fig. 9, locating a beam splitter 161 and a sensor 162 on tics of the exposure light, locating a sensor 163 on the leaving side of the sample, comparing the output from the sensor 162 with the output from the sensor 163, determining a transmittance on the basis of the difference between the outputs. The irradiation with light is then effected on the basis of the resulting transmittance. In the configuration as shown in Fig. 9, in place of the excimer laser light source as a light source for exposure, a light source having an identical wavelength may be disposed separately therefrom.

In the example as shown in Fig. 7, the device is configured such that the irradiation with light can be effected automatically on the basis of the decision as to whether the transmittance has varied or not. The device may also be configured such that, instead, a display section is disposed and an error display may be effected on the display section. In this instance, the operator can input a command through an input section 120 to permit irradiation with light.

The above description is directed to the cases where the present invention is applied to the scanning projection exposure apparatus. It is to be understood as a matter of course that the present invention can be applied to a projection exposure apparatus (a stepper) of a sequential exposure type. Moreover, it is to be noted that the irradiation with light in the above embodiments can provide the effect of preventing a variation in characteristics due to a thermal distribution of the optical system.

A description will be made of the projection exposure apparatus in the fourth embodiment of the present invention with reference to Figs. 10 to 25. The projection exposure apparatus in this embodiment is an example wherein the present invention is applied to a projection exposure apparatus of a step-and-scan type, like the projection exposure apparatus of the embodiment as shown in Fig. 7.

In Fig. 10, reference numeral 211 stands for an exposure light amount control unit, reference numeral 212 stands for an excimer laser light source, and reference numeral 213 stands for a beam matching unit (BMU). These elements have substantially the same configurations as those as shown in Fig. 7.

As the beam matching unit 213, there may be those as disclosed in Japanese Patent Application Laid-Open No. 8-293,491 or as proposed in Japanese Patent Application Laid-Open No. 8-353,022.

The illumination light passed through the beam matching unit 213 passes through a light-shielding pipe 214 and then is incident to a variable light extinction device 216 through a beam shaping optical system 215 for converting the shape of a section of the illumination light flux, composed of a cylindrical lens or a toric lens into a predetermined shape. The variable light extinction device 216 functions as a light attenuator and operates an inner drive motor in accordance with an instruction from the exposure light amount control unit 211, thereby adjusting the light extinction rate of the illumination light in a non-stepwise or stepwise manner.

The illumination light passed through the variable light extinction device 216 has its light flux dimension expanded through a beam expander 217 and then travels toward a first fly-eye lens 218 with a plurality of lens elements integrated. As such an beam expander 217, there may be used those, for example, as proposed in Japanese Patent Application Laid-Open No. 9-19,912.

The illumination light incident to the first fly-eye lens 218 then forms a secondary light source composed of a plurality of images of the light source on the leaving side of the first fly-eye lens 218. The illumination light from the secondary light source passes through a relay optical system composed of a front group 219F and a rear group 219R and is incident to a second fly-eye lens 221. A vibrating mirror 220 for deviating the light path and preventing a speckle pattern from appearing on a surface on which light is irradiated is disposed in the light path between the front group 219F and the rear group 219R of the relay optical system.

The illumination light incident to the second fly-eye lens 220 then forms a tertiary light source (a planar light source) as an image of the plural light source images on the leaving side of the second fly-eye lens 221. The optical system that uses two such fly-eye lenses (optical integrators) is disclosed, for example, in Japanese Patent Application Laid-Open No. 1-235,289 (U. S. Patent No. 5,307,207), Japanese Patent Application Laid-Open No. 8-330,212, and Japanese Patent Application Laid-Open No. 9-6,009. In the vicinity of the position at which the tertiary light source is formed, an opening diaphragm unit 222 is disposed, the opening diaphragm unit 222 being composed of a plurality of opening diaphragms, like the opening diaphragm unit 118 as shown in Fig. 7, and being controlled with an opening diaphragm control unit 223.

The illumination light leaving from the opening diaphragm unit 222 travels toward a condenser lens system 226 through a beam splitter 224 having a reflectance of several percentage. In this configuration, an integrator sensor 225 composed of a photoelectrical conversion element is disposed in the reflection direction of the beam splitter 224.

The condenser lens system 226 may be composed of, for example, from five sheets to ten and several sheets of lens elements, and disposed so as for its front side focus to be located nearly at the position of the opening diaphragm unit 222. The illumination light leaving from the opening diaphragm unit 222 is condensed by means of the condenser lens system 226, and illuminates a fixed blind 228B of a reticle blind unit 228 disposed in the vicinity of a rear side focus nearly uniformly in a superimposed manner.

In this configuration, in order to adjust an irregularity of illuminance, a portion of the plural lens elements constituting the condenser lens system 226 is disposed so as to move in the light axis direction and the remaining is disposed so as to move in an oblique direction. These lens elements are aligned by means of a condenser lens system drive unit 227. This configuration will be described with reference to Fig. 11. As shown in Fig. 11, the condenser lens system 226 comprises a front group 226F and a rear group 226R, which are disposed in this order from the side of the second fly-eye lens 221. The front group 226F is disposed so as to move along the light axis, and the rear group 226R is disposed so as to rotate about one point on the light axis. The condenser lens system drive unit 227 comprises a control sub-unit 227A, a drive sub-unit 227B, and a drive sub-unit 227C. The control sub-unit 227A is to generate a drive signal in accordance with an amount of movement of the front group 226F and the rear group 226R of the condenser lens system 226 on the basis of an instruction from the main control unit. The drive sub-unit 226B is to move the front group 226F in a predetermined amount along the light axis on the basis of an instruction from the control sub-unit 227A. The drive sub-unit 227C is to move the rear group 226R in a predetermined amount along the direction of rotation about one point on the light axis in accordance with an instruction from the control sub-unit 227A. These configurations of the condenser lens system 226 and the condenser lens system drive unit 227 are proposed, for example, in Japanese Patent Application Laid-Open No. 9-34,378. Further, those as proposed in Japanese Patent Application Laid-Open No. 8-353,023 may be used as the condenser lens system 226 and the condenser lens system drive unit 227.

The reticle blind unit 228 has substantially the same configuration as the illumination vision field diaphragm unit 123 as shown in Fig. 7. Reference symbol 228A stands for a movable blind, reference symbol 228B stands for a fixed blind, and reference numeral 229 stands for a movable blind control unit. The operations of the reticle blind unit 228 and the movable blind control unit 229 are disclosed, for example, in Japanese Patent Application Laid-Open No. 4-196,513 (U. S. Patent No. 5,473,410).

In Fig. 10, reference numeral 230 stands for a relay optical system, reference symbol 230F for a front group of the relay optical system 230, reference numeral 231 for a mirror for turning a light path, reference symbol 230R for a rear group of the relay optical system 230, and reference numeral 232 for a higher-order illuminance irregularity adjustment unit.

The higher-order illuminance irregularity adjustment unit 232 comprises a plurality of parallel flat panels each having a different thickness and being light-passing, which are disposed in the light path selectively so as to be movable, or a member having no nearly refractive power, which can vary its thickness in a continuous manner. The higher-order illuminance irregularity adjustment unit 232 can adjust a higher-order irregularity of illuminance on the reticle R or the wafer W by varying the thickness thereof in the light path. A drive unit 233 drives the higher-order illuminance irregularity adjustment unit 232 in accordance with an instruction from a main control unit 200 so as to insert one of the plural parallel flat panels of the higher-order illuminance irregularity adjustment unit 232 selectively into the light path or to make the thickness of the member having no refractive power set to become a predetermined thickness. The higher-order illuminance irregularity adjustment unit 232 is disclosed, for example, in Japanese Patent Application Laid-Open No. 9-82,631.

In Fig. 10, reference numeral 234 stands for a sub-chamber, and the sub-chamber 234 has substantially the same configuration as the illumination system cover 143 as shown in Fig. 7. The configuration of the such sub-chamber is disclosed, for example, in Japanese Patent Application Laid-Open No. 6-260,385 (U. S. Patent No. 5,559,584), Japanese Patent Application Laid-Open No. 8-279,458, and Japanese Patent Application Laid-Open No. 8-279,459.

Further, in Fig. 10, reference numeral 235 stands for a beam splitter, and reference numeral 236 stands for a reflectance sensor, as well as the beam splitter 235 and the reflectance sensor 236 have substantially the same configurations as the beam splitter 128 and the reflectance sensor 129, respectively.

The reflectance sensor 236 may be disposed on the side opposite to the integrator sensor 225 that is interposed between the reflectance sensor 236 and the beam splitter 224.

In Fig. 12, there is shown a reticle stage 240 that has substantially the same configuration as the reticle stage as shown in Fig. 7. In Fig. 12, reference numeral 241 stands for a reticle support table, reference symbols 242A and 243A each for a moving mirror, reference numerals 246 and 247 each for a Y-axial laser interferometer, reference symbols 242B and 243B each for a fixed mirror, reference numeral 244 for an X-axial moving mirror, and reference numeral 249 for a reticle stage control unit. The configuration and operation of the reticle stage are disclosed, for example, in Japanese Patent Application Laid-Open No. 6-291,019 (U. S. Patent No. 5,464,715). As the reticle stage, there may be used the reticle stage as disclosed, for example, in Japanese Patent Application Laid-Open No. 8-63,231.

A rectangle-shaped opening portion 240A having a size covering an entire area of an illumination region IA is disposed at a Y-directional end portion side on the reticle stage 240 in order to measure an irregularity of illuminance in a manner will be described hereinafter.

Returning now to Fig. 10, the projection optical system PL is disposed under the reticle R (on the -Z-directional side), which has a predetermined projection magnification β and which is telecentric at its both ends (on the reticle R side and the wafer W side). The projection optical system PL is disposed so as to allow a column 251 disposed on a base 250 to come into abutment with a fringe portion F.

As the reticle R is illuminated with the illumination light, the illumination light passes through a light-transmitting portion of a circuit pattern of the reticle R, and a diffraction light (including a O-th light) passed through the pattern is incident to the projection optical system PL, thereby forming a partial image of the circuit pattern in a linear slit-shaped or rectangle-shaped exposure region on the image plane side of the projection optical system. The partial image of the circuit pattern is a reduced image of a portion of the circuit pattern of the reticle R, which is superimposed on the illumination region IA. On the image plane of the projection optical system PL is disposed the wafer W as a photosensitive substrate, and a portion of the circuit pattern is transcribed on a resist layer on the surface of a portion of one shot region among the plural shot regions on the wafer W.

The wafer W is adsorbed on a wafer holder, although not shown, and the wafer holder is disposed on a focus-leveling stage 253 for adjusting the position in the light axis direction of the projection optical system PL and an inclination with respect to the light axis. A planar position detection unit 274 for detecting the position and the inclination of the light axis direction of the wafer W on the focus-leveling stage 253 is disposed under the projection optical system PL. As the planar position detection unit, there may be used the unit as disclosed, for example, in Japanese Patent Application Laid-Open No. 6-260,391 (U. S. Patent No. 5,448,332).

The focus-leveling stage 253 has a Y-stage 254 disposed so as to be movable in the Y-direction as shown in the drawing, and the Y-stage 254 has an X-stage 255 disposed so as to be movable in the X-direction as shown in the drawing.

Fig. 13 is a perspective view showing an example of the X-Y stage as described above. In Fig. 13, reference numeral 254 stands for a Y-stage, reference symbols 254F1 to 254F4, inclusive, each for a fluid bearing, reference numeral 255 for an X-stage, and reference symbol 255A for beams. The Y-stage 254 is configured so as to be movable in the Y-direction as shown in the drawing. Further, in Fig. 13, reference symbols 255C1-255C4, inclusive, stand each for a fluid bearing, reference symbols 255B1 and 255B2 each for a transferring guide, reference symbols 256A1 and 256A2 each for a fixed guide, and reference symbols 256B1 and 256B2 each for a magnetic track. The X-stage 255 is transferred in the X-direction as shown in the drawing in association with a motor coil in the X-stage 255.

In Fig. 13, reference numeral 257 stands for a Y-axial moving mirror, reference numeral 258 for an X-axial moving mirror, reference numeral 259 for a Y-axial laser interferometer, and reference numeral 260 for an X-axial laser interferometer.

The positions in the X-direction and the Y-direction of the Y-stage 254 can be measured always at a resolution of approximately 0.001 μm by the Y-axial laser interferometer 259 and the X-axial laser interferometer 260, respectively. The displacement of rotation (about the light axis of the projection optical system PL) of the Y-stage is measured by these laser interferometers. The measured values are supplied to a wafer stage control unit 261. The wafer stage control unit 261 is controlled by the main control unit 200. The X-Y stage is disclosed, for example, in Japanese Patent Application Laid-Open No. 8-233,964, and the X-Y stage as disclosed in Japanese Patent Application Laid-Open No. 8-31,728 can also be used. As the focus-leveling stage 253, that as disclosed, for example, in Japanese Patent Application Laid-Open No. 7-161,799, may be used.

At a portion on the Y-stage 254 are disposed a reticle coordinates system and a reference mark plate 254A, the reticle coordinates system being defined by the coordinates to be measured by the laser interferometers 246 to 248, inclusive, on the reticle side, and the reference mark plate 254a corresponding to a wafer coordinates system defined by the coordinates to be measured by the laser interferometers 259 and 260 on the wafer side. At a position in the vicinity of the reference mark plate 254a on the Y-stage 254 is disposed a light receipt section 254B of an illuminance meter for measuring a distribution of illuminance in the exposure region EA. The configuration of the reference mark plate 254a is disclosed, for example, in Japanese Patent Application Laid-Open No. 7-176,468 (U. S. Patent No. 5,646,413).

As shown in Fig. 14, a first reference mark for the reference mark plate 254a is provided above the reticle R (on the +Z-directional side). Moreover, reticle alignment microscopes 262 and 263 are disposed, too, which allow an observation of a mark provided on the reticle R together with the first reference mark. Further, turning mirrors 264 and 265 are disposed, which lead the detection light from the reticle R to the reticle alignment microscopes 262 and 263, respectively, the turning mirrors 264 and 265 being movably disposed so as to be inserted or detached in a position inside or outside the light path of the illumination light travelling toward the reticle R from the illumination optical system. As an exposure sequence has been started in a manner as will be described hereinafter, mirror drive units 266 and 267 evacuate the respective turning mirrors 264 and 265 from the light path in response to an instruction from the main control unit 200. An alignment unit 268 of an off-axis type for observing an alignment mark (a wafer mark) formed on the wafer W is disposed on the side surface in the Y-direction of the projection optical system PL. On the other hand, the reference mark plate 254A is provided with a second reference mark corresponding to the first reference mark, in order to allow a measurement of a baseline amount defining a distance between the reference position of the projection optical system PL and the alignment unit 268 of the off-axis type.

The reticle alignment microscopes 262 and 263 are then associated with the reticle coordinates and the wafer coordinates system.

Then, a description will be made of the configuration of the illuminance meter with reference to Fig. 15, in which Fig. 15(a) is an enlarged view showing an enlarged portion in the vicinity of the light receipt section 254B on the Y-stage 254, and Fig. 15(b) is a plan view showing the Y-stage 254. In Fig. 15(a), the light receipt section 254B comprises a plate-shaped member provided with a plurality of pinholes 254B1 to 254B5, inclusive. Each of the pinholes 254B1 to 254B5 is connected to an optical fiber 254D1 to 254D5, respectively, which each leads the light received through each of the pinholes 254B1 to 254B5. The optical fibers 254D1 to 254D5, inclusive, are each made of a material (for example, quartz glass, etc.) having a transmittance for the exposure light, and lead the light from the light receipt section 254B to a light delivery section 254C on the Y-stage 254. The light delivery section 254C is provided with a plurality of opening portions 254C1 to 254C5, inclusive, and the plural opening portions 254C1 to 254C5 are connected to an leaving end of each of the respective optical fibers 254D1 to 254D5, inclusive.

As shown in Fig. 15(b), the projection optical system PL is provided at its side with a detection section 254E for detecting the light from the light delivery section 254C. The detection section 254E comprises a relay optical system 254E1 for forming an image of the light delivery section 254C and a photoelectrical conversion element 254E2 disposed at the position of the image of the light delivery section 254C. The photoelectrical conversion element 254E2 is formed at its plural locations with light spots corresponding to the light incident to the plural opening portions 254B1 to 254B5, inclusive. Then, the photoelectrical conversion element 254E2 converts each light spot in a photoelectric mode in accordance with the light amount thereof and sends the output to the main control unit 200.

The detection section 254E is configured, as shown in Fig. 15(c), such that the detection section 254E is aligned so as to be superimposed right over the light delivery section 254C in such a state that the center of the projection optical system PL (the position of the light axis) is superimposed right over the light receipt section 254B. It is to be noted herein that, although Fig. 15 indicates an example where five opening portions are provided, the number of the opening portions. i.e. the number of detection points for detecting a distribution of illuminance, is not restricted to five, as a matter of course. The such configuration of the light receipt section is disclosed, for example, in Japanese Patent Application Laid-Open No. 10-74,680 and 10-293,677.

In the example as described above, it is shown that the light from the light receipt section 254B is led to the light delivery section 254C by means of the optical fibers. It can be noted that a turning mirror and a relay optical system can also be used, in place of the configuration as shown in the above example.

Further, in the example as described above, it is shown that the photoelectrical conversion element 254E2 is disposed outside the X-Y stages 254 and 255, however, the photoelectrical conversion element 254E2 may be disposed inside the Y-stage 254. This configuration can provide the advantage in that the probability of causing an error in detection by the optical system extending from the light receipt section 254B to the photoelectrical conversion element 254E2 can be made smaller.

Now, turning to Fig. 16, the projection optical system PL is shown which comprises a plurality of lens elements L1 to L16, inclusive, each being made of a material (for example, $SiO_2$, $CaF_2$, etc.) having a transmittance for the illumination light (the exposure light) from the excimer laser light source 212, lens frames C1 to C16, inclusive, for holding the respective lens elements L1 to L16, spacers S1 to S16, inclusive, each being disposed between the respective lens frames C1 to C16 to hold the respective lens elements L1 to L16 at a predetermined distance, and a barrel LB for accommodating the lens frames C1 to C16 and the spacers S1 to S16 therein. Moreover, in the first embodiment of the present invention, the projection optical system has parallel flat panels P1 and P2, each being made of a material having a transmittance for the exposure light, disposed in the positions of the barrel LB closest to the reticle R side and the wafer side, respectively, thereby providing a closed space that blocks and closes the inside of the barrel LB airtight from the outside atmosphere. Lines 269A to 269D are connected to the barrel LB, inclusive. Inert gases, such as dry nitrogen ($N_2$), which have the oxygen content to be controlled to an extremely low level, are supplied to the inside of the barrel LB, i.e., into a space each between the lens elements, through the lines 269A to 269D from a gas supply unit 270. The gas supply unit 270 has further the function of controlling the pressure among the intervals between the lens elements inside the barrel LB, and can adjust the pressure among the intervals between the lens elements in accordance with information from the main control unit 200. The adjustment of the pressure in the manner as described above is disclosed, for example, in Japanese Patent Application Laid-Open No. 60-78,416 (U. S. Patent No. 4,871,237).

A variation or fluctuation of transmittance may be caused by attachment of various impurities to the surfaces of the optical elements (e.g., lens elements L1 to L16, parallel flat panels P1, P2, etc.), which may be derived from various substances present inside the barrel LB, the various substances including, for example, materials constituting the lens elements, coating materials for coating the surfaces of the lens elements, adhesive for joining the lens elements to the lens frames, paints for preventing of reflection on coarsely polished surfaces of the lens elements, metallic and ceramic materials constituting the barrel, etc. Therefore, in order to reduce the variation in transmittance due to the attachment of such impurities, it is preferred that such impurities are removed, for example, by means of a chemical filter, an electrostatic filter or the like, while the dry nitrogen gas with its temperature controlled is forcibly flown inside the barrel LB by means of the gas supply unit 270.

Further, in the projection optical system PL as shown in Fig. 16, an opening diaphragm AS is configured such that its opening dimension is variable. The opening diaphragm unit 271 adjusts the opening dimension of the opening diaphragm AS in response to information relating to the opening dimension of the projection optical system PL from the main control unit 200. The barrel LB is provided inside with sensors 272A to 272D, inclusive, for sensing the state (pressure, temperature, moisture, etc.) of the atmosphere inside the barrel LB, and the outputs from the sensors 272A to 272D are sent to the main control unit 200. It is to be noted herein that, although the projection optical system PL as shown in Fig. 11 is directed to the number of sensors as described above, i.e., four sensors 274A to 274D, the present invention is not restricted to such a particular number and any appropriate number of sensors may be used, as needed.

Moreover, the projection optical system PL as shown in Fig. 16 is configured such that all the lens elements L1 to L16 are accommodated in one barrel LB, but the projection optical system PL may be of a configuration in such a manner that the lens elements L1 to L16 are divided each into an appropriate number and accommodated into an appropriate number of barrels, as disclosed, for example, in Japanese Patent Application Laid-Open No. 7-86,152.

In addition, as the projection optical system PL in the embodiments of the present invention, there may be used the projection optical system of a refraction type as proposed, for example, in Japanese Patent Application Laid-Open No. 10-79,345 or the projection optical system of a reflection-refraction type as proposed, for example, in Japanese Patent Application Laid-Open No. 8-171,054 (U. S. Patent No. 5,668,672) and Japanese Patent Application Laid-Open No. 8-304,705 (U. S. Patent No. 5,691,802).

Now, turning back to Fig. 10, the projection exposure apparatus in the fourth embodiment of the present invention is shown therein, which is provided with a bar code reader 273, like in the case as shown in Fig. 7, for distinguishing the kinds of the reticles R to be loaded on the reticle stage 240.

Then, a description of an example of the exposure sequence of the projection exposure apparatus in the fourth embodiment of the present invention with reference to the flow chart of Fig. 17.

In the flow chart as shown in Fig. 17, at step S210. various exposure conditions are set by the main control unit 200 in order to subject shot regions on the wafer W to scanning exposure at an appropriate exposure light amount. The techniques for setting the appropriate exposure conditions will be described hereinafter. The main control unit 200 sends an instruction to an exposure control unit 211 for controlling the excimer laser light source 212 and the variable light extinction device 216 on the basis of the set exposure conditions.

Each one of the shot regions on the wafer W is subjected to scanning exposure at step S210 in the manner as described above.

Then, a description will be made of the setting of the exposure condition at step S210. As the technique for controlling the exposure light amount in the fourth embodiment of the present invention, there may be used the technique as disclosed, for example, in Japanese Patent Application Laid-Open No. 8-250,402. The technique as disclosed therein comprises computing an accumulated exposure light amount of the pulse light irradiated until then at every irradiation with the pulse light, determining an average value of the accumulated exposure light amount so computed and an average pulse energy, and adjusting the accumulated exposure light amount so as to become closer to a target accumulated exposure light amount on the basis of the average value of the accumulated exposure light amount and the average pulse energy, in order to reduce a fluctuation or deviation of the exposure light amount among the shot regions (the wafers) due to a fluctuation of the energy of the pulse laser light from the excimer laser light source 212.

In the fourth embodiment, the above technique is different from the technique as disclosed in Japanese Patent Application Laid-Open No. 8-250,402 in that the target accumulated exposure light amount is multiplied by a variation portion of the transmittance as a coefficient. Now, a description will be made of the way of determining the coefficient by the variation portion of the transmittance. It should be noted herein that the operation for correcting an irregularity of illuminance is also described hereinafter because the operation for correcting the irregularity of illuminance has to be taken into account, too, upon determining the such coefficient.

Fig. 18 is a series of graphs for explaining the operations for correcting the irregularity of illuminance, in which Fig. 18(a) shows a state of the irregularity of illuminance on the exposure region EA of the wafer W; Fig. 18(b) shows a distribution of illuminance to be generated in order to correct the irregularity of illuminance; Figs. 18(c) to 18(e) show each a state in which the distribution of illuminance of Fig. 18(b) is divided into three components of the distribution of illuminance; and Fig. 18(f) shows a state after the correction of the irregularity of illuminance. In each of Figs. 18(a) to 18(f), the Y-axis represents the intensity of light, and the X-axis represents the coordinate along the meridional direction on the wafer plane. The original point on the X-axis is the position of the light axis of the projection optical system PL.

First, in the exposure region EA of the wafer W, the distribution of illuminance is supposed to be as shown in Fig. 18(a). In order to make the distribution of illuminance of Fig. 18(a) flat, the distribution of illuminance to be generated by the condenser lens system 226 and the higher-order illuminance irregularity adjustment unit 232 is an inverted characteristic as shown in Fig. 18(b). The distribution of illuminance of the inverted characteristic as shown in Fig. 18(b) can be considered as three divisions into which the inverted characteristic of Fig. 18(b) is divided, i.e., the first division being the distribution of illuminance of an concave-convex component, as shown in Fig. 18(c); the second division being the distribution of illuminance of an inclining component, as shown in Fig. 18(d); and the third division being the distribution of illuminance of a higher-order component, as shown in Fig. 18(e).

The control sub-unit 227A of the condenser lens system drive unit 227 sends to the drive sub-unit 227B an instruction to transfer the front group 226F of the condenser lens system 226 to the position at which the distribution of illuminance as shown in Fig. 18(c) is to be generated, while it sends to the drive sub-unit 227C an instruction to transfer the rear group 226R of the condenser lens system 226 to the position at which the distribution of illuminance as shown in Fig. 28(d) is to be generated. The drive unit 233 for driving the higher-order illuminance irregularity adjustment unit 232 determines the thickness of the parallel flat panel (the thickness of the member having no refraction power) so as to generate a distribution of illuminance as shown in Fig. 18(e) and inserts the parallel flat panel of that thickness into the light path (or adjust the thickness of the member having no refraction power).

Although the distribution of illuminance as shown in Fig. 18(f) can be obtained in the procedures as described above, it is found that, when the intensity of the light at the original point of the distribution of illuminance in this instance (corresponding to the average light intensity on the exposure region EA because the distribution is flat) is taken into account, the transmittance of this optical system is varied by a variation amount κ as compared with the transmittance of the optical system is 100%, due to the influence of the transmittance of the optical system extending from the beam splitter 226 branching the light into the integrator sensor 225 to the projection optical system PL.

The variation amount κ may vary with the history of irradiation (a history of the exposure light passing through the illumination optical system and the projection optical system), as will be described hereinafter. Therefore, in the fourth embodiment, the exposure light amount is controlled on the basis of the target accumulated exposure light amount modified by multiplying the target accumulated exposure light amount by the portion of the variation amount κ as a coefficient δ.

Moreover, in the fourth embodiment of the present invention, the memory 210 in the main control unit 200 is saved with the relationship among the history of irradiation, the corrected amounts, and coefficients δ for modification of the target accumulated exposure light amount as a history table. In this embodiment, the condition for illumination is determined primarily for each kind of the reticle R, so that a table relating to the irradiation time and a table relating to the irradiation stop time are used, the table relating to the irradiation duration time in which the correction amount Δ26F for the front group 226F, the correction amount Δ26R for the rear group 226R, the correction amount Δ32 for the higher-order illuminance irregularity adjustment unit 232, and the coefficient δ for correction of the target accumulated exposure light amount are saved for the correction of the irradiation duration time, and the table relating to the irradiation suspension time in which the correction amount Δ26F for the front group 226F, the correction amount Δ26R for the rear group 226R, the correction amount Δ32 for the higher-order illuminance irregularity adjustment unit 232, and the coefficient δ for correction of the target accumulated exposure light amount are saved for the correction of the irradiation suspension time. The tables of the irradiation duration time and the irradiation suspension time are shown in Figs. 19 and 20, respectively. The irradiation duration time so referred to herein is meant to denote the period of time during which the exposure light travels through the illumination optical system and the projection optical system, while the irradiation suspension time so referred to herein is meant to denote the period of time during which no exposure light travels through the illumination optical system and the projection optical system. Further, in the tables relating to the irradiation duration time and the irradiation suspension time, the correction amount and the coefficient at every predetermined unit time are saved. The time interval of the unit time corresponds to the interval of the pulse signals by a timer section disposed in the main control unit 200. The correction amounts Δ26F, Δ26R and Δ32 are not each an absolute amount of variation from the predetermined original point, but an amount of variation when the state just before one in the unit times is set as the original point. In this instance, it is not preferred to set the absolute amount of variation from the predetermined original point because there is the risk that an amount of information on the coefficients for modifications as described above may become too large.

At this time, however, it is necessary to change the correction amount of each of the front group 226F, the rear group 226R and the higher-order illuminance irregularity adjustment unit 232 and the coefficient δ therefor in accordance with the magnitude of the energy of the exposure light passing through the illumination optical system and the projection optical system PL. In the fourth embodiment of the present invention, coefficients ε, ζ, η, and ι for modifying the correction amount of the front group 226F, the correction amount of the rear group 226R, the correction amount of the higher-order illuminance irregularity adjustment unit 232 and the coefficient δ, respectively, in the form corresponding to the intensity of the exposure light (corresponding to the energy of the exposure light) to be detected by the integrator sensor 225, are saved in an irradiation energy modification table, as shown in Fig. 21.

Further, the transmittance of the projection optical system PL and the illumination optical system may be changed in the ascent direction by the phenomenon that the exposure light from the projection optical system PL is returned again to the projection optical system PL by the reflection of the wafer W itself. Therefore, there may be the case where the state of the variation in transmittance may vary by the reflectance of the wafer W. Therefore, in the fourth embodiment of the present invention, each of the correction amounts and the coefficient δ saved in the table relating to the irradiation duration time among the history tables are modified in accordance with the light amount of the light travelling through the projection optical system PL and the illumination optical system in a reverse direction after the reflection at the wafer W. Thus, coefficients ξ, ρ, τ, and χ are saved in a wafer reflectance modification table, as shown in Fig. 22, which coefficients are to modify the correction amount of the front group 226F, the correction amount of the rear group 226R, the correction amount of the higher-order illuminance irregularity adjustment unit 232, and the coefficient δ, in the form corresponding to the intensity (corresponding to the reflectance in the case of the wafer W) of the returning light to be detected by the reflectance sensor 236.

The memory 210 is provided with temporary memory sections, i.e. a first temporary memory section M1 to an eighteenth temporary memory section M18, inclusive, in addition to the irradiation duration time table, the irradiation suspension time table, the irradiation energy modification table and the wafer reflectance modification table. These temporary memory sections M1 to M18 can function each as a register.

Now, a description will be made of the adjustment of the irregularity of illuminance using the irradiation duration time table, the irradiation suspension time table, the irradiation energy modification table and the wafer reflectance modification table, with reference to the flow chart as shown in Fig. 23.

First, at step S301, the main control unit 200 is provided with zero (0) as a count number N in the first temporary memory section M1 in the memory 210.

Then, at step S302, count 1 is added to the count number N entered in the first temporary memory section M1 in accordance with the pulse signal by the timer section in the main control unit 200.

At the next step S303, the main control unit 200 decides whether the integrator sensor 225 outputs or not. When it is decided that the integrator sensor 225 have output, then the program goes to step S304. On the other hand, when it is decided that there is no output from the integrator sensor 225, the program goes to step S315.

The following is a description of the case where it is decided that there is the output from the integrator sensor 225.

In this instance, at step S304, the value S25 of the photoelectrical conversion output from the integrator sensor 225 is saved in the second temporary memory section M2, and the value S36 of the photoelectrical conversion output from the reflectance sensor 236 is saved in the third temporary memory section M3.

At step S305, each of the coefficient $\delta$, the correction amount $\Delta$26F, the correction amount $\Delta$26R, and the correction amount $\Delta$32 corresponding to the value of the count number N saved in the first temporary memory section M1 is read from the irradiation duration time table. Then, the coefficient $\delta$ is saved in the fourth temporary memory section M4, the correction amount $\Delta$26F in the fifth temporary memory section M5, the correction amount $\Delta$26R in the sixth temporary memory section M6, and the correction amount $\Delta$32 in the seventh temporary memory section M7.

Then, the program goes to step S306 at which the coefficient $\varepsilon$ for modifying the coefficient $\delta$, the coefficient $\zeta$ for modifying the correction amount $\Delta$26F, the coefficient $\eta$ for modifying the correction amount $\Delta$26R, and the coefficient $\iota$ for modifying the correction amount $\Delta$32, each corresponding to the output S25 saved in the second temporary memory section M2, are read from the irradiation energy modification table. Then, the coefficient $\varepsilon$ is saved in the eighth temporary memory section M8, the coefficient $\zeta$ in the ninth temporary memory section M9, the coefficient $\eta$ in the tenth temporary memory section M10, and the coefficient $\iota$ in the eleventh temporary memory section M11.

Further, the program goes to step S307 at which the coefficient $\xi$ for modifying the coefficient $\delta$, the coefficient $\rho$ for modifying the correction amount $\Delta$26F, the coefficient $\tau$ for modifying the correction amount $\Delta$26R, and the coefficient $\chi$ for modifying the correction amount $\Delta$32, each corresponding to the output S36 saved in the third temporary memory section M3, are read from the irradiation energy modification table. Then, the coefficient $\xi$ is saved in the twelfth temporary memory section M12, the coefficient $\rho$ in the thirteenth temporary memory section M13, the coefficient $\tau$ in the fourteenth temporary memory section M14, and the coefficient $\chi$ in the fifteenth temporary memory section M15.

Then, at step S308, the coefficient $\delta$ saved in the fourth temporary memory section M4 is multiplied by the coefficient $\varepsilon$ saved in the eighth temporary memory section M8 and the coefficient $\xi$ saved in the twelfth temporary memory section M12 to give a modified coefficient that is then entered in the fourth temporary memory section M4. The modified coefficient is then sent to the exposure light amount control unit 211.

At step S309, a modified correction value $\Delta$26Fc is obtained by multiplying the correction amount $\Delta$26F saved in the fifth temporary memory section M5 by the coefficient $\zeta$ saved in the ninth temporary memory section M9 and the coefficient $\rho$ saved in the thirteenth temporary memory section M13, and the modified correction value $\Delta$26Fc is saved in the fifth temporary memory section M5.

At step S310, the correction amount $\Delta$26R saved in the sixth temporary memory section M6 is multiplied by the coefficient $\eta$ saved in the tenth temporary memory section M10 and the coefficient $\tau$ saved in the fourteenth temporary memory section M14 to give a modified correction amount $\Delta$26Rc, and the modified correction amount $\Delta$26Rc is saved in the sixth temporary memory section M6.

Then, at step S311, the correction amount $\Delta$32 saved in the seventh temporary memory section M7 is multiplied by the coefficient $\iota$ saved in the eleventh temporary memory section M11 and the coefficient $\chi$ saved in the fifteenth temporary memory section M15 to give a modified correction amount $\Delta$32c, and the modified correction amount $\Delta$32c is then saved in the seventh temporary memory section M7.

At step S312, the modified correction value $\Delta$26Fc saved in the fifth temporary memory section M5 is added to the sixteenth temporary memory section M16. In other words, the accumulated value of the modified correction value $\Delta$26Fc is saved as $\Sigma\Delta$26Fc in the sixteenth temporary memory section M16.

Then, at step S313, the modified correction value $\Delta$26Rc saved in the sixth temporary memory section M6 is added to the seventeenth temporary memory section M17. In other words, the accumulated value of the modified correction value Δ26Rc is saved as ΣΔ26Rc in the seventeenth temporary memory section M17.

Further, at step S314, the modified correction value Δ32c saved in the seventh temporary memory section M7 is added to the eighteenth temporary memory section M18. In other words, the accumulated value of the modified correction value Δ32c is saved as ΣΔ32c in the eighteenth temporary memory section M18.

After step S314, the program advances to step S320.

The above description at steps S304 to S314 is directed to the case where there was the output from the integrator sensor 225. On the other hand, a description will be made of the case where no output was sent from the integrator sensor 225 at step S303.

In this instance, at step S315, each of the coefficient δ, the correction amount Δ26F, the correction amount Δ26R, and the correction amount Δ32 corresponding to the value of the count number N saved in the first temporary memory section M1 is read from the irradiation suspension time table. Then, the coefficient δ is saved in the fourth temporary memory section M4, the correction amount Δ26F in the fifth temporary memory section M5, the correction amount Δ26R in the sixth temporary memory section M6, and the correction amount Δ32 in the seventh temporary memory section M7.

At step S316, the coefficient δ saved in the fourth temporary memory section M4 is sent to the exposure light amount control unit 211.

Then, at step S317, the correction amount Δ26F saved in the fifth temporary memory section M5 is added to the sixteenth temporary memory section M16. In other words, the accumulated correction amount ΣΔ26F is saved in the sixteenth temporary memory section M16.

Further, at step S318, the correction amount Δ26R saved in the sixth temporary memory section M6 is added to the seventeenth temporary memory section M17. In other words, the accumulated correction amount ΣΔ26R is saved in the seventeenth temporary memory section M17.

Moreover, at step S319, the correction amount Δ32 saved in the seventh temporary memory section M7 is added to the eighteenth temporary memory section M18. In other words, the accumulated correction amount ΣΔ32 is saved in the eighteenth temporary memory section M18.

After step S319, the program goes to step S320.

At step S320, it is decided to determine whether the accumulated correction amount ΣΔ26F (ΣΔ26Fc) saved in the sixteenth temporary memory section M16 exceeds a predetermined acceptable value. When it is decided that the accumulated correction amount does not exceed the predetermined acceptable value, then the program goes to step S322. On the other hand, when it is decided that the accumulated correction amount exceeds the predetermined acceptable value, then the program goes to step S321. The acceptable value so referred to herein corresponds to an acceptable scope of a deviation from a uniform distribution of illuminance on the wafer W, and the acceptable value can be optionally set by the operator operating the projection exposure apparatus according to the present invention.

Then, at step S321, an instruction is given to the condenser lens system drive unit 227 to transfer the front group 226F of the condenser lens system 226 by the accumulated correction amount ΣΔ26F (ΣΔ26Fc) saved in the sixteenth temporary memory section M16, and the value in the sixteenth temporary memory section M16 is reset to zero (0), followed by advancing to the next step S322.

At step S322, it is decided to determine whether the accumulated correction amount ΣΔ26R (ΣΔ26Rc) saved in the seventeenth temporary memory section M17 exceeds a predetermined acceptable value. When it is decided that the accumulated correction amount does not exceed the predetermined acceptable value, then the program goes to step S324. On the other hand, when it is decided that the accumulated correction amount exceeds the predetermined acceptable value, then the program goes to step S323. The acceptable value so referred to herein likewise corresponds to an acceptable scope of a deviation from a uniform distribution of illuminance on the wafer W, and the acceptable value can be optionally set by the operator operating the projection exposure apparatus according to the present invention.

Then, at step S323, an instruction is given to the condenser lens system drive unit 227 to transfer the rear group 226R of the condenser lens system 226 by the accumulated correction amount ΣΔ26R (ΣΔ26Rc) saved in the seventeenth temporary memory section M17, and the value in the seventeenth temporary memory section M17 is reset to zero (0), followed by advancing to the next step S324.

Then, at step S324, it is decided to determine whether the accumulated correction amount ΣΔ32 (ΣΔ32c) saved in the eighteenth temporary memory section M18 exceeds a predetermined acceptable value. When it is decided that the accumulated correction amount does not exceed the predetermined acceptable value, then the program goes to step S326. On the other hand, when it is decided that the accumulated correction amount exceeds the predetermined acceptable value, then the program goes to step S325. The acceptable value so referred to herein likewise corresponds to an acceptable scope of a deviation from a uniform distribution of illuminance on the wafer W, and the acceptable value can be optionally set by the operator operating the projection exposure apparatus according to the present invention.

Then, at step S325, an instruction is given to the drive unit 233 to vary the thickness of the parallel flat panel in the higher-order illuminance irregularity adjustment unit 232 by the accumulated correction amount ΣΔ32 (ΣΔ32c) saved in the eighteenth temporary memory section M18, and then the value in the eighteenth temporary memory section M18 is reset to zero (0), followed by advancing to the next step S326.

Then, at step S326, it is decided to determine whether the value of the count number N exceeds a predetermined value K. The predetermined value K is a value corresponding to a time axis each of the irradiation duration time table and the irradiation suspension time table. When it is decided that the count number N does not exceed the predetermined value K, then the program goes to step S302. On the other hand, when it is decided that the count number N exceeds the predetermined value K, then the program is terminated.

By executing a sequence of the adjustment of the irregularity of illuminance in the manner as described above, the distribution of illuminance on the wafer surface can be maintained always in a uniform fashion or in the form of a predetermined illuminance distribution, even if the transmittance would fluctuate with an elapse of time, thereby improving uniformity of line widths in the shot regions on the wafer and assisting in manufacturing devices of a high quality.

In the examples as described above, the conditions are configured such that each of the correction amount Δ26F, the correction amount Δ26R and the correction amount Δ32 as well as the coefficient δ is saved always at the identical time intervals in the history table, but the time interval (i.e., the interval at which the count number N is counted) is not necessarily set to be identical. Fig. 24 shows a periodical variation of illuminance by irradiation at one point present on the exposure region EA, in which the Y-axis represents illuminance and the X-axis represents an irradiation time. As is apparent from Fig. 24, the illuminance per unit time varies to a steep extent for a while from the point of time immediately after irradiation of light and the variation in illuminance per unit time becomes milder thereafter. Therefore, at step S302, it is not required that count 1 be added to the count number N at every pulse signal from the timer section and that count 1 can be added to the count number N when the pulse signals reach a predetermined number from the timer section, when the variation in illuminance (variation in a distribution of illuminance) per unit time is small and mild. At this time, it is needless to state that the time interval for each of each of the correction amount Δ26F, the correction amount Δ26R and the correction amount Δ32 as well as the coefficient δ to be saved in the irradiation duration time table and the irradiation suspension time table should be altered in accordance with the variation in the distribution of illuminance per unit time. With this configuration, the volume of the irradiation duration time table and the irradiation suspension time table can be reduced.

Further, in the examples as described above, the configuration is such that each of the correction amount Δ26F, the correction amount Δ26R and the correction amount Δ32 as well as the coefficient δ per unit time is saved by means of the history tables, however, it can be saved instead by means of a predetermined function. In this instance, as a function, there may be used a function f(t) representing a variation in illuminance with respect to the irradiation time at plural points in the exposure region EA and a function g(t) representing a variation in illuminance with respect to the irradiation suspension time at plural points in the exposure region EA. These functions f(t) and g(t) can be obtained from a result by experiments by means of techniques such as, for example, the least square method.

In this instance, the distribution of illuminance on the exposure region EA is obtained by computing the illuminance at each of the plural points of the exposure region EA by means of the above functions f(t) and g(t), and the irregularity of illuminance may be corrected by using the front group 226F and the rear group 226R of the condenser lens system 226 as well as the higher-order illuminance irregularity adjustment unit 232 by means of the techniques as shown in Figs. 18(a) to 18(f), inclusive. At this time, the memory 210 may be saved with the transferring amount of the front group 226F and the rear group 226R of the condenser lens system 226 as well as the adjusting amount of the higher-order illuminance irregularity adjustment unit 232 in the form corresponding to the distribution of illuminance on the exposure region EA.

It is to be noted herein that the variation in the distribution of illuminance can be corrected in accordance with the history of irradiation by using the predetermined function in the manner as described above.

Moreover, in the examples as described above, the values of the irradiation duration time table are modified by the magnitude of the irradiating energy. In accordance with the present invention, instead, it is also possible, however, to save each of the correction amount Δ26F, the correction amount Δ26R and the correction amount Δ32 as well as the coefficient δ in the table in accordance with the product obtained by multiplying the irradiation time by the irradiating energy.

In addition, irradiation time tables under a predetermined irradiating energy and a predetermined reflectance of a wafer may be prepared each for a combination of the predetermined irradiating energy with the reflectance of the wafer, in place of the configuration in which the irradiation duration time table can be modified on the basis of the magnitude of the irradiating energy or the magnitude of the reflectance of the wafer.

The projection exposure apparatus in the fourth embodiment of the present invention is directed to a projection exposure apparatus of a scanning type, which is so adapted as to effect the exposure while the projection optical system PL is being transferred relative to the reticle R and the wafer W. In this instance, there may be the occasion that the state of a diffraction light passing through the projection optical system PL may vary with scanning due to a distribution of density of patterns on the reticle R. It is thus preferred that the history tables as described above or the functions f(t) and g(t) are determined by taking into account a variation in the distribution of illuminance due to a variation in the diffraction light.

In the above examples, the kinds of the reticles R and the illumination conditions are determined primarily. When plural illumination conditions can be set for the reticle R, however, a plurality of irradiation duration time tables are prepared for each of the plural illumination conditions or correction values and coefficients of the irradiation duration time table may be modified in accordance with the illumination conditions, i.e., a modification table is prepared in accordance with the illumination conditions.

In the method for correcting the variation in the distribution of illuminance in accordance with the fourth embodiment of the present invention, it is preferred that an actual distribution of illuminance is measured at a predetermined time interval and that a correction amount from the history table or a correction amount to be computed by the functions f(t) and g(t) is modified in accordance with the actual distribution of illuminance measured.

The procedures for this correction method will be described briefly. First, the main control unit 200 sends an instruction to the wafer stage control unit 261 to transfer the Y-stage 254 so as to superimpose the light receipt section 254B of Fig. 15 over the exposure region EA by the projection optical system PL. At the same time, the main control unit 200 sends the reticle stage control unit 249 to transfer the reticle stage 240 so as to superimpose the opening portion 240A on the reticle stage 240 over the exposure region IA. Thereafter, the main control unit 200 sends an instruction to the exposure light amount control unit 211 to allow the excimer laser light source 212 to emit the exposure light. At this instance, the output from the photoelectrical conversion element 254E2 in the detection section 254E as shown in Fig. 15 is associated with the actual distribution of illuminance. The main control unit 200 compares the actual distribution of illuminance by the output from the photoelectrical conversion element 254E2 with the distribution of illuminance estimated by the history table or the function, and determines an amount of a deviation of the estimated distribution of illuminance from the actual distribution of illuminance, thereby correcting the estimated distribution of illuminance on the basis of the amount of deviation. In this instance, in the examples as described above, the process is carried out by using the correction amount of the front group 226F and the rear group 226R of the condenser lens system 226 as well as the higher-order illuminance irregularity adjustment unit 232, not by using the distribution of illuminance, so that the comparison can be made after converting the actually measured distribution of illuminance into the corresponding correction amount.

The timing for measuring the actual distribution of illuminance in the manner as described above may include, for instance, loading the reticle at step S201 in the flow chart of Fig. 17, immediately before or after aligning the reticle or effecting the baseline measurement at step S204, loading the wafer at step S205, and unloading the wafer at step S212. The measurement of the distribution of illuminance immediately before the alignment of the reticle and the baseline measurement is preferable than the measurement thereof immediately thereafter because no error is caused to occur upon transferring the opening portion 240A of the reticle stage 240 so as to agree with the exposure region IA. On the other hand, in the case where the distribution of illuminance is measured at the time of loading the wafer or unloading the wafer, it is preferred that the position of the light receipt section 254B is set so as to be superimposed over the exposure region of the projection optical system PL upon transferring the Y-stage 254 to the position at which the wafer is loaded.

Further, it is preferred that the time interval for measuring the actual distribution of illuminance is set to be shorter at the time of the start of operation after the operation of the projection exposure apparatus has been suspended during a long period of time, or immediately after the shift of the illumination condition.

In the fourth embodiment of the present invention, as shown in Fig. 15, the illuminance is measured at the plural locations in the exposure region EA concurrently. For instance, as shown in Fig. 25(a), the distribution of illuminance can be measured using the light receipt section 254B having one opening 254B1 by repeating the measurement while transferring the light receipt section 254B in the X-Y direction. In this instance, the light receipt section 254B may preferably be disposed at the position where an image of the light delivery section 254c is not formed on the photoelectrical conversion element 254E2, but where the light from the light delivery section 254C is nearly collimated, for example, as shown in Fig. 25(b). This configuration presents the advantage in that an influence of the photoelectrical conversion element 254B upon the irregularity of sensitivity can be disregard nearly completely, because the identical position of the photoelectrical conversion element 254E2 can be used.

Further, in Fig. 15, the distribution of illuminance only in the direction perpendicular to the scanning direction is measured by taking the effect of canceling the irregularity of illuminance in the scanning direction upon scanning exposure into account. However, when it can be decided that the influence upon the irregularity of illuminance in the scanning direction becomes large, the distribution of illuminance may be measured in the scanning direction, too, by using the opening portions 254B1 to 254B21, inclusive, disposed in a matrix form, for example, as shown in Fig. 25(c).

Moreover, as shown in Fig. 15 or Fig. 25, in the case where the illuminance is measured at the plural locations concurrently by using the plural pinholes (opening portions) 254B1 to 254B5 and 254B6 to 254B21, the distribution of illuminance is obtained by repeating the measurement using a particular one (for example, the pinhole 254B1) out of the plural opening portions by transferring the light receipt section 254B in the X-Y direction, and by comparing the distribution of illuminance with the distribution of illuminance obtained by concurrent measurements at the plural locations, thereby enabling correction of the influence of the photoelectrical conversion element itself upon the irregularity of sensitivity.

Although a description is omitted above, it is needless to say that the output from the reflectance sensor 236 can be used for adjusting the projection magnification β of the projection optical system PL in a type as disclosed, for example, in Japanese Patent Application Laid-Open No. 62-183,522 (U. S. Patent No. 4,780,747).

Furthermore, the actual distribution of illuminance only can be measured without using the history table or function, and the irregularity of illuminance on the exposure region can be adjusted on the basis of the result of measurement. In this instance, the distribution of illuminance may be measured immediately before or after the alignment and the baseline measurement at step S204 in the flow chart of Fig. 17, at the time of loading the wafer at step S205, or at the time of unloading the wafer at step S212.

In addition, in the case where the actual distribution of illuminance is measured without using the opening portion 240A in the manner as described above, while the reticle R is stayed loaded, information relating to an ideal distribution of illuminance by the light through the reticle R can be saved in the memory 210, and the ideal distribution of illuminance can be compared with the distribution of illuminance measured through the reticle R.

Next, a description will be made of the example in which the present invention is applied to a projection exposure apparatus of a step-and-repeat type.

Fig. 26 schematically shows the projection exposure apparatus of the step-and-repeat type in the fifth embodiment. The identical members having the same functions as in the embodiment as shown in Fig. 10 are provided with the identical reference numerals and symbols.

The configuration of the projection exposure apparatus of Fig. 26 differs from that of the projection exposure apparatus of Fig. 10 to a great extent in that the reticle blind unit 237 is disposed, in place of the reticle blind unit 228, an illuminance distribution correction unit 238 is disposed on the leaving plane side of the second fly-eye lens 221, in place of the higher-order illuminance irregularity adjustment unit 232, and the planar position detection unit 275 is disposed, in place of the configuration of the reticle stage, the configuration of the light receipt portion on the Y-stage 254, and the planar position detection unit 274.

First, the configuration of the reticle stage will be described with reference to Fig. 27. In Fig. 27, the reticle R is adsorbed and fixed on a reticle stage 280, and the reticle stage 280 is mounted on a reticle support table 281 through a bearing, although not shown, so as to move in all the directions (in the X-direction, the Y-direction and the direction of rotation (θ)) on the X-Y plane. In Fig. 27, reference symbols 282A and 283A stand each for a moving mirror, reference numerals 286 and 287 each for a Y-axial laser interferometer, reference symbols 282B and 283B each for a fixed mirror, reference symbol 284A for a moving mirror, reference numeral 288 for an X-axial laser, and reference symbol 285B for a fixed mirror.

The X-directional and Y-directional positions are measured always at a resolution of about 0.001 μm, and the measured value is supplied to the reticle stage control unit 289.

Further, as shown in Fig. 28, the configuration of the X-Y stage is basically the same as in the fourth embodiment, but it differs therefrom in the configuration of the reference mark plate 254A and the light receipt section 254B, each provided on the Y-stage 254. The configuration of the reference mark plate in the projection exposure apparatus of the step-and-repeat type is disclosed, for example, in Japanese Patent Application Laid-Open No. 4-324,923 (U. S. Patent No. 5,243,195) and Japanese Patent Application Laid-Open No. 6-97,031. In the fifth embodiment of the present invention, the technology disclosed, for example, in Japanese Patent Application Laid-Open No. 4-324,923 (U. S. Patent No. 5,243,196), Japanese Patent Application Laid-Open No. 6-97,031 may be utilized as it is or as modified to some extent, so that the description of the technology will be omitted hereinafter.

An example of the configuration of the light receipt section 254B on the Y-stage 254 is shown in Fig. 29. The fifth embodiment differs from the fourth embodiment in that the exposure region EA is in a nearly square form and that points for measuring illuminance are disposed over the nearly entire area of the exposure region EA in order that the exposure is performed collectively. Fig. 29(a) shows an example in which plural opening portions 254B1 are disposed in a matrix form, and Fig. 29(b) shows an example in which plural opening portions 254B1 are disposed in a concentric form. Like in the fourth embodiment, these plural opening portions 254B1 are connected each to an optical fiber to lead the light of the plural opening portions 254B1 to the light delivery section 254C.

Then, a description will be made of the illuminance distribution correction unit 238. The illuminance distribution correction unit 238 comprises a plurality of illuminance distribution adjustment members to be disposed selectively in the light path on the incident side of the second fly-eye lens. One of the illuminance distribution adjustment members is shown, for example, in Figs. 30(a) and 3(b) as an illuminance distribution adjustment member 238A. Fig. 30(a) is a plan view showing the fly-eye lens 221 when looked from the side of the illuminance distribution adjustment member 238A, and Fig. 30(b) is a side view thereof. In the configuration as described above, the illuminance distribution adjustment member 238A comprises light amount attenuation sections 238A1 to 238A5, inclusive, each having a predetermined distribution of illuminance to vary the distribution of intensity of the light flux incident to each of lens elements 221A to 221U, inclusive, constituting the second fly-eye lens 221, disposed each on the parallel flat panels. The illuminance distribution adjustment member 238A is disclosed, for example, in Japanese Patent Application Laid-Open No. 7-130,600.

In the fifth embodiment of the present invention, plural illuminance distribution adjustment members, each having a transmittance characteristic different from the illuminance distribution adjustment member 238A, are disposed, in addition to the illuminance distribution adjustment member 238A. Further, these plural illuminance distribution adjustment members are disposed on the illuminance distribution correction unit 238, for example, in the form of a turret. The drive unit 239 drives the illuminance distribution correction unit 238 so as to selectively locate one of the illuminance distribution adjustment members in the illuminance distribution correction unit 238 in response to an instruction from the main control unit 200. This operation permits a selective alteration of the distribution of illuminance on the reticle R or the wafer W. It is to be noted herein that, in the fifth embodiment of the present invention as described above, too, the distribution of illuminance of the concave-convex component and the inclining component are adjusted by transferring the front group 226F and the rear group 226R of the condenser lens system 226, so that the plural illuminance distribution adjustment members correct an irregularity of illuminance that cannot be corrected to a full extent by the condenser lens system 226.

Moreover, in the fourth embodiment of the present invention, the correction amount of the higher-order illuminance irregularity adjustment unit 232 is saved in the history table in the memory 210. In the fifth embodiment, however, information relating to the kind of the illuminance distribution adjustment members to be inserted into the light path may be saved, in place of the correction amount of the higher-order illuminance irregularity adjustment unit 232. In this instance, as the operation for modifying the correction amount by multiplication by the coefficient as in the fourth embodiment cannot be adopted in this embodiment, unlike the fourth embodiment, it is preferred that the irradiation duration time tables relating to the illuminance distribution adjustment member under the predetermined irradiation energy and the predetermined reflectance of the wafer are prepared each for a combination of the predetermined irradiation energy with the predetermined reflectance of the wafer.

Then, a brief description will be made of the correction operation. First, the main control unit 200 corrects the distribution of illuminance of the concave-convex component and the inclining component in substantially the same manner as in the fourth embodiment. Further, the main control unit 200 reads information relating to the kind of the illuminance distribution adjustment member from the history table saved in the memory 210 in accordance with the kind of the reticle R, the illumination condition, the output from the integrator sensor 225, and the output from the reflectance sensor 236, and sends the resulting information to the drive unit 238. Then, the drive unit 238 inserts the corresponding illuminance distribution adjustment member into the light path in response to the information from the main control unit 200. This operation can make uniform the distribution of illuminance on the exposure region EA of the wafer W.

The entire exposure sequence in this embodiment is substantially the same as in the fourth embodiment as shown in Fig. 17. The procedures from step S204 to step S208 are conducted in accordance with the procedures as disclosed in Japanese Patent Application Laid-Open No. 4-324,923 and Japanese Patent Application Laid-Open No. 6-97,031. The scanning exposure at step S210 differs from the fourth embodiment in that the exposure is effected in a collective manner.

Concerning the controls of the exposure light amount, the technology as disclosed in Japanese Patent Application Laid-Open No. 8-250,402 is used as modified in the fourth embodiment. In the second embodiment, the technique is used where the target exposure light amount is multiplied by the variation portion of transmittance as the coefficient in the method for controlling the exposure light amount as disclosed in Japanese Patent Application Laid-Open No. 2-135,723 (U. S. Patent No. 5,191,374). The technique for multiplying the variation portion of the transmittance as a coefficient in this embodiment is substantially the same as that adopted in the fourth embodiment, only with the exception that the actual coefficient is different. Therefore, an explanation will be omitted hereinafter.

Turning back to Fig. 26, the fifth embodiment of the present invention is different from the fourth embodiment in the configuration of the reticle blind. In the fifth embodiment, the reticle blind 237 is identical to the fourth embodiment in that it is disposed at the position conjugated with the pattern-forming plane of the reticle R between the condenser lens system 226 and the relay optical system 230. The reticle blind 237 in the fifth embodiment, however, is different from that in the fourth embodiment in that the former has four movable edges to define the illumination region, in place of the movable blind 228A and the fixed blind 228B in the fourth embodiment. The configuration of the reticle blind is disclosed, for example, in Japanese Patent Application Laid-Open No. 2-116,115.

Further, as the planar position detection unit 274 in the fourth embodiment of the present invention, there is used the one disclosed in Japanese Patent Application Laid-Open No. 6-260,391 or 6-283,403. In the fifth embodiment of the present invention, as the planar position detection unit 275, there is used the one as disclosed, for example, in Japanese Patent Application Laid-Open No. 5-275,313 (U. S. Patent No. 5,502,311) or Japanese Patent Application Laid-Open No. 7-142,324 (U. S. Patent No. 5,602,359).

Moreover, in the fourth embodiment of the present invention, the opening portion of the reticle stage 240 is superimposed over the illumination region IA upon measuring the actual distribution of illuminance at the predetermined time interval and modifying the correction amount to be computed by the history table or the functions f(t) and g(t). In the fifth embodiment, on the other hand, the technique can be used such that the actual distribution of illuminance is measured in such a state that the reticle R is detached from the reticle stage 280 or the actual distribution of illuminance is measured in such a state that the reticle R is stayed disposed thereon, and the measured value is compared with information saved in the memory 210 relating to an ideal distribution of illuminance by the light through the reticle R.

In the fifth embodiment of the present invention, too, one opening portion may be disposed on the light receipt section 254B, in place of the plural opening portions 254B1 (the plural points for measurement), and the measurement can be repeated while transferring the light receipt section 254B in the X-Y direction. Furthermore, the results of the simultaneous measurement for the plural opening portions 254B1 can be calibrated on the basis of the result of measurement for the distribution of illuminance by the particular one out of the plural opening portions 254B1.

In addition, each of the elements as used in from the first embodiment to the fifth embodiment, inclusive, can be associated in an electrical, mechanical or optical way to integrate the projection exposure apparatus according to the present invention.

**Claims**

**1.** An exposure light amount control method for controlling an exposure light amount on a substrate by illuminating a pattern on a mask and projecting and exposing an image of the pattern through a projection optical system;
characterized by the step of:

computing the exposure light amount on the substrate on the basis of a variation in an attenuation factor of a light amount of the light passing through the projection optical system.

**2.** An exposure light amount control method for controlling an exposure light amount on a substrate for a pattern on a mask upon illuminating the pattern on the mask and projecting and exposing an image of the pattern through a projection optical system;
characterized by the step of:

computing the exposure light amount on the substrate on the basis of a variation in a transmittance with respect to an incident light amount incident to the projection optical system.

**3.** The exposure light amount control method as claimed in claim 1 or 2, further characterized by the step of:

comparing the exposure light amount with a predetermined exposure light amount.

**4.** The exposure light amount control method as claimed in claim 1 or 2, wherein an illumination light for illuminating the mask has a wavelength of 250 nm or less.

**5.** The exposure light amount control method as claimed in claim 2, further characterized by the steps of:

measuring a variation in transmittance with respect to the incident light amount incident to the projection optical system; and
saving the variation in transmittance.

**6.** An exposure light amount control method for controlling an exposure light amount on a substrate upon illuminating a mask with a pulse light and projecting and exposing a pattern on the mask onto the substrate through a projection optical system by scanning the mask and the substrate in synchronism with each other;
characterized by the step of:

computing the exposure light amount on the substrate on the basis of a variation in an attenuation factor of a light amount passing through the projection optical system.

**7.** An exposure light amount control method for controlling an exposure light amount on a substrate upon illuminating a mask with a pulse light and projecting and exposing a pattern on the mask onto the substrate through a projection optical system by scanning the mask and the substrate in synchronism with each other;
characterized by the step of:

computing the exposure light amount on the substrate on the basis of a variation in a transmittance with respect to an incident light amount incident to the projection optical system.

**8.** The exposure control method as claimed in claim 6 or 7, further characterized by the step:

controlling the exposure light amount on the substrate by varying at least one of a relative scanning velocity of the mask and the substrate, a timing of emitting the pulse light, an intensity of the pulse light, and a magnitude of the relative scanning direction of the pulse light.

**9.** An exposure method for illuminating a pattern on a mask and projecting an image of the pattern onto a substrate through a projection optical system; characterized by the steps of:

computing an exposure light amount on the substrate on the basis of a variation in an attenuation factor of a light amount of the light passing through the projection optical system; and
accumulating the exposure light amount and terminating the exposure as the accumulated exposure light amount reaches a predetermined exposure light amount.

**10.** An exposure method for illuminating a pattern on a mask and projecting an image of the pattern onto a substrate through a projection optical system; characterized by the steps of:

computing an exposure light amount on the substrate on the basis of a variation in a transmittance of the projection optical system; and
accumulating the exposure light amount and terminating the exposure as the accumulated exposure light amount reaches a predetermined exposure light amount.

**11.** An exposure light amount control apparatus for controlling an exposure light amount for projecting and exposing a pattern on a mask onto a substrate through a projection optical system, comprising:

a memory section which saves a variation in an attenuation factor of a light amount of the projection optical system; and
a control unit which computes an exposure light amount on the substrate on the basis of the variation in the attenuation factor saved.

**12.** An exposure light amount control apparatus for controlling an exposure light amount for projecting and exposing a pattern on a mask onto a substrate through a projection optical system, comprising:

a memory section which saves a variation in a transmittance of the projection optical system; and
a control unit which computes an exposure light amount on the substrate on the basis of the variation in the transmittance saved.

**13.** An exposure apparatus for projecting and exposing a pattern on a mask onto a substrate through a projection optical system, comprising:

a memory section which saves a variation in an attenuation factor of a light amount of the projection optical system;
a device which measures an incident light amount of light incident to the projection optical system; and
a control unit which computes an exposure light amount on the substrate on the basis of the variation in the attenuation factor saved and the incident light amount measured.

**14.** An exposure apparatus for projecting and exposing a pattern on a mask onto a substrate through a projection optical system, comprising:

a memory section which saves a variation in a transmittance of the projection optical system;
a device which measures an incident light amount of light incident to the projection optical system; and
a control unit which computes an exposure light amount on the substrate on the basis of the variation in the transmittance saved and the incident light amount measured.

**15.** An exposure method for illuminating a pattern on a mask and projecting an image of the pattern onto a substrate through a projection optical system; characterized by the steps of:

entering an illumination light into the projection optical system prior to exposure; and
computing an exposure light amount on the substrate on the basis of an attenuation factor of the projection optical system after entry of the illumination light.

**16.** An exposure method for illuminating a pattern on a mask and projecting an image of the pattern onto a substrate through a projection optical system; characterized by the steps of:

entering an illumination light into the projection optical system prior to exposure; and
computing an exposure light amount on the substrate on the basis of a transmittance of the projection optical system after entry of the illumination light.

**17.** The exposure method as claimed in claim 15, wherein:

the illumination light is incident to the projection optical system prior to exposure so as to make the attenuation factor of the projection optical system a predetermined value.

**18.** The exposure method as claimed in claim 16, wherein:

the illumination light is incident to the projection optical system prior to exposure so as to make the transmittance of the projection optical system a predetermined value.

**19.** An exposure method for illuminating a pattern on a mask with light having a wavelength of 250 nm or less and projecting an image of the pattern onto a substrate through a projection optical system; characterized by the steps of:

measuring an attenuation factor of the projection optical system at a predetermined timing; and
computing an exposure light amount on the substrate on the basis of the attenuation factor measured.

**20.** An exposure method for illuminating a pattern on a mask with light having a wavelength of 250 nm or less and projecting an image of the pattern onto a substrate through a projection optical system; characterized by the steps of:

measuring a transmittance of the projection optical system at a predetermined timing; and
computing an exposure light amount on the substrate on the basis of the transmittance measured.

**21.** An element manufacture method for manufacturing a circuit element, which is carried out by illuminating a pattern on a mask; and projecting an image of the pattern onto a substrate through a projection optical system; characterized by:

controlling an exposure light amount on the substrate on the basis of a variation in an attenuation factor of the projection optical system.

**22.** An element manufacture method for manufacturing a circuit element, which is carried out by illuminating a pattern on a mask; and projecting an image of the pattern onto a substrate through a projection optical system; characterized by:

controlling an exposure light amount on the substrate on the basis of a variation in a transmittance of the projection optical system.

**23.** A device manufacture method for manufacturing a device containing the step of illuminating a mask with an exposure light of an ultraviolet region through an illumination optical system and projecting a device pattern on the mask onto a substrate through a projection optical system; characterized by the steps of:

deciding whether an attenuation factor varies from at least one of a light amount of the illumination optical system and a light amount of the projection optical system (the first step);
irradiating at least the projection optical system with the exposure light for a predetermined period of time, when it is decided in the first step that the attenuation factor varies (the second step); and
projecting the device pattern onto the substrate after the second step (the third step).

**24.** A device manufacture method for manufacturing a device containing the step of illuminating a mask with an exposure light of an ultraviolet region through an illumination optical system and projecting a device pattern on the mask onto a substrate through a projection optical system; characterized by the steps of:

deciding whether a transmittance of the illumination optical system and the projection optical system varies (the first step);
irradiating the projection optical system with the exposure light for a predetermined period of time, when it is decided in the first step that the transmittance varies (the second step); and
projecting the device pattern onto the substrate after the second step (the third step).

**25.** The device manufacture method as claimed in claim 24, wherein in the first step, it is decided that the transmittance varies upon changing an illumination condition for the mask.

**26.** The device manufacture method as claimed in claim 24, wherein in the first step, it is decided that the transmittance varies upon exchanging a different kind of a mask for the mask.

**27.** The device manufacture method as claimed in claim 24, wherein in the first step, it is decided that the transmittance varies when a period of time during which the exposure light fails to pass through the projection optical system and the illumination optical system exceeds a predetermined period of time.

**28.** The device manufacture method as claimed in claim 24, wherein in the first step, it is decided that the transmittance varies when a period of time during which an air conditioning device for controlling a state of an atmosphere around the illumination optical system and the projection optical system is suspended exceeds a predetermined period of time.

**29.** The device manufacture method as claimed in claim 24, wherein in the first step, it is decided that the transmittance varies when a state of an atmosphere around at least one of the illumination optical system and the projection optical system changes.

**30.** The device manufacture method as claimed in claim 24, wherein in the first step, it is decided that the transmittance varies, on the basis of a result of an output from a device for detecting pollution of at least one of the illumination optical system and the projection optical system.

**31.** The device manufacture method as claimed in any one of claims 24 to 30, wherein an error display is conducted when it is decided in the first step that the transmittance varies.

**32.** The device manufacture method as claimed in any one of claims 24 to 30, wherein an irradiation time of the exposure light is adjusted in accordance with a factor of an variation in the transmittance in the second step.

**33.** A projection exposure apparatus for effecting an actual exposure by illuminating a mask by an illumination optical system supplying an exposure light of an ultraviolet region and projecting a device pattern on the mask onto a substrate through a projection optical system; comprising:

a control unit which decides to determine whether an attenuation factor of a light amount from the illumination optical system and the projection optical system varies; and controls the illumination optical system so as to irradiate the illumination optical system and the projection optical system with the exposure light for a predetermined period of time prior to the actual exposure, when it is decided that the attenuation factor varies.

**34.** A projection exposure apparatus for effecting an actual exposure by illuminating a mask by an illumination optical system supplying an exposure light of an ultraviolet region and projecting a device pattern on the mask onto a substrate through a projection optical system; comprising:

a control unit which decides to determine whether a transmittance of the illumination optical system and the projection optical system varies; and controls the illumination optical system so as to irradiate the illumination optical system and the projection optical system with the exposure light for a predetermined period of time prior to the actual exposure, when it is decided that the transmittance varies.

**35.** The projection exposure apparatus as claimed in claim 34, further comprising:

a detection device which detects a state of an illumination condition for the mask;
wherein the control unit decides that the transmittance varies on the basis of an output from the detection device.

**36.** The projection exposure apparatus as claimed in claim 34, further comprising:

a detection device which detects a kind of the mask;
wherein the control unit decides that the transmittance varies on the basis of an output from the detection device.

**37.** The projection exposure apparatus as claimed in claim 34, further comprising:

a timer device which measures a time during which the exposure light fails to pass through the projection optical system and the illumination optical system;
wherein the control unit decides that the transmittance varies on the basis of an output from the timer device.

**38.** The projection exposure apparatus as claimed in claim 34, further comprising:

an air conditioning device which controls a state of an atmosphere in the projection exposure apparatus;
wherein the control unit decides that the transmittance varies on the basis of information relating to an operation and a suspension of the operation of the air conditioning device.

**39.** The projection exposure apparatus as claimed in claim 34, further comprising:

a cover which separates an atmosphere around at least one of the illumination optical system and the projection optical system from an outside atmosphere;
wherein the control unit decides that the transmittance varies on the basis of information relating to opening and closing of the operation of the cover.

**40.** The projection exposure apparatus as claimed in claim 34, further comprising:

a pollution detection device which detects pollution of at least one of the illumination optical system and the projection optical system;
wherein the control unit decides that the transmittance varies on the basis of an output from the pollution detection device.

**41.** The projection exposure apparatus as claimed in any one of claims 34 to 40, wherein the control unit adjusts an irradiation time of the exposure light in accordance with a factor of a variation in transmittance.

**42.** A projection exposure method for transcribing a device pattern on a mask onto a substrate by means of a projection exposure apparatus as claimed in any one of claims 33 to 41.

**43.** A projection exposure apparatus for leading an exposure light having a wavelength of an ultraviolet region to a pattern on a mask through an illumination optical system and forming an image of the pattern on the mask within an exposure region on a substrate through a projection optical system: comprising:

a memory device which saves information relating to a variation in an attenuation factor of a light amount of an exposure light, which results from passage of the exposure light through the illumination optical system and the projection optical system;
wherein a distribution of illuminance in the exposure region is maintained at a constant level on the basis of information from the memory device.

**44.** A projection exposure apparatus for leading an exposure light having a wavelength of an ultraviolet region to a pattern on a mask through an illumination optical system and forming an image of the pattern on the mask within an exposure region on a substrate through a projection optical system; comprising:

a memory device which saves information relating to a variation in a transmittance, which results from passage of the exposure light through the illumination optical system and the projection optical system;
wherein a distribution of illuminance in the exposure region is maintained at a constant level on the basis of information from the memory device.

**45.** A projection exposure apparatus having:

a light source for generating an exposure light having a wavelength of an ultraviolet region;
an illumination optical system for leading the exposure light from the light source to a pattern on a mask; and
a projection optical system for forming an image of the pattern on the mask into a predetermined exposure region on a substrate through a projection optical system; characterized by:
a memory device which saves information relating to a variation in a transmittance, which results from passage of the exposure light from the light source through the illumination optical system and the projection optical system;
an illuminance distribution adjustment device which adjusts a distribution of illuminance in the exposure region; and
a control unit which controls the illuminance distribution adjustment device so as to maintain the distribution of illuminance in the exposure region at a constant level on the basis of information from the memory device.

**46.** The projection exposure apparatus as claimed in claim 45, wherein the illuminance distribution adjustment device comprises a condenser lens system and a condenser lens system drive unit which drives the condenser lens system; the condenser lens system being disposed in the illumination optical system and having at least one of a lens element arranged so as to be movable along a light axis and a lens element arranged so as to be rotatable about one point on the light axis.

**47.** The projection exposure apparatus as claimed in claim 45, further comprising:

a measuring device which measures the distribution of illuminance within the exposure region;
wherein the control unit controls the illuminance distribution adjustment device on the basis of information from the measuring device obtained by modifying at least a portion of information from the memory device on the basis of information modified.

**48.** The projection exposure apparatus as claimed in claim 45, wherein the measuring device comprises a member having a pinhole disposed in the exposure region; an optical fiber leading light received through the pinhole and having a transmittance for the exposure light; and a photoelectrical conversion element which detects light from the optical fiber and converts the light into an electrical signal.

**49.** The projection exposure apparatus as claimed in claim 47, wherein modification on the basis of the information from the measuring device is conducted at a predetermined number of times per unit time, and the predetermined number of times is determined in accordance with a magnitude of an amount of a variation in the distribution of transmittance per unit time, saved in the memory device.

**50.** The projection exposure apparatus as claimed in any one of claims 45 to 49, wherein information about the variation in the distribution of transmittance saved in the memory device is saved in association with at least one of a time during which the exposure light passes through the illumination optical system and the projection optical system, an illumination condition for illuminating the mask, a kind of the mask, an optical characteristic of the projection optical system, and a light amount reflected at the substrate and returning to the projection optical system.

**51.** A projection exposure apparatus for leading an exposure light having a wavelength of an ultraviolet region to a pattern on a mask through an illumination optical system and forming an image of the pattern on the mask in a predetermined exposure region on a substrate through a projection optical system; comprising:

a measuring device which measures a distribution of illuminance in the exposure region by the exposure light through the mask;
a memory device which saves information relating to the distribution of illuminance in the exposure region by the exposure light through the mask, when the illumination optical system and the projection optical system are each in a predetermined initial state;
an illuminance distribution adjustment device which adjusts the distribution of illuminance in the exposure region; and
a control unit which controls the illuminance distribution adjustment device so as to maintain the distribution of illuminance in the exposure region at a constant level on the basis of a result of measurement by the measuring device and the information saved in the memory device.

**52.** The projection exposure apparatus as claimed in claim 51, wherein the information relating to the distribution of illuminance in the exposure region relates to the distribution of illuminance in the exposure region in a state in which a distribution of transmittance of the mask is uniform.

**53.** A projection exposure method for leading an exposure light having a wavelength of an ultraviolet region to a pattern on a mask through an illumination optical system and forming an image of the pattern on the mask in a predetermined exposure region on a substrate through a projection optical system; characterized by the step of:

adjusting the distribution of illuminance in the exposure region so as to maintain the distribution of illuminance in the exposure region at a constant level on the basis of information relating to a variation in an attenuation factor of an exposure light amount, which results from passage of the exposure light through the illumination optical system and the projection optical system.

**54.** A projection exposure method for leading an exposure light having a wavelength of an ultraviolet region to a pattern on a mask through an illumination optical system and forming an image of the pattern on the mask in a predetermined exposure region on a substrate through a projection optical system; characterized by the step of:

adjusting the distribution of illuminance in the exposure region so as to maintain the distribution of illuminance in the exposure region at a constant level on the basis of information relating to a variation in a transmittance, which results from passage of the exposure light from the light source through the illumination optical System and the projection optical system.

**55.** The projection exposure method as claimed in claim 54, further characterized by the steps of:

measuring a distribution of illuminance in the exposure region; and
modifying at least a portion of information relating to a variation in the distribution of transmittance on the basis of information relating to the distribution of illuminance measured at the illuminance distribution measurement step.

**56.** The projection exposure method as claimed in claim 55, wherein:

the modification step is conducted at a predetermined number of times per unit time; and
the predetermined number of times is determined in accordance with a magnitude of an amount of the variation in the distribution of transmittance per unit time.

**57.** A projection exposure method for leading an exposure light having a wavelength of an ultraviolet region to a pattern on a mask through an illumination optical system and forming an image of the pattern on the mask in a predetermined exposure region on a substrate through a projection optical system; characterized by the steps of:

measuring the distribution of illuminance in the exposure region by the exposure light through the mask;
saving information relating to the distribution of illuminance in the exposure region by the exposure light through the mask, when the illumination optical system and the projection optical system are each in a predetermined initial state; and
adjusting the distribution of illuminance in the exposure region so as to maintain the distribution of illuminance in the exposure region at a constant level on the basis of information relating to the distribution of illuminance measured by the measuring step and information saved in the saving step.

**58.** The projection exposure method as claimed in claim 57, wherein the saving step is to save information relating to the distribution of illuminance in the exposure region in a state that the distribution of transmittance of the mask is uniform.

**59.** A projection exposure method for irradiating a mask with an exposure light having a wavelength of an ultraviolet region in a pulse form through an illumination optical system and conducting scanning exposure by scanning the mask and a substrate in synchronism with each other, and projecting a pattern on the mask onto the substrate through a projection optical system; wherein:

an exposure light amount irradiated so far by irradiating the mask with the exposure light in a pulse form during scanning exposure is accumulated at every irradiation to yield an accumulated exposure light amount; an average value of the accumulated exposure light amount and an average pulse energy are obtained therefrom; and a target accumulated exposure light amount is modified by taking a variation in a distribution in transmittance resulting from passage of the exposure light through at least the projection optical system into account, upon conducing the scanning exposure by controlling the accumulated exposure light amount so as to come closer to the target accumulated exposure light amount on the basis of the average value of the accumulated exposure light amount and the average pulse energy.

**60.** A projection exposure device for irradiating a mask with an exposure light having a wavelength of an ultraviolet region in a pulse form through an illumination optical system and conducting scanning exposure by scanning the mask and a substrate in synchronism with each other, and projecting a pattern on the mask onto the substrate through a projection optical system; comprising:

a memory device for saving information relating to a variation in a distribution of transmittance resulting from passage of the exposure light through the illumination optical system and the projection optical system;
wherein an exposure light amount irradiated so far by illuminating the mask with the exposure light in a pulse form during scanning exposure is accumulated at every irradiation to yield an accumulated exposure light amount; an average value of the accumulated exposure light amount and an average pulse energy are obtained therefrom; and a target accumulated exposure light amount is modified by multiplying the target accumulated exposure light amount by a variation in the distribution of transmittance as a coefficient, upon conducting the scanning exposure by controlling the accumulated exposure light amount so as to come closer to the target accumulated exposure light amount on the basis of the average value of the accumulated exposure light amount and the average pulse energy.

**61.** A device manufacture method containing the step of transcribing a device pattern on a mask onto a substrate by the projection exposure method as claimed in any one of claims 50 to 55.

FIG. 1

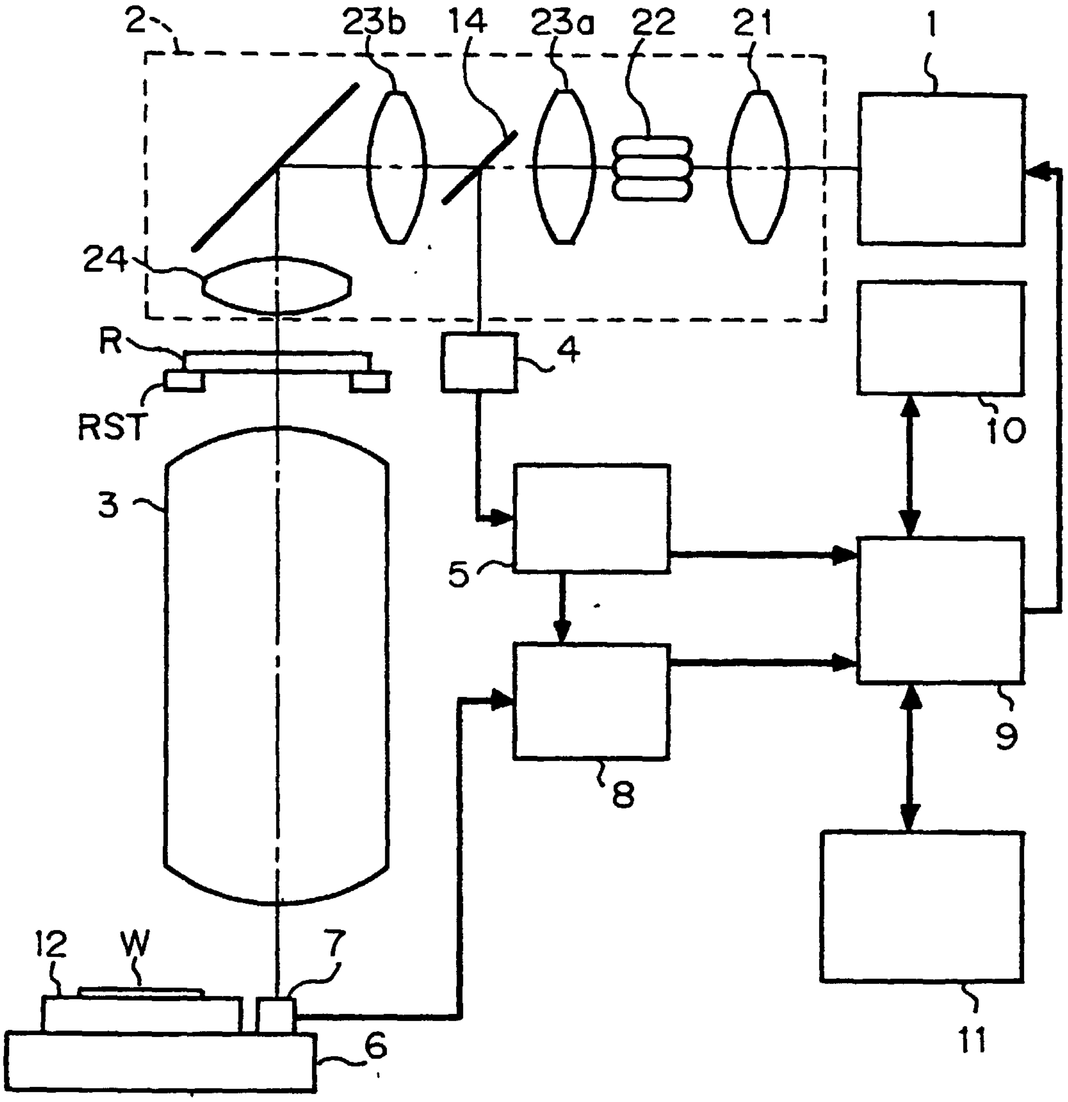

FIG. 2

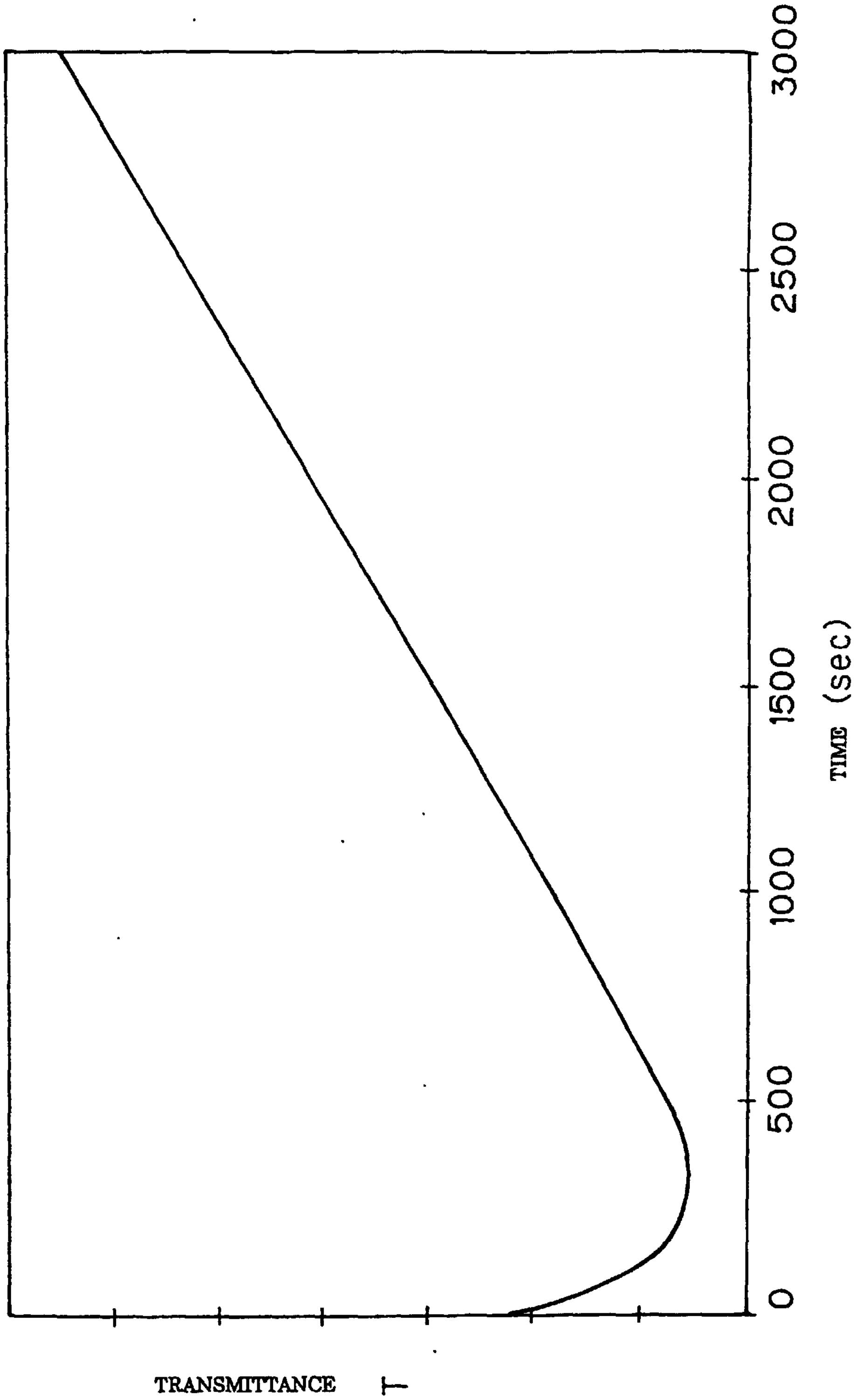

FIG. 3

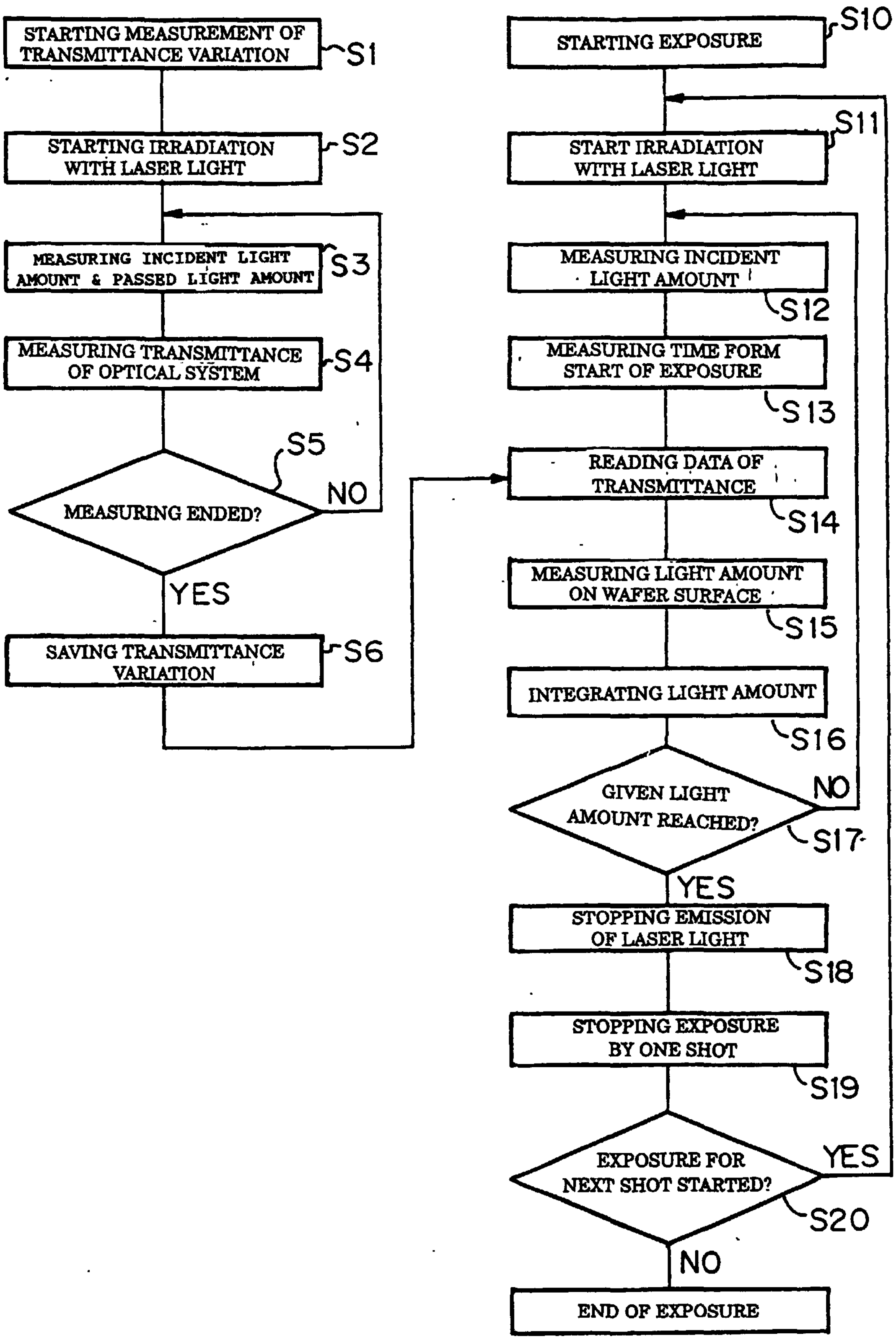
STARTING MEASUREMENT OF TRANSMITTANCE VARIATION
S1
STARTING IRRADIATION WITH LASER LIGHT
S2
MEASURING INCIDENT LIGHT AMOUNT & PASSED LIGHT AMOUNT
S3
MEASURING TRANSMITTANCE OF OPTICAL SYSTEM
S4
S5
MEASURING ENDED?
NO
YES
SAVING TRANSMITTANCE VARIATION
S6
STARTING EXPOSURE
S10
START IRRADIATION WITH LASER LIGHT
S11
MEASURING INCIDENT LIGHT AMOUNT
S12
MEASURING TIME FORM START OF EXPOSURE
S13
READING DATA OF TRANSMITTANCE
S14
MEASURING LIGHT AMOUNT ON WAFER SURFACE
S15
INTEGRATING LIGHT AMOUNT
S16
GIVEN LIGHT AMOUNT REACHED?
NO
S17
YES
STOPPING EMISSION OF LASER LIGHT
S18
STOPPING EXPOSURE BY ONE SHOT
S19
EXPOSURE FOR NEXT SHOT STARTED?
YES
S20
NO
END OF EXPOSURE

FIG. 4

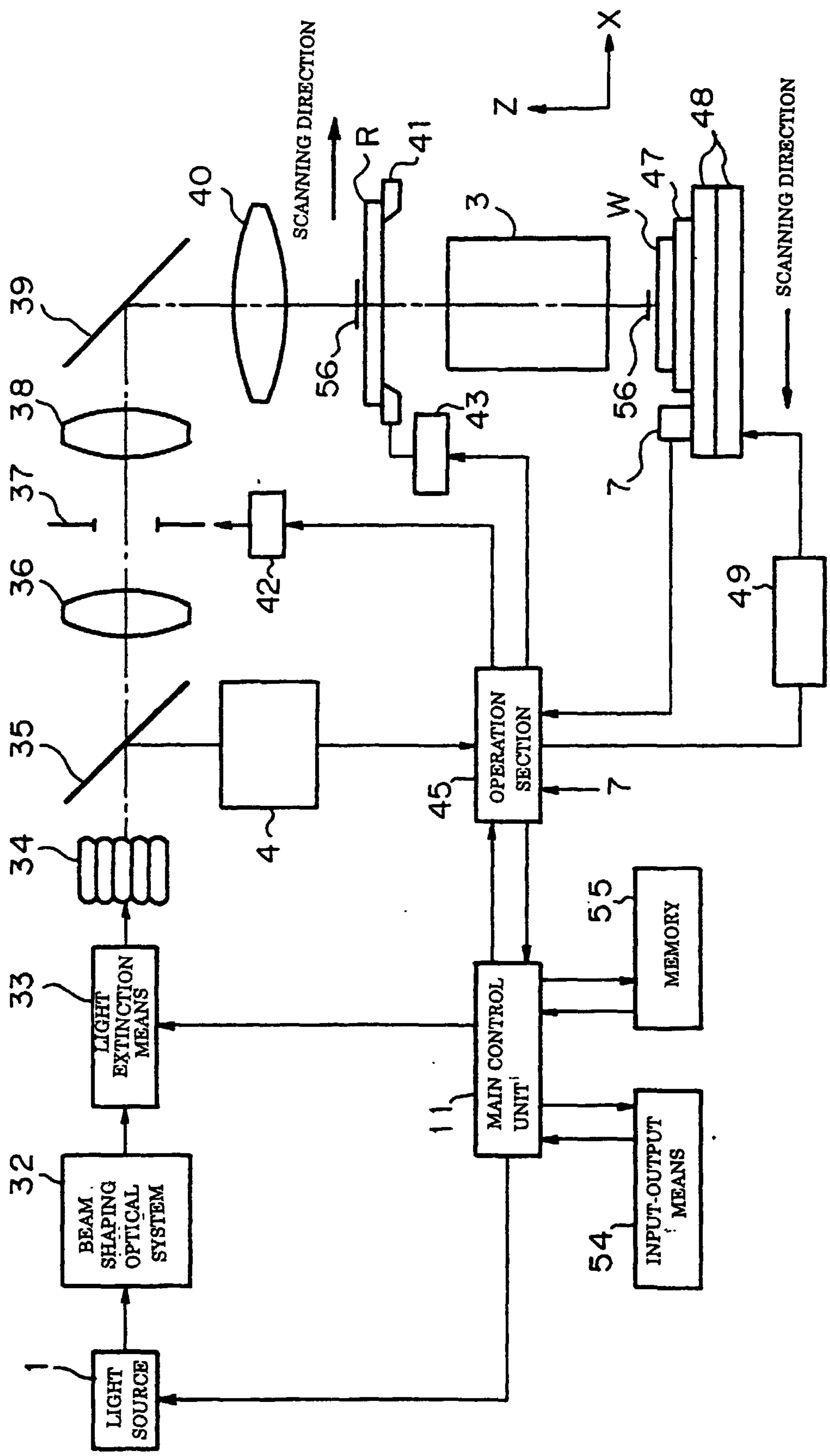
LIGHT SOURCE
BEAM SHAPING OPTICAL SYSTEM
LIGHT EXTINCTION MEANS
OPERATION SECTION
MAIN CONTROL UNIT
MEMORY
INPUT-OUTPUT MEANS
SCANNING DIRECTION
SCANNING DIRECTION
X
Z
R
W

FIG. 5

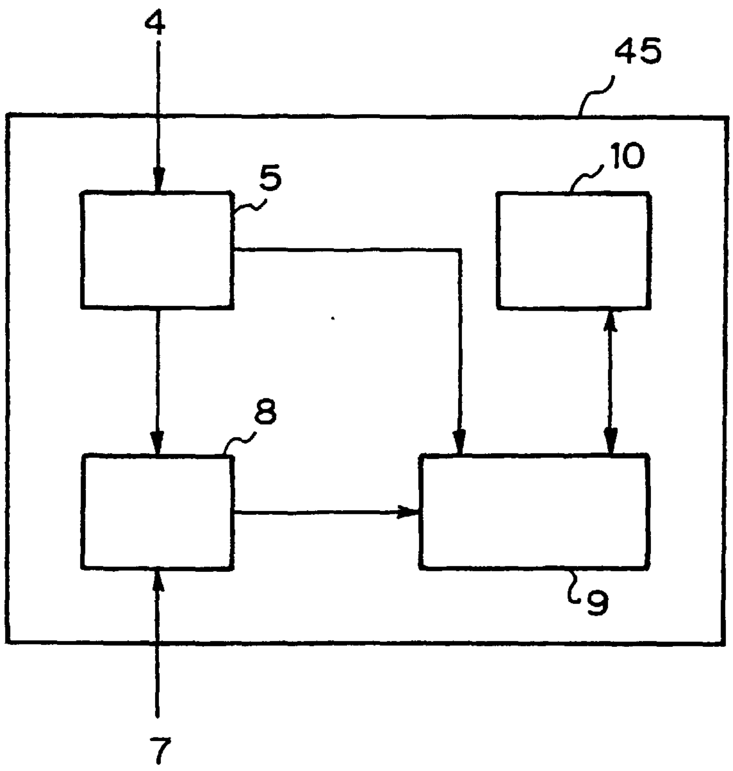

FIG. 6

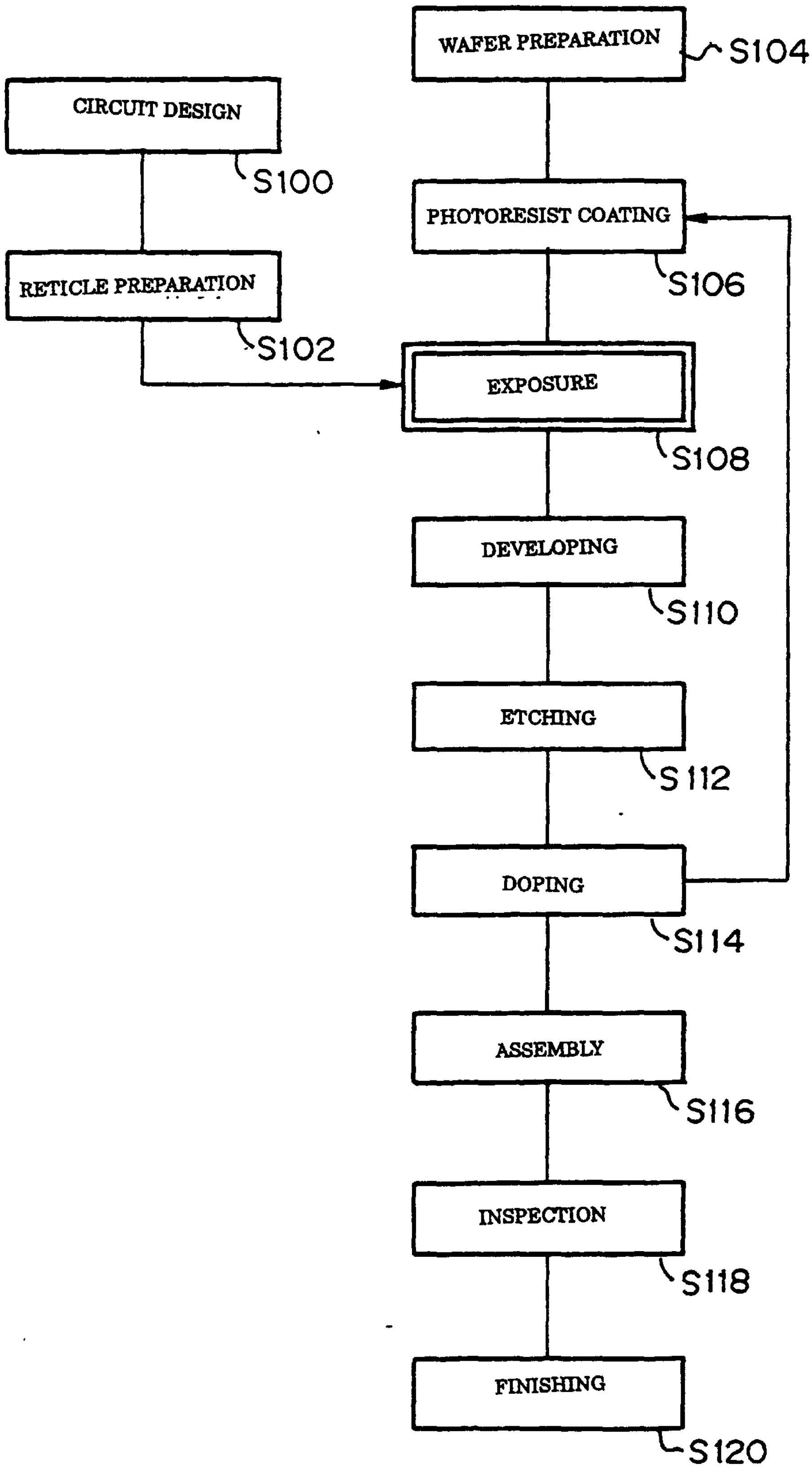
WAFER PREPARATION
S104
CIRCUIT DESIGN
S100
PHOTORESIST COATING
S106
RETICLE PREPARATION
S102
EXPOSURE
S108
DEVELOPING
S110
ETCHING
S112
DOPING
S114
ASSEMBLY
S116
INSPECTION
S118
FINISHING
S120

FIG. 7

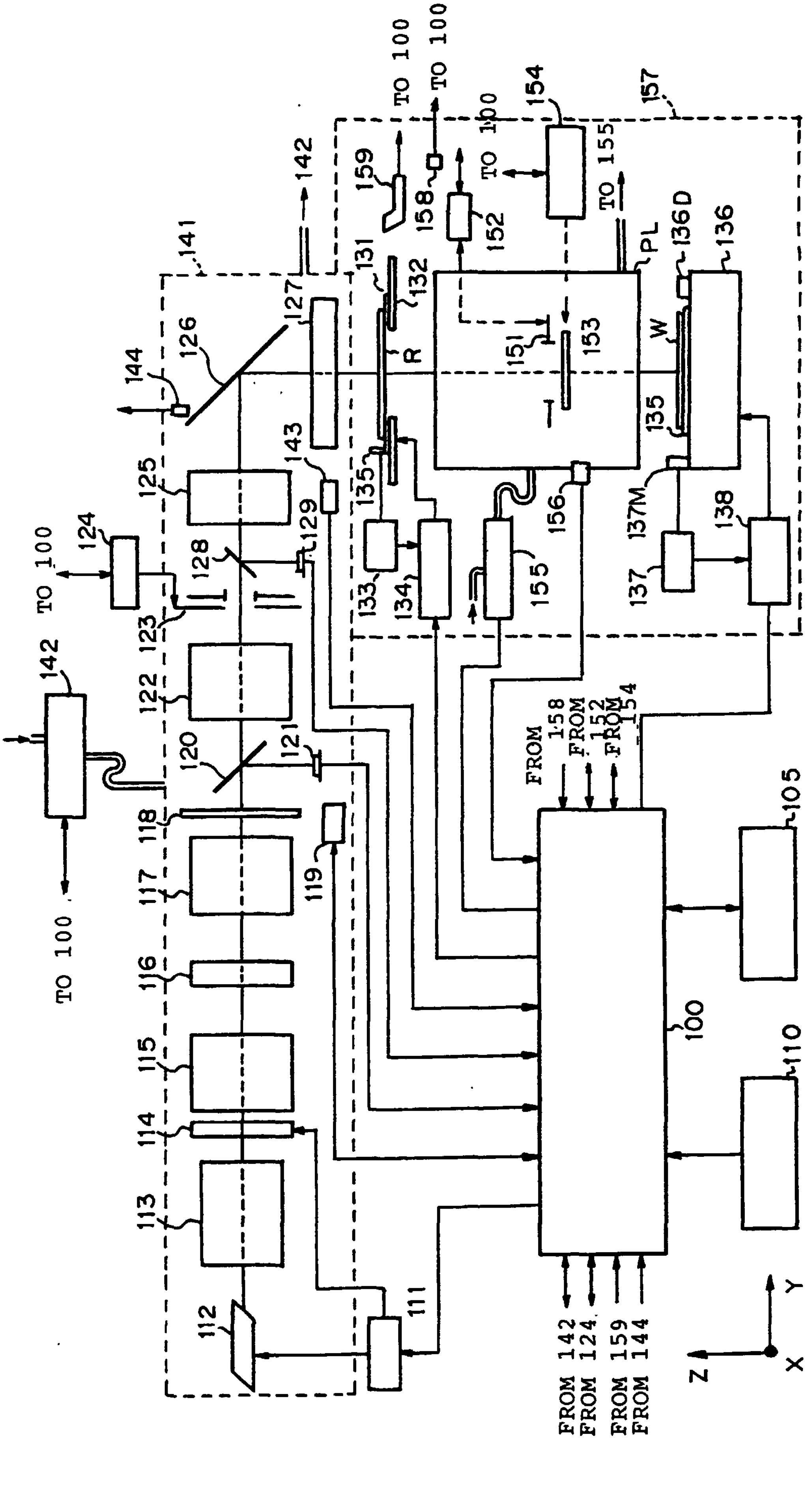
TO 100
142
TO 100
124
TO 100
TO 100
TO 100
154
157
159
158
152
TO 155
PL
136D
136
141
144
126
127
131
132
R
151
153
W
135
125
143
129
128
123
122
120
121
118
119
117
116
115
114
113
112
111
133
134
135
155
156
137M
137
138
FROM 158
FROM 152
FROM 154
105
100
110
FROM 142
FROM 124
FROM 159
FROM 144
Z
Y
X

FIG. 8

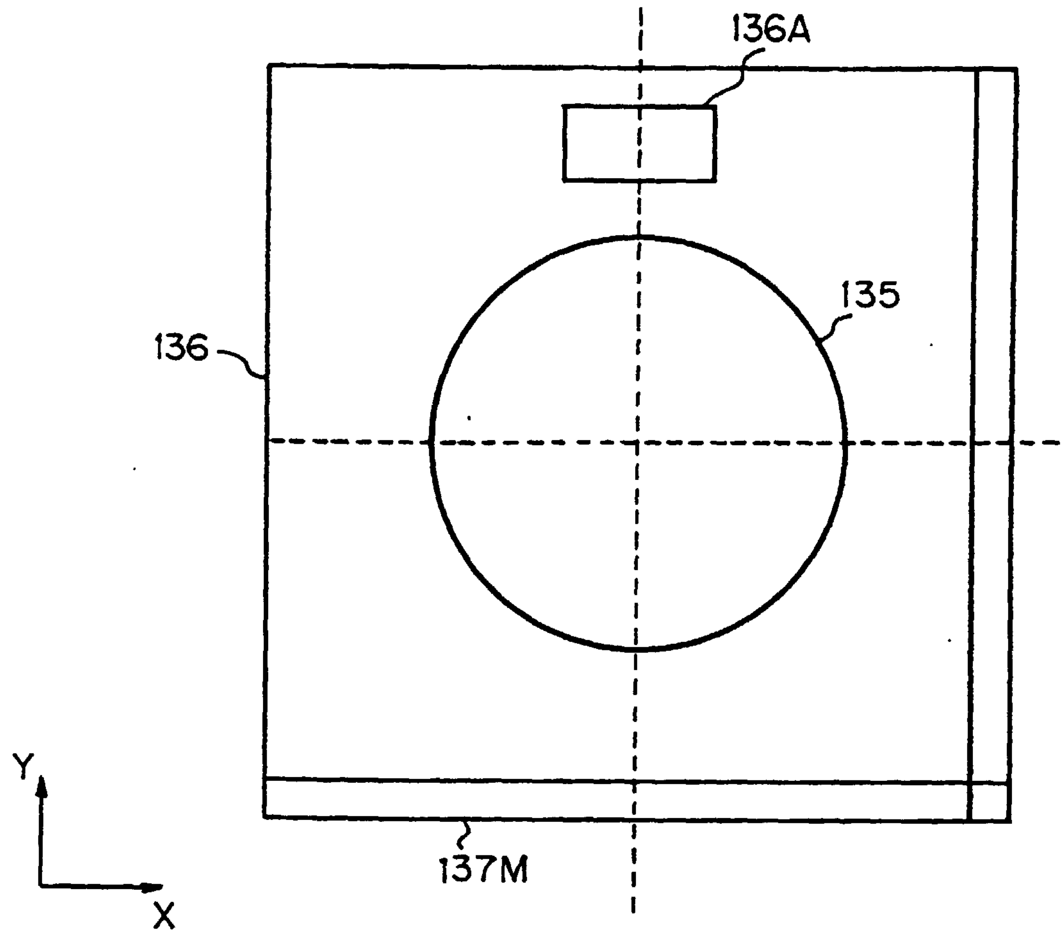


FIG. 9

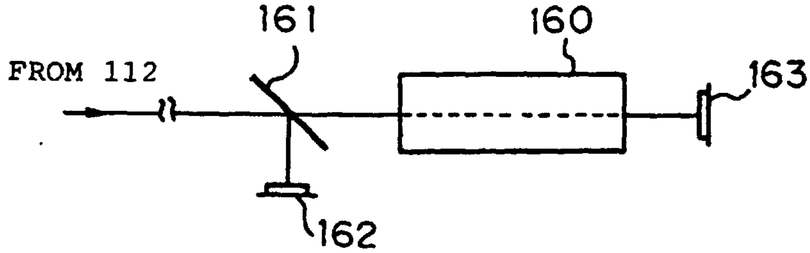

FIG. 10

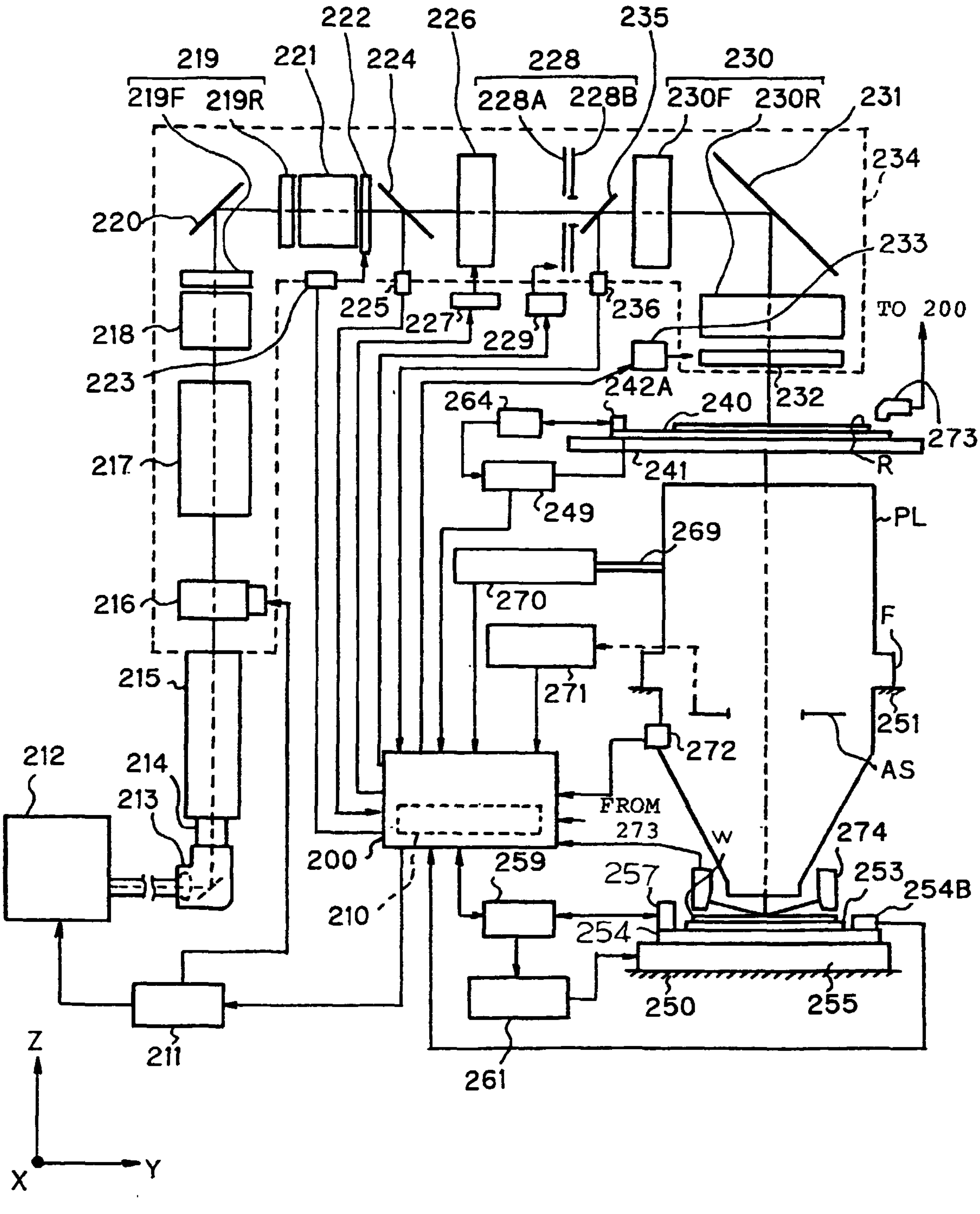
219
219F
219R
221
222
224
226
228
228A
228B
235
230
230F
230R
231
234
220
233
218
225
227
229
236
TO 200
223
242A
240
232
264
273
217
241
R
249
269
PL
270
216
F
271
251
215
212
214
272
AS
213
FROM
273
274
W
200
259
257
253
254B
210
254
250
255
211
261
Z
Y
X

FIG. 11

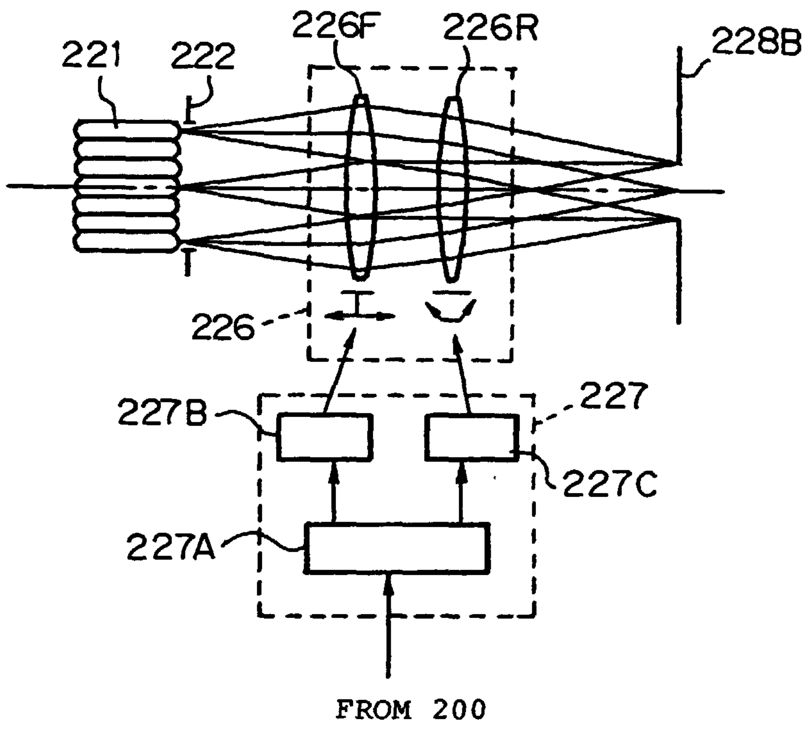

FIG. 12

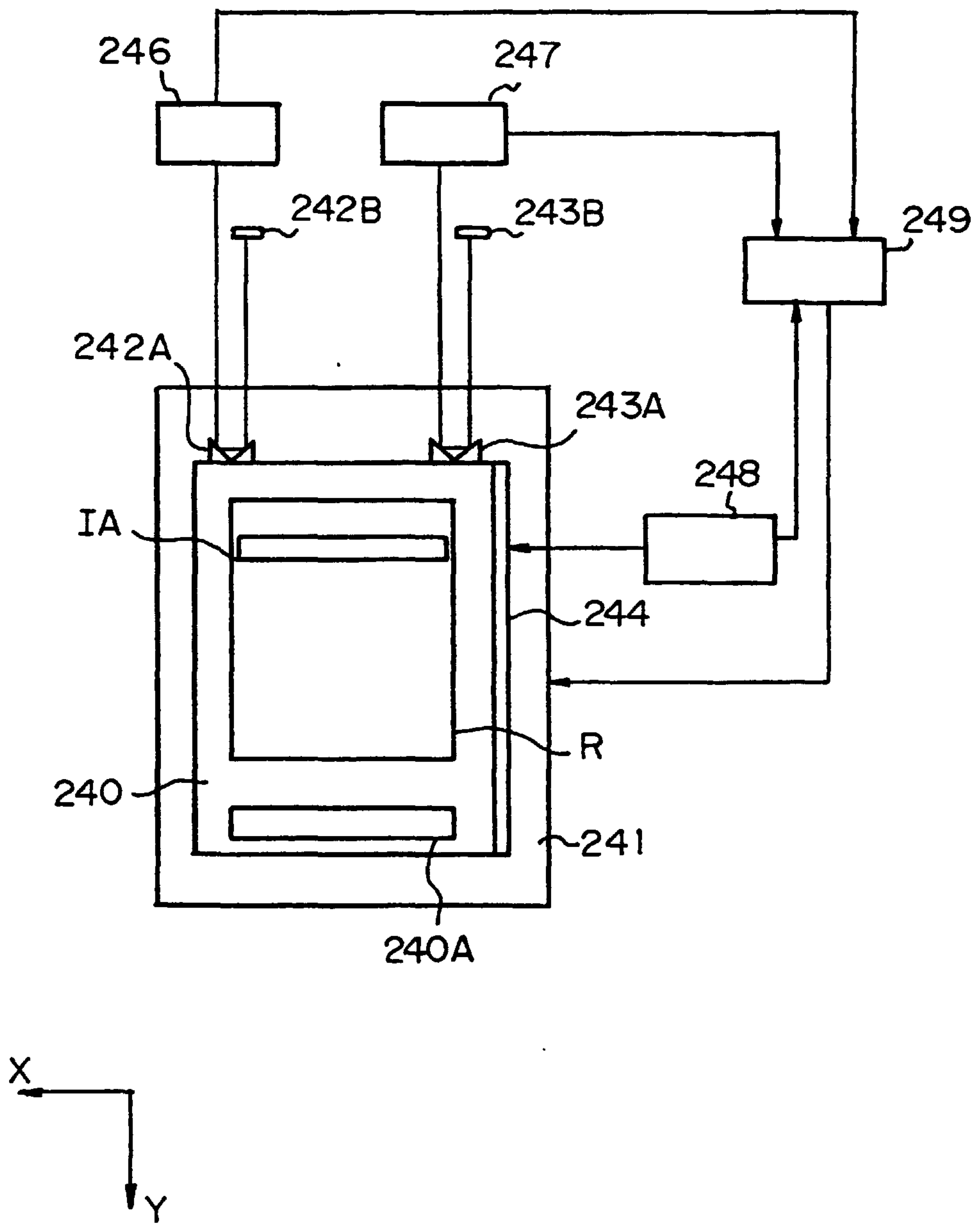

FIG. 13

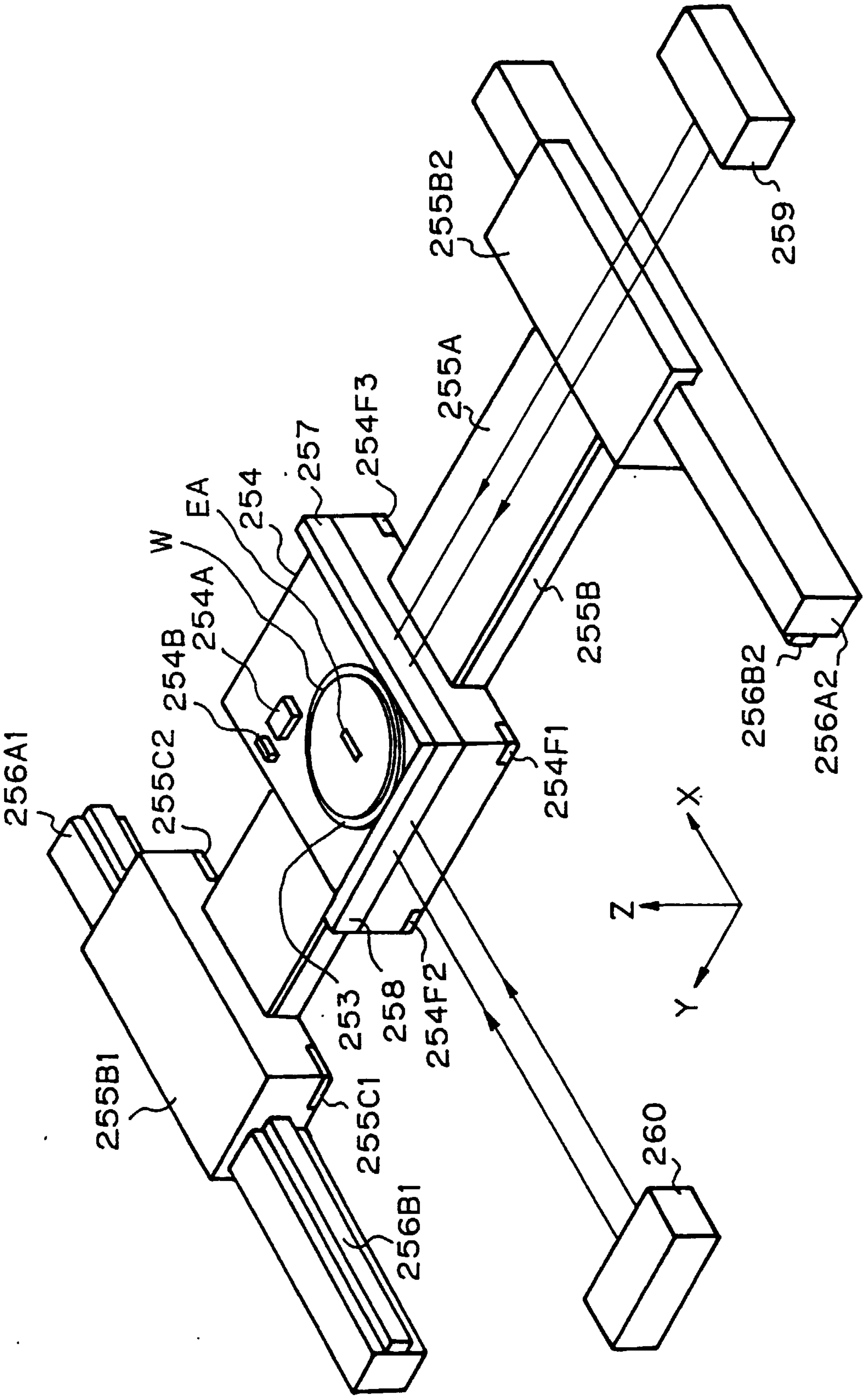

256A1
255C2
254B
254A
W
EA
254
257
254F3
255A
255B2
259
255B
256B2
256A2
254F1
X
Z
Y
253
258
254F2
255B1
255C1
256B1
260

FIG. 14

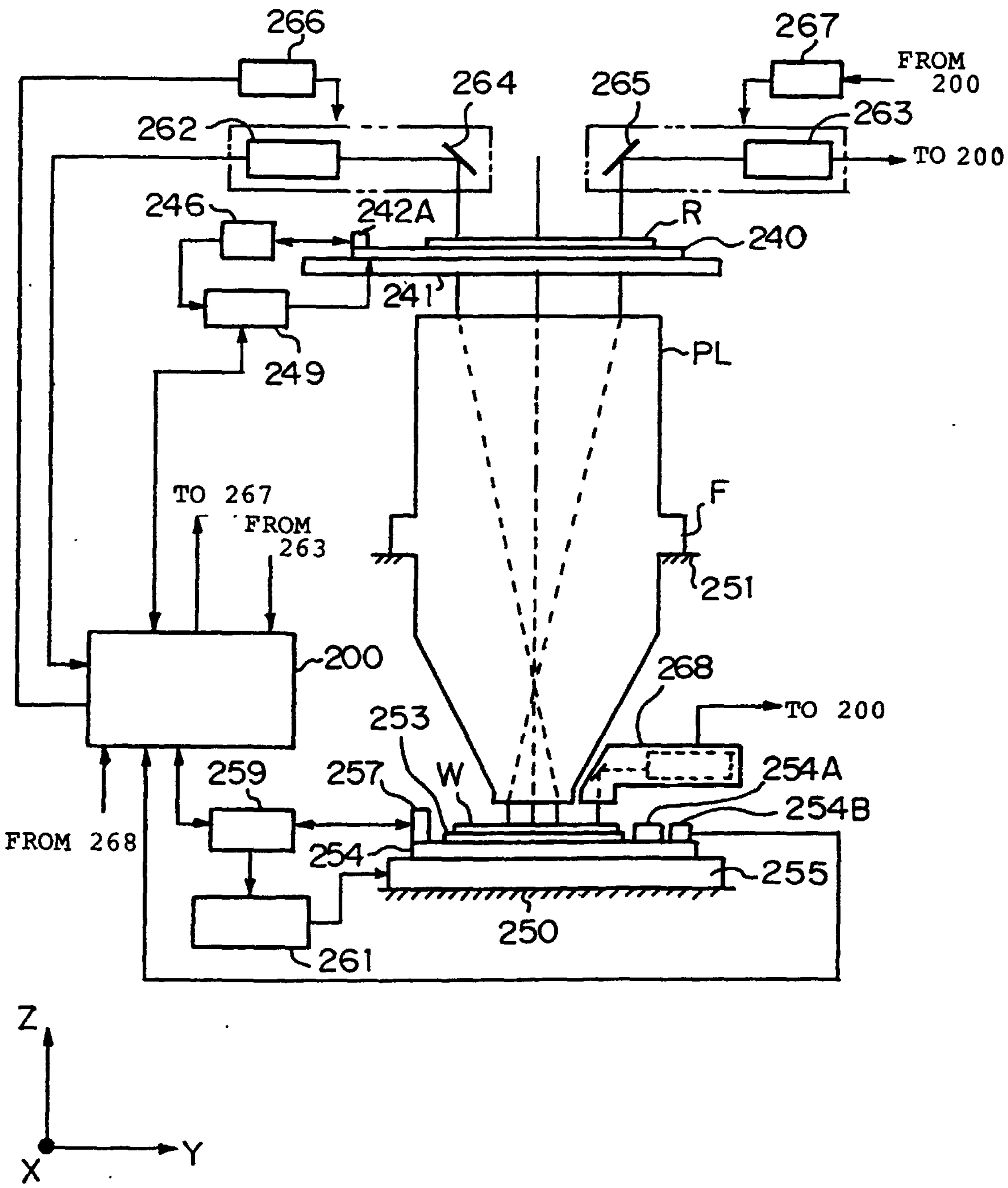

266
267
FROM 200
264
265
262
263
TO 200
246
242A
R
240
241
249
PL
TO 267
FROM 263
F
251
200
268
TO 200
253
259
257
W
254A
254B
FROM 268
254
255
250
261
Z
Y
X

FIG. 15

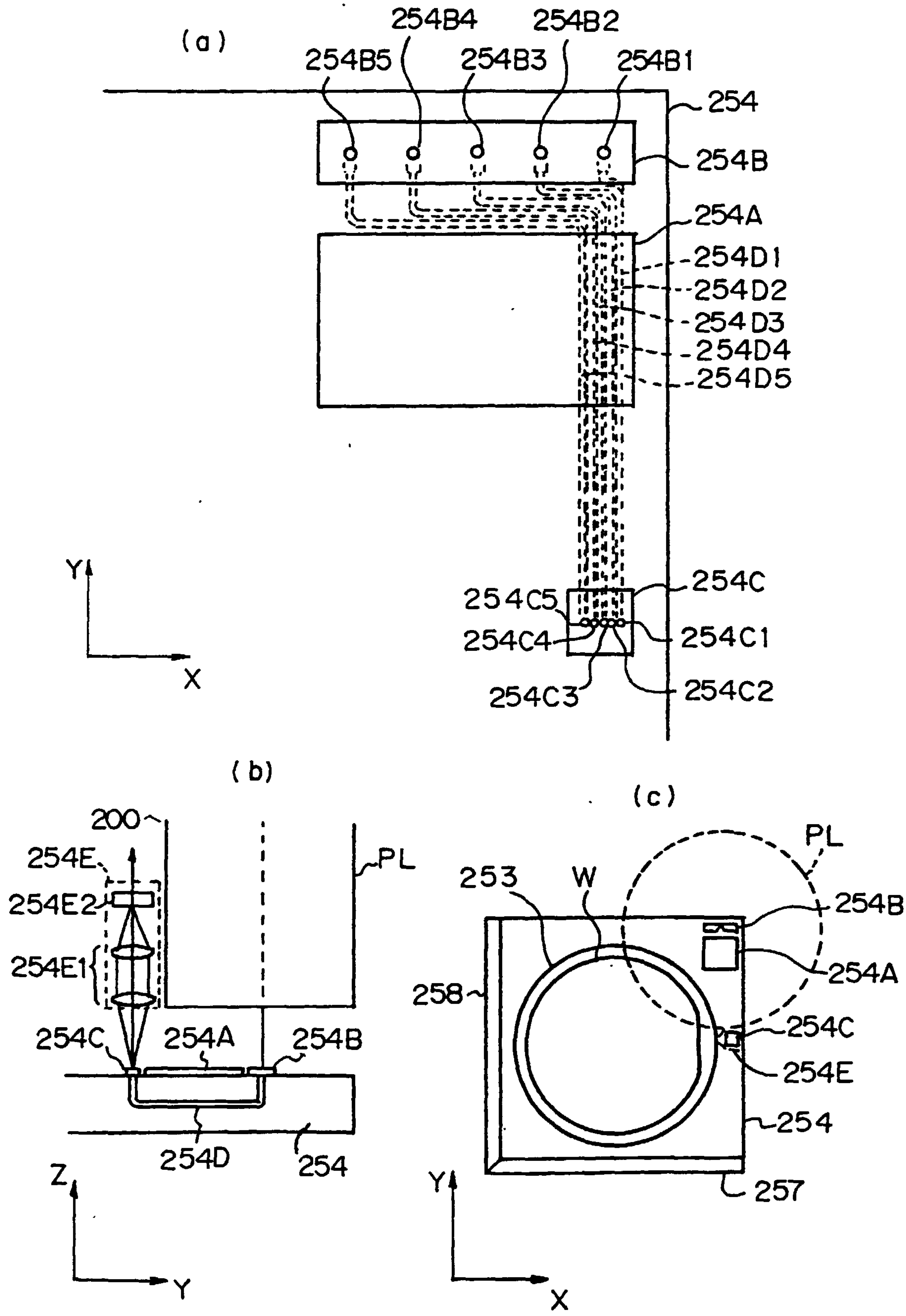
(a)
254B5
254B4
254B3
254B2
254B1
254
254B
254A
254D1
254D2
254D3
254D4
254D5
254C
254C5
254C4
254C1
254C3
254C2
Y
X
(b)
200
254E
254E2
254E1
254C
254A
254B
PL
254D
254
Z
Y
(c)
PL
253
W
254B
254A
258
254C
254E
254
257
Y
X

FIG. 16

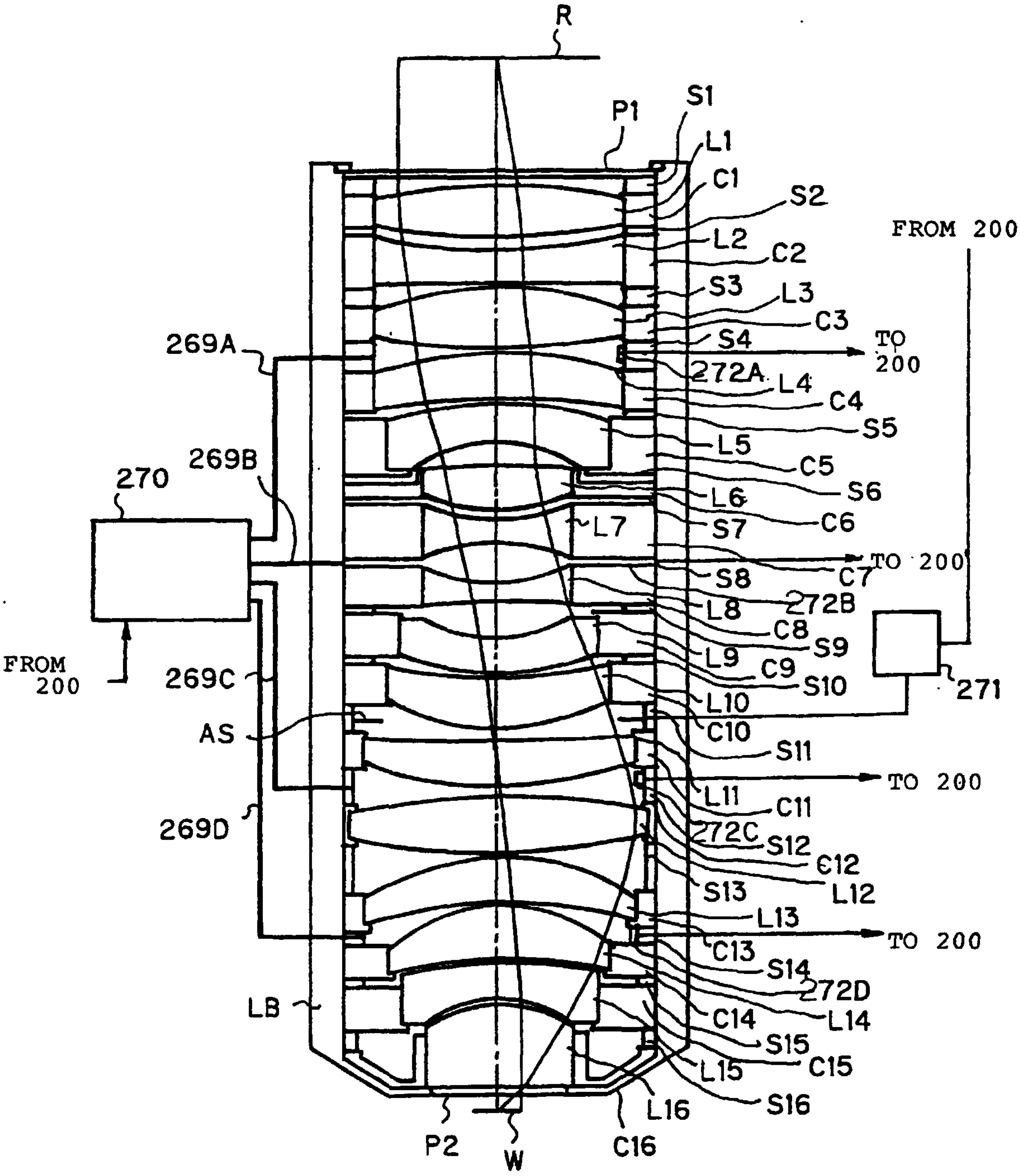
R
P1
S1
L1
C1
S2
L2
C2
S3
L3
C3
S4
272A
L4
C4
S5
L5
C5
S6
L6
S7
C6
L7
S8
C7
272B
L8
C8
S9
L9
C9
S10
L10
C10
S11
L11
C11
272C
S12
C12
S13
L12
L13
C13
S14
272D
C14
L14
S15
C15
L15
S16
L16
C16
P2
W
LB
AS
269A
269B
269C
269D
270
271
FROM 200
FROM 200
TO 200
TO 200
TO 200
TO 200

FIG. 17

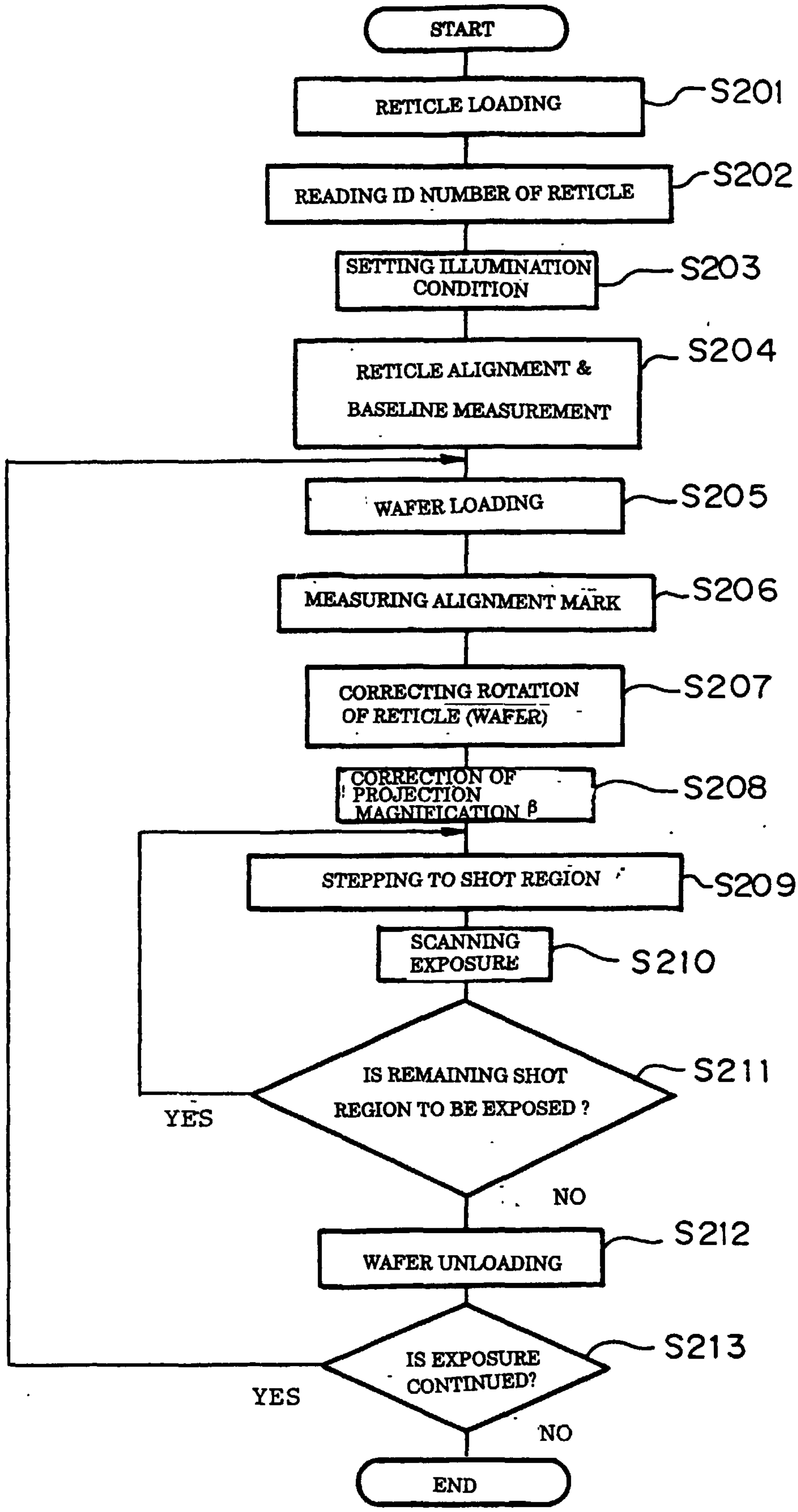
START
RETICLE LOADING
S201
READING ID NUMBER OF RETICLE
S202
SETTING ILLUMINATION CONDITION
S203
RETICLE ALIGNMENT & BASELINE MEASUREMENT
S204
WAFER LOADING
S205
MEASURING ALIGNMENT MARK
S206
CORRECTING ROTATION OF RETICLE (WAFER)
S207
CORRECTION OF PROJECTION MAGNIFICATION β
S208
STEPPING TO SHOT REGION
S209
SCANNING EXPOSURE
S210
IS REMAINING SHOT REGION TO BE EXPOSED ?
S211
YES
NO
WAFER UNLOADING
S212
IS EXPOSURE CONTINUED?
S213
YES
NO
END

FIG. 18

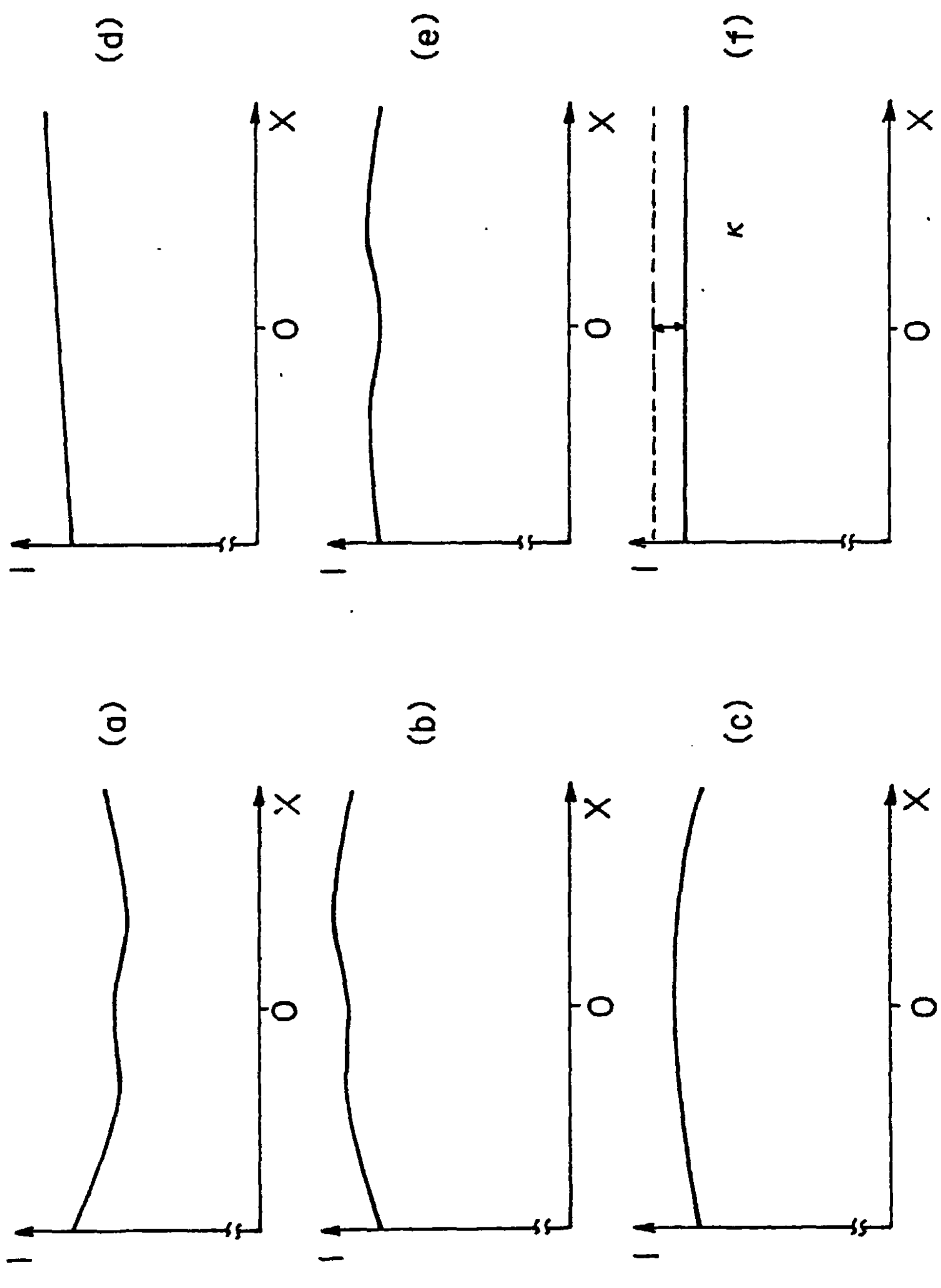

FIG. 19

| IRRADIATION TIME | 1 | 2 | 3 | … | … | … | … | … | … | … | … | … | … | K-1 | K |
|---|---|---|---|---|---|---|---|---|---|---|---|---|---|---|---|
| COEFFICIENT δ CORRESPONDING TO CORRECTION AMOUNT κ | 0.89 | 0.89 | 0.91 | … | … | … | … | … | … | … | … | … | … | 0.99 | 1.00 |
| CORRECTION AMOUNT Δ26F OF FRONT GROUP 226F | 0.36 | 0.38 | 0.38 | … | … | … | … | … | … | … | … | … | … | 0.52 | 0.53 |
| CORRECTION AMOUNT Δ26R OF REAR GROUP 226R(ρ) | 0.02 | 0.03 | 0.03 | … | … | … | … | … | … | … | … | … | … | 0.23 | 0.23 |
| CORRECTION AMOUNT Δ32 OF HIGHER-ORDER ILLUMINANCE IRREGULARITY ADJUSTMENT UNIT 232 | 0.02 | 0.03 | 0.02 | … | … | … | … | … | … | … | … | … | … | 0.11 | 0.11 |

FIG. 20

| IRRADIATION TIME | 1 | 2 | 3 | ... | ... | ... | ... | ... | ... | ... | ... | ... | ... | K-1 | K |
|---|---|---|---|---|---|---|---|---|---|---|---|---|---|---|---|
| COEFFICIENT δ CORRESPONDING TO CORRECTION AMOUNT κ | 0.99 | 0.98 | 0.98 | ... | ... | ... | ... | ... | ... | ... | ... | ... | ... | 0.41 | 0.41 |
| CORRECTION AMOUNT Δ26F OF FRONT GROUP 226F | 0.04 | 0.04 | 0.05 | ... | ... | ... | ... | ... | ... | ... | ... | ... | ... | 0.12 | 0.13 |
| CORRECTION AMOUNT Δ26R OF REAR GROUP 226R(*) | 0.02 | 0.02 | 0.03 | ... | ... | ... | ... | ... | ... | ... | ... | ... | ... | 0.11 | 0.11 |
| CORRECTION AMOUNT Δ32 OF HIGHER-ORDER ILLUMINANCE IRREGULARITY ADJUSTMENT UNIT 232 | 0.02 | 0.01 | 0.01 | ... | ... | ... | ... | ... | ... | ... | ... | ... | ... | 0.13 | 0.13 |

FIG. 21

| OUTPUT S25 OF INTGRATOR SENSOR 225 | ... | ... | ... | 20 | ... | ... | ... | ... | ... | ... | 80 | 81 | ... | ... | ... |
|---|---|---|---|---|---|---|---|---|---|---|---|---|---|---|---|
| COEFFICIENT ε FOR MODIFYING COEFFICIENT δ | ... | ... | ... | 2,33 | ... | ... | ... | ... | ... | ... | 1,21 | 1,20 | ... | ... | ... |
| COEFFICIENT ζ FOR MODIFYING CORRECTION AMOUNT OF FRONT GROUP 226F | ... | ... | ... | 1,52 | ... | ... | ... | ... | ... | ... | 1,33 | 1,33 | ... | ... | ... |
| COEFFICIENT η FOR MODIFYING CORRECTION AMOUNT (Φ) OF REAR GROUP 226R | ... | ... | ... | 1,32 | ... | ... | ... | ... | ... | ... | 1,15 | 1,14 | ... | ... | ... |
| COEFFICIENT ι FOR MODIFYING CORRECTION AMOUNT OF HIGHER-ORDER ILLUMINANCE IRREGULARITY ADJUSTMENT UNIT 232 | ... | ... | ... | 1,24 | ... | ... | ... | ... | ... | ... | 1,31 | 1,30 | ... | ... | ... |

FIG. 22

| | | | | | | | | | | | | | | | |
|---|---|---|---|---|---|---|---|---|---|---|---|---|---|---|---|
| OUTPUT S36 OF REFLECTANCE SENSOR 236 | --- | --- | --- | 25 | --- | --- | --- | --- | --- | --- | 53 | 54 | --- | --- | --- |
| COEFFICIENT ξ FOR MODIFYING COEFFICIENT δ | --- | --- | --- | 3,21 | --- | --- | --- | --- | --- | --- | 2,63 | 2,61 | --- | --- | --- |
| COEFFICIENT ρ FOR MODIFYING CORRECTION AMOUNT OF FRONT GROUP 226F | --- | --- | --- | 1,10 | --- | --- | --- | --- | --- | --- | 1.06 | 1.06 | --- | --- | --- |
| COEFFICIENT τ FOR MODIFYING CORRECTION AMOUNT (θ) OF REAR GROUP 226R | --- | --- | --- | 1.05 | --- | --- | --- | --- | --- | --- | 1.01 | 1.01 | --- | --- | --- |
| COEFFICIENT χ FOR MODIFYING CORRECTION AMOUNT OF HIGHER-ORDER ILLUMINANCE IRREGULARITY ADJUSTMENT UNIT 232 | --- | --- | --- | 1,08 | --- | --- | --- | --- | --- | --- | 1,03 | 1.02 | --- | --- | --- |

FIG. 23

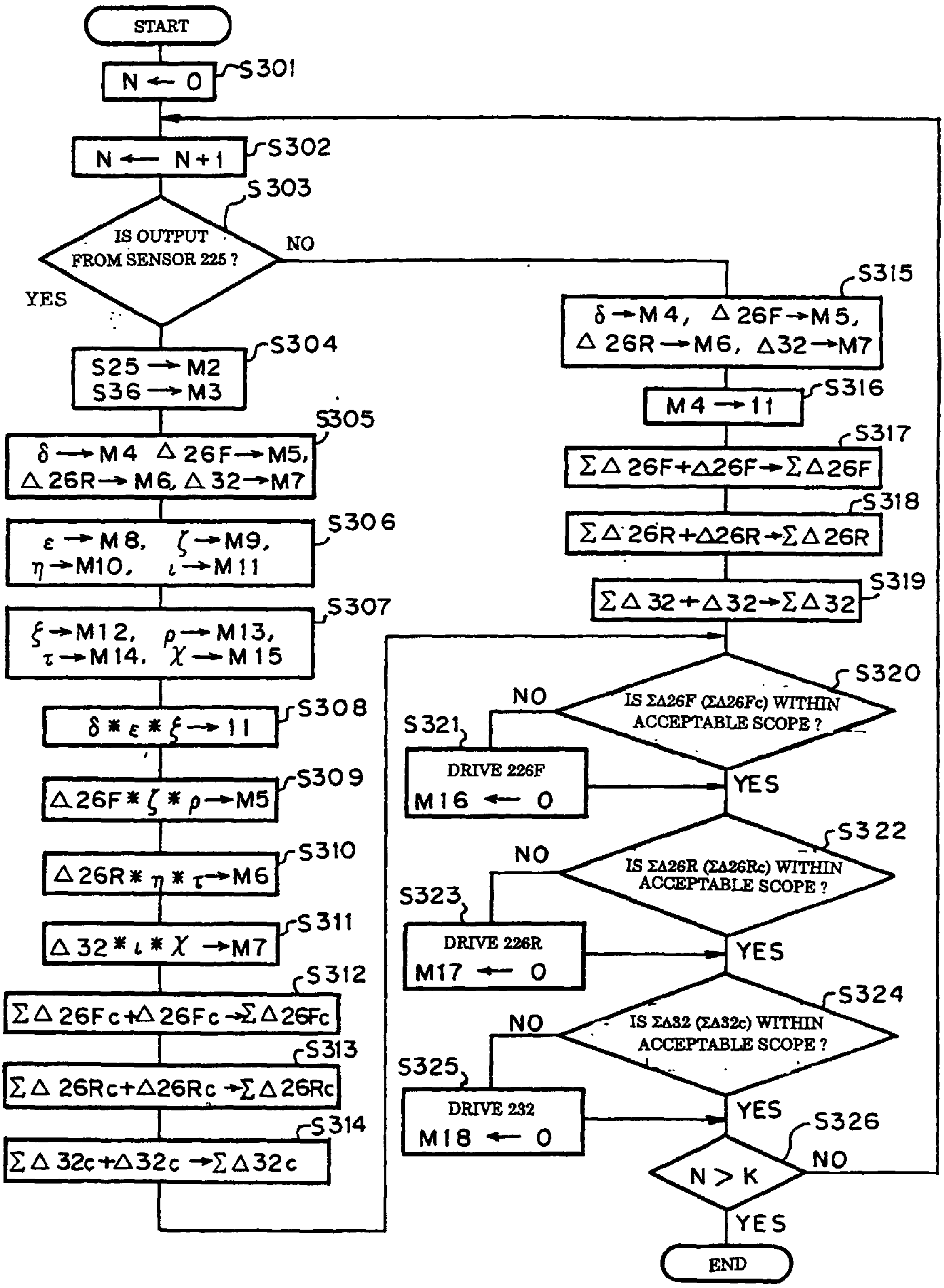
START
N ← 0
S301
N ← N+1
S302
IS OUTPUT FROM SENSOR 225 ?
S303
YES
NO
S25 → M2
S36 → M3
S304
δ → M4 Δ 26F → M5,
Δ 26R → M6, Δ 32 → M7
S305
ε → M8, ζ → M9,
η → M10, ι → M11
S306
ξ → M12, ρ → M13,
τ → M14, χ → M15
S307
δ * ε * ξ → 11
S308
Δ26F * ζ * ρ → M5
S309
Δ 26R * η * τ → M6
S310
Δ 32 * ι * χ → M7
S311
ΣΔ 26Fc + Δ 26Fc → ΣΔ 26Fc
S312
ΣΔ 26Rc + Δ26Rc → ΣΔ 26Rc
S313
ΣΔ 32c + Δ32c → ΣΔ32c
S314
δ → M4, Δ 26F → M5,
Δ 26R → M6, Δ32 → M7
S315
M4 → 11
S316
ΣΔ 26F + Δ26F → ΣΔ26F
S317
ΣΔ 26R + Δ26R → ΣΔ 26R
S318
ΣΔ 32 + Δ32 → ΣΔ32
S319
IS ΣΔ26F (ΣΔ26Fc) WITHIN ACCEPTABLE SCOPE ?
S320
NO
YES
DRIVE 226F
M16 ← 0
S321
IS ΣΔ26R (ΣΔ26Rc) WITHIN ACCEPTABLE SCOPE ?
S322
NO
YES
DRIVE 226R
M17 ← 0
S323
IS ΣΔ32 (ΣΔ32c) WITHIN ACCEPTABLE SCOPE ?
S324
NO
YES
DRIVE 232
M18 ← 0
S325
N > K
S326
NO
YES
END

FIG. 24

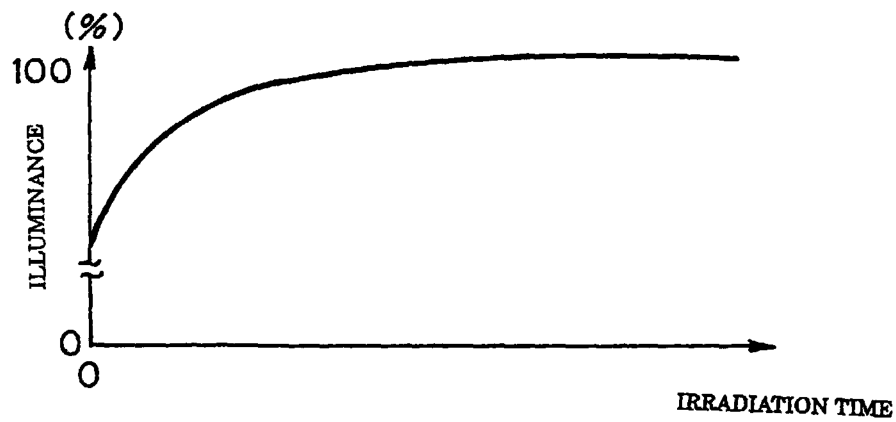

FIG. 25

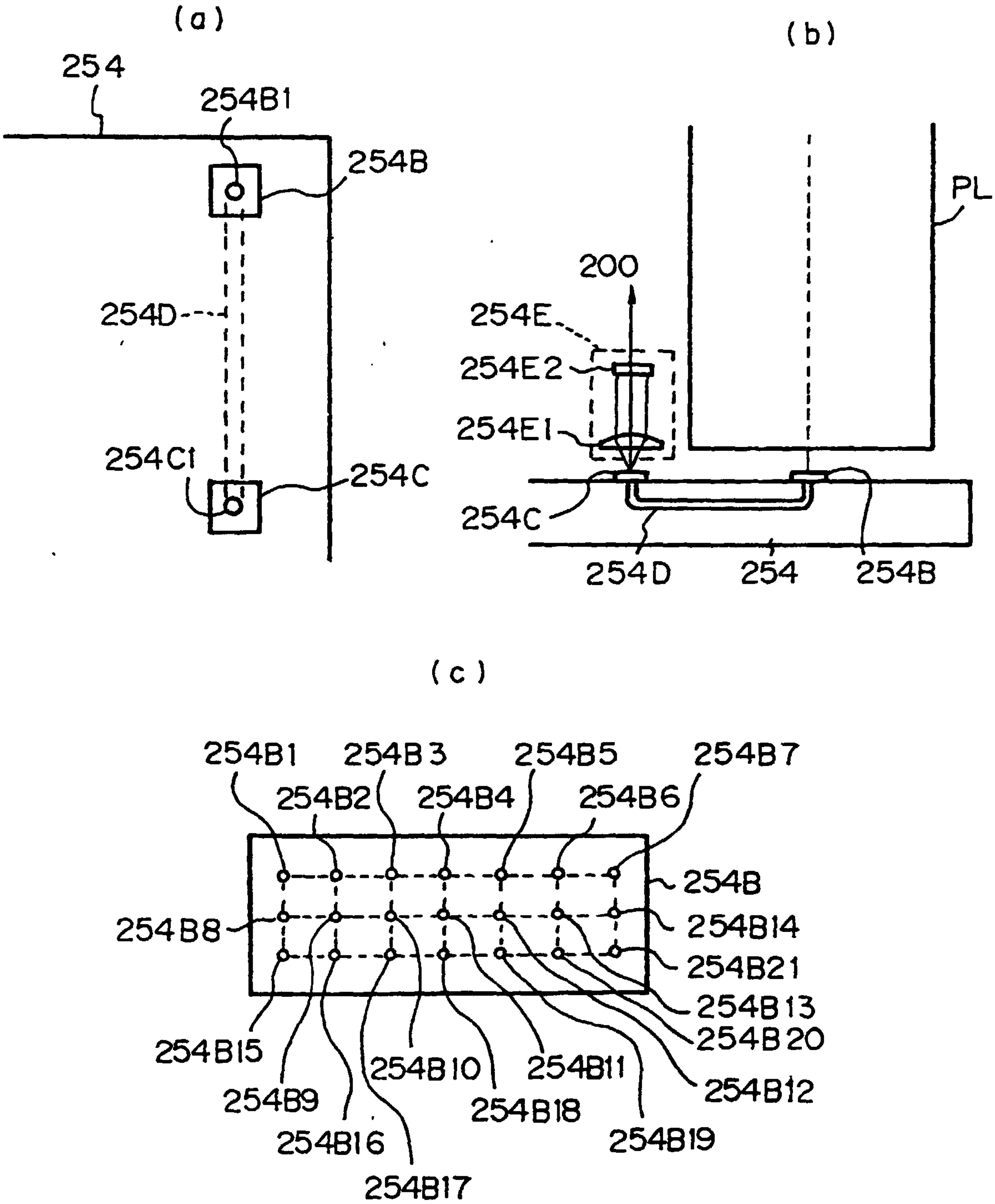
(a)
254
254B1
254B
254D
254C1
254C
(b)
PL
200
254E
254E2
254E1
254C
254D
254
254B
(c)
254B1
254B3
254B5
254B7
254B2
254B4
254B6
254B
254B8
254B14
254B21
254B13
254B20
254B15
254B10
254B11
254B12
254B9
254B18
254B16
254B19
254B17

FIG. 26

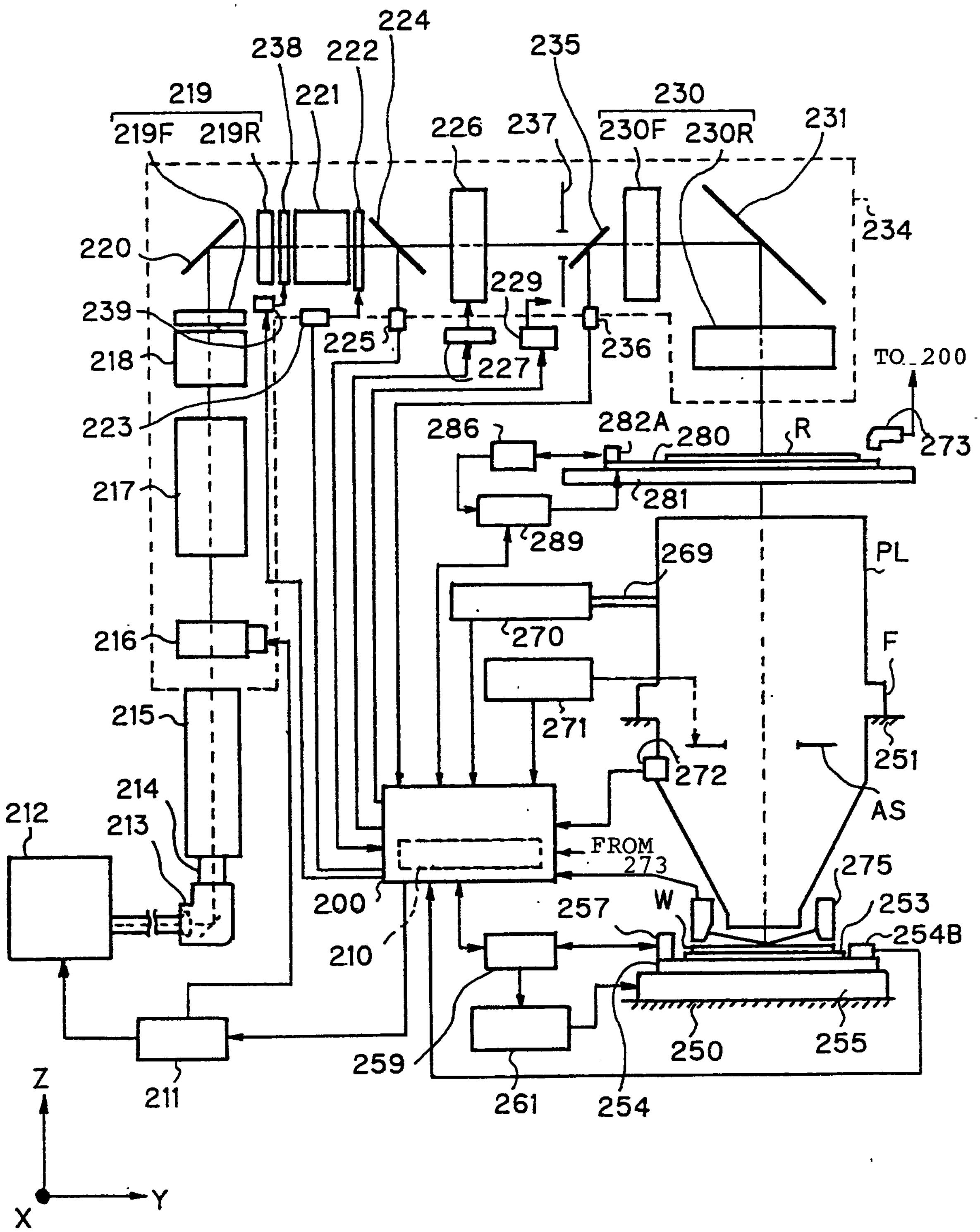
224
238
222
235
219
221
230
219F
219R
226
237
230F
230R
231
234
220
229
239
225
236
218
227
TO 200
223
286
282A
280
R
273
281
217
289
269
PL
270
216
F
215
271
251
272
214
AS
212
213
FROM
273
275
257
W
253
200
254B
210
259
250
255
Z
211
261
254
Y
X

FIG. 27

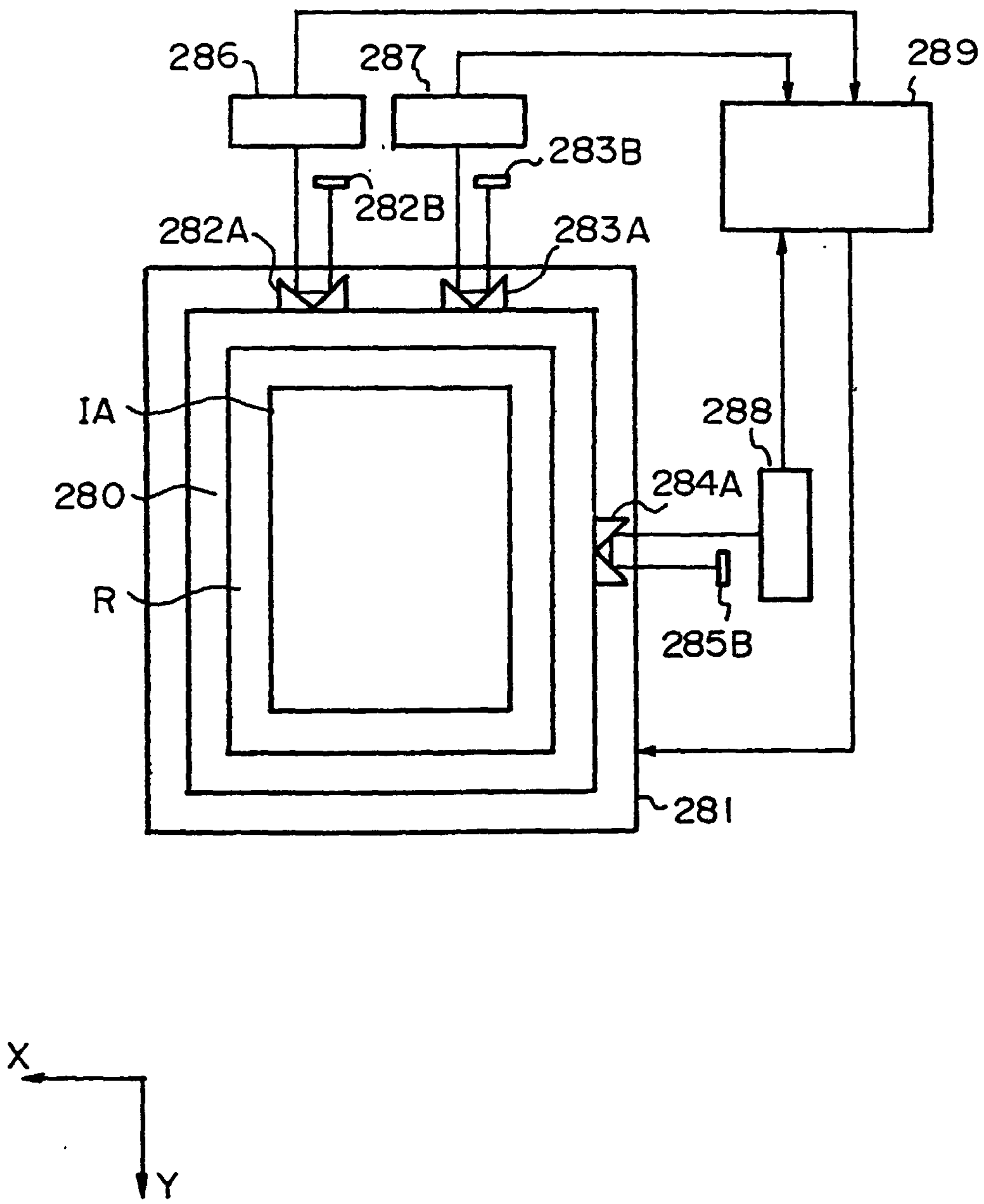

FIG. 28

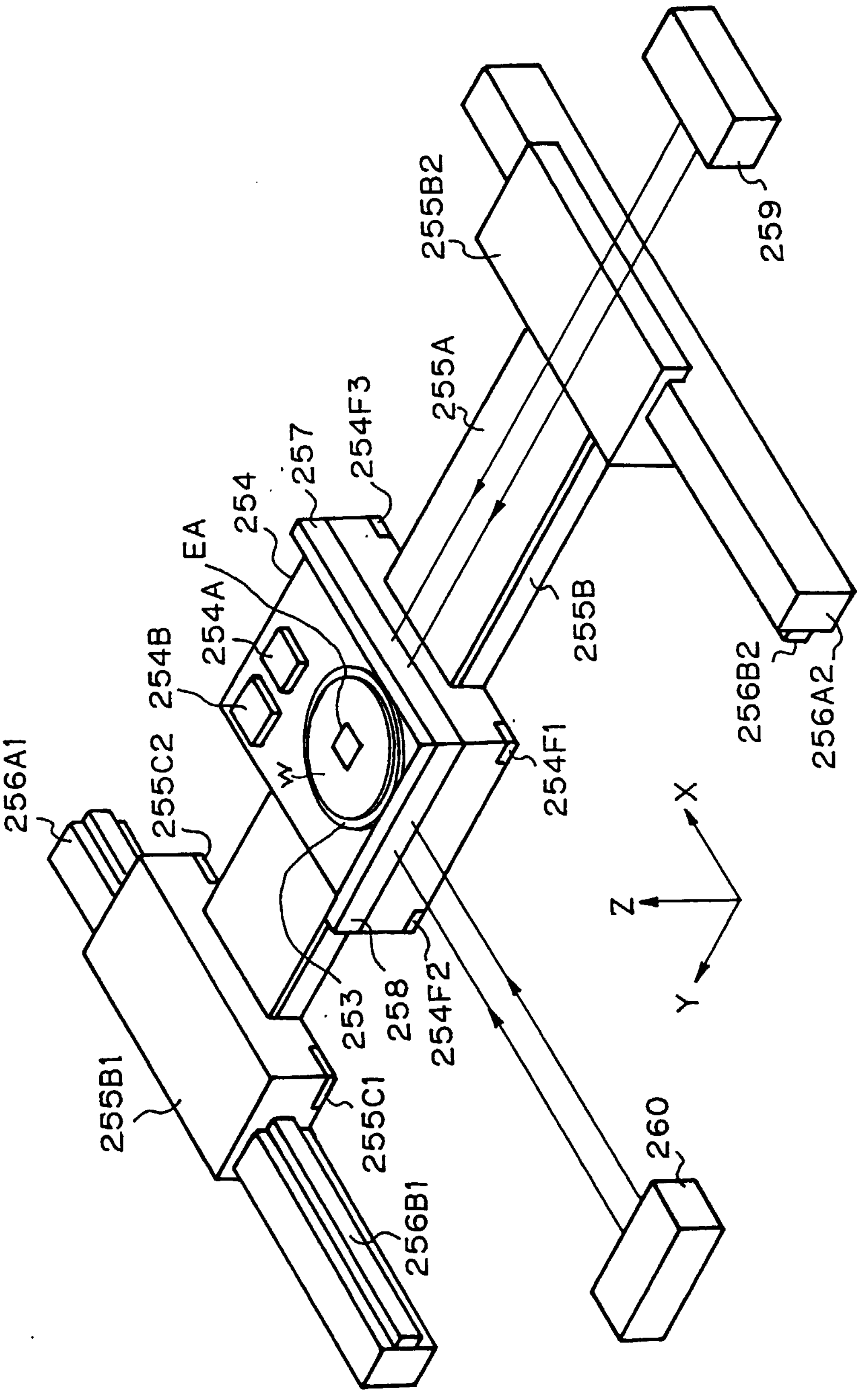

256A1
255C2
254B
254A
EA
254
257
254F3
255A
255B2
259
255B
256B2
256A2
254F1
X
Z
Y
W
253
258
254F2
255B1
255C1
256B1
260

FIG. 29

(a)

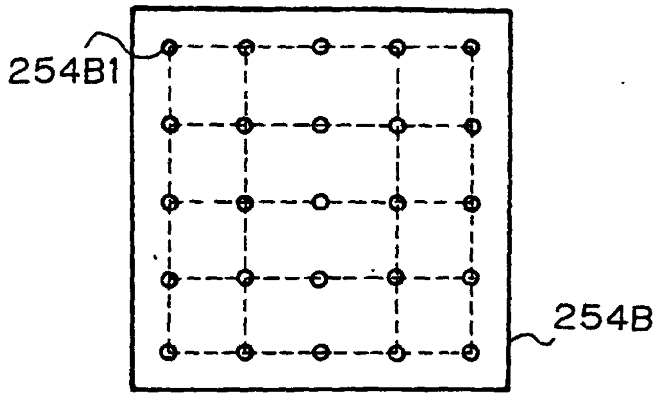


(b)

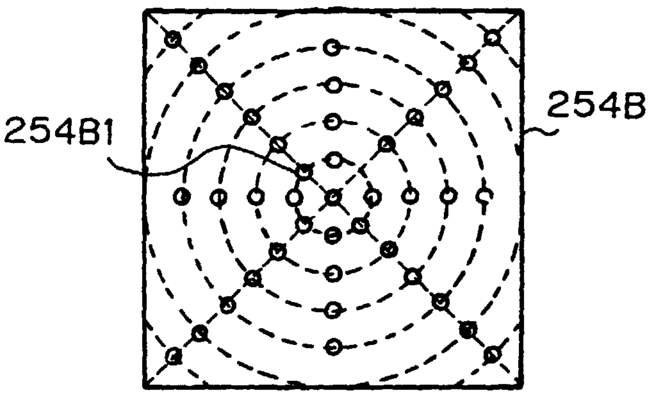

FIG. 30

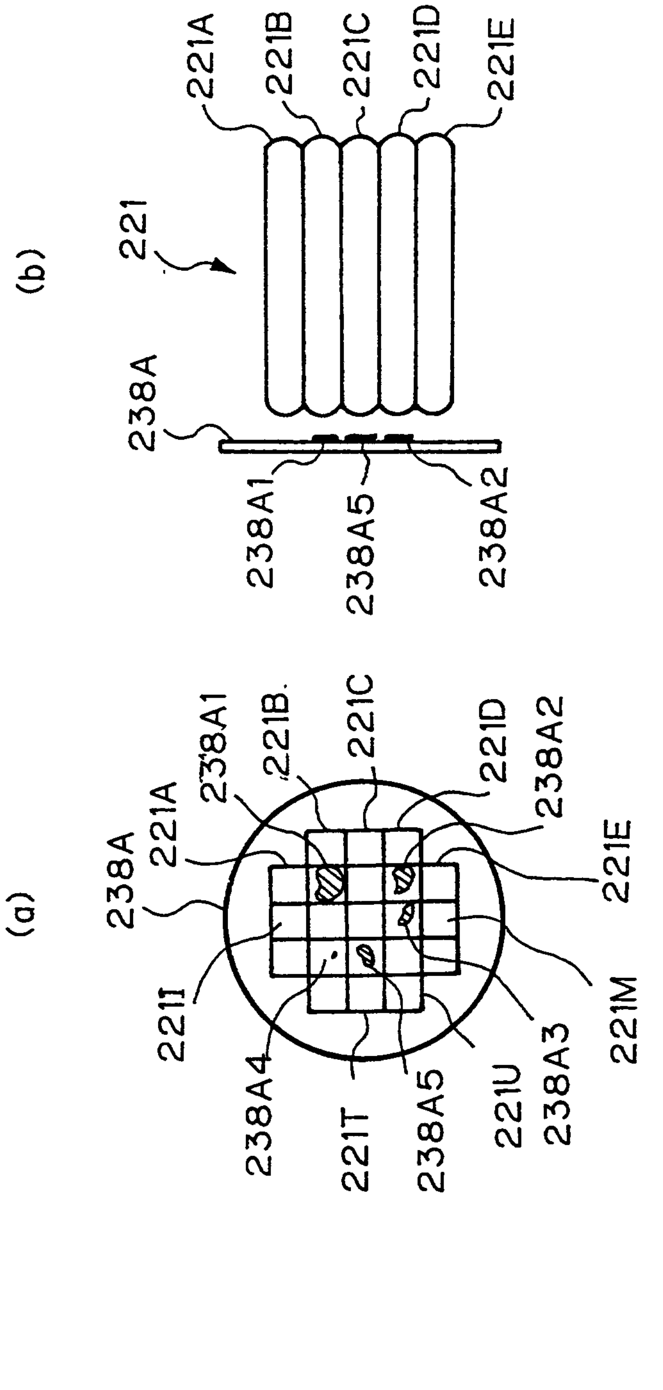
(a)
238A
221A
238A1
221B
221C
221D
238A2
221E
221M
238A3
221U
238A5
221T
238A4
221I
(b)
221
221A
221B
221C
221D
221E
238A
238A1
238A5
238A2

FIG. 31

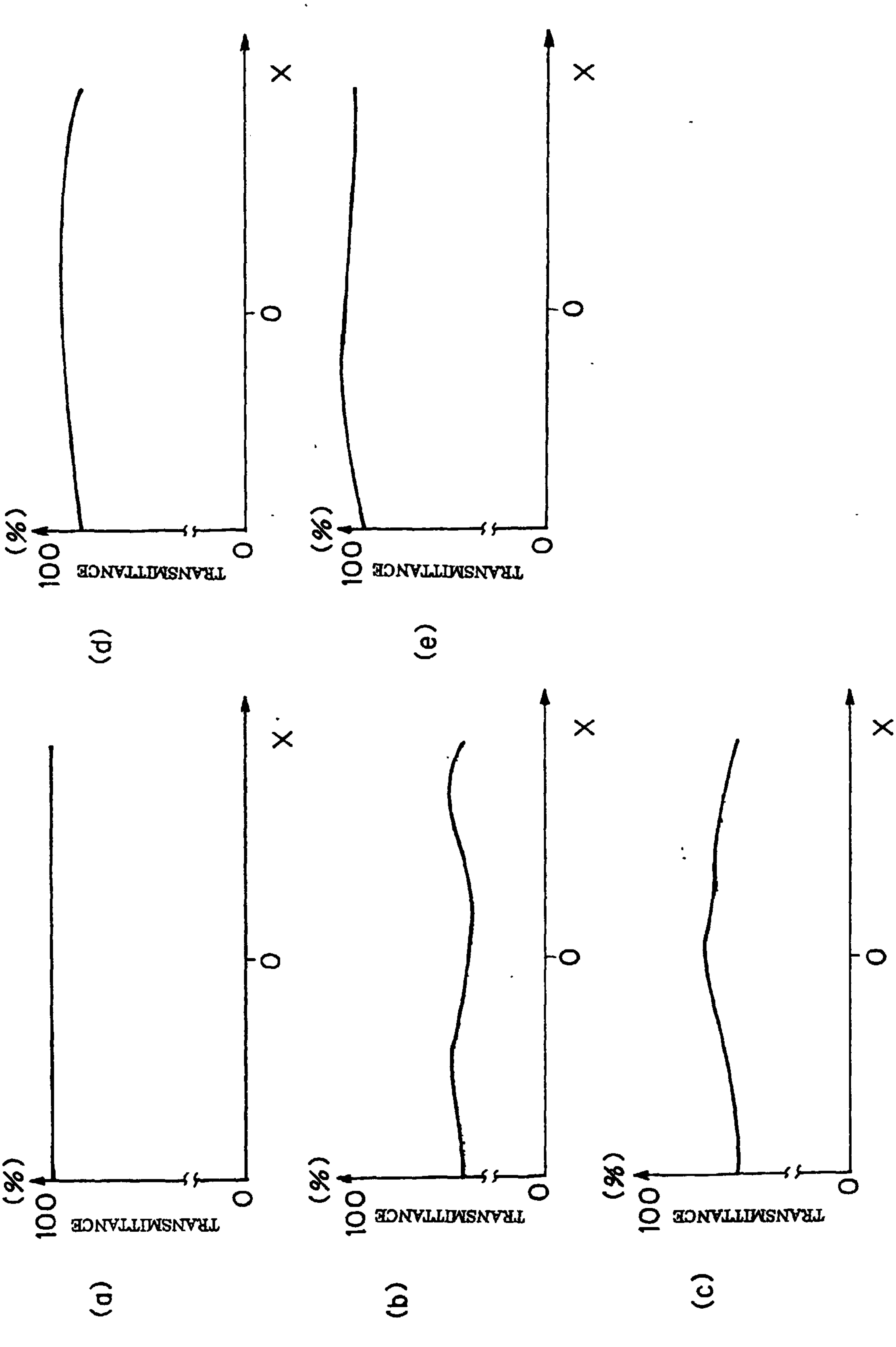

FIG. 32

(a) (b) (c)

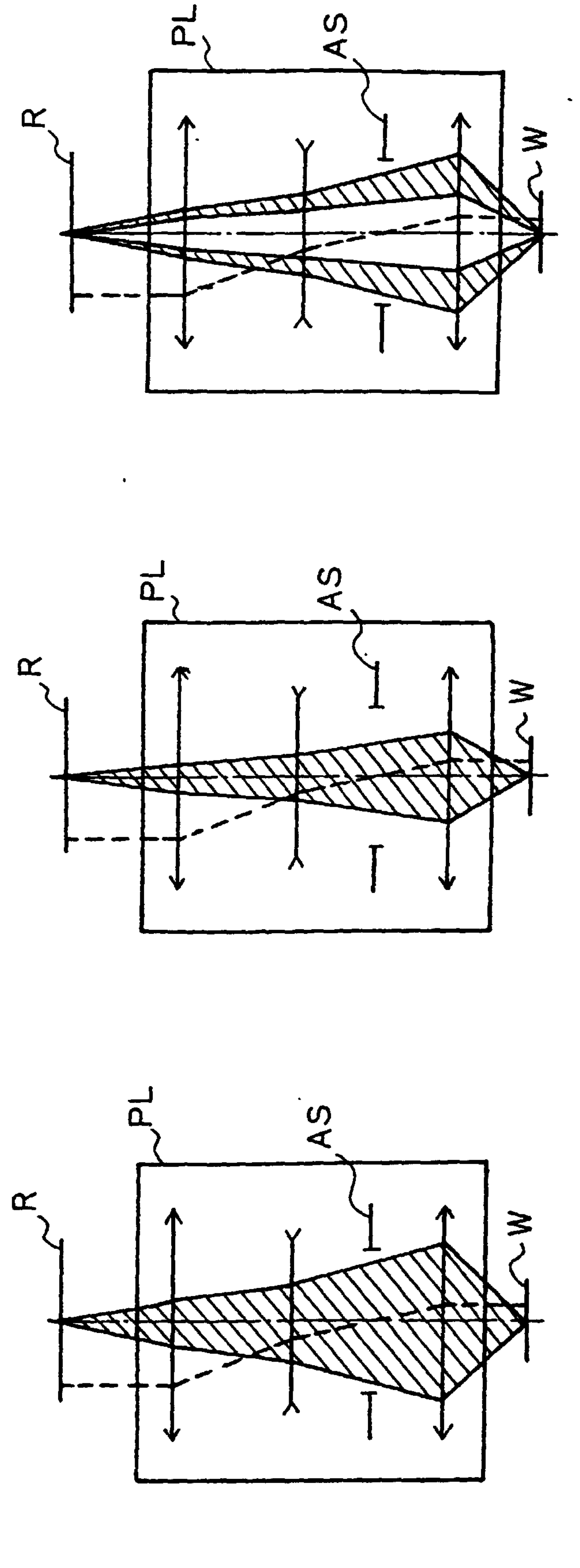

FIG. 33

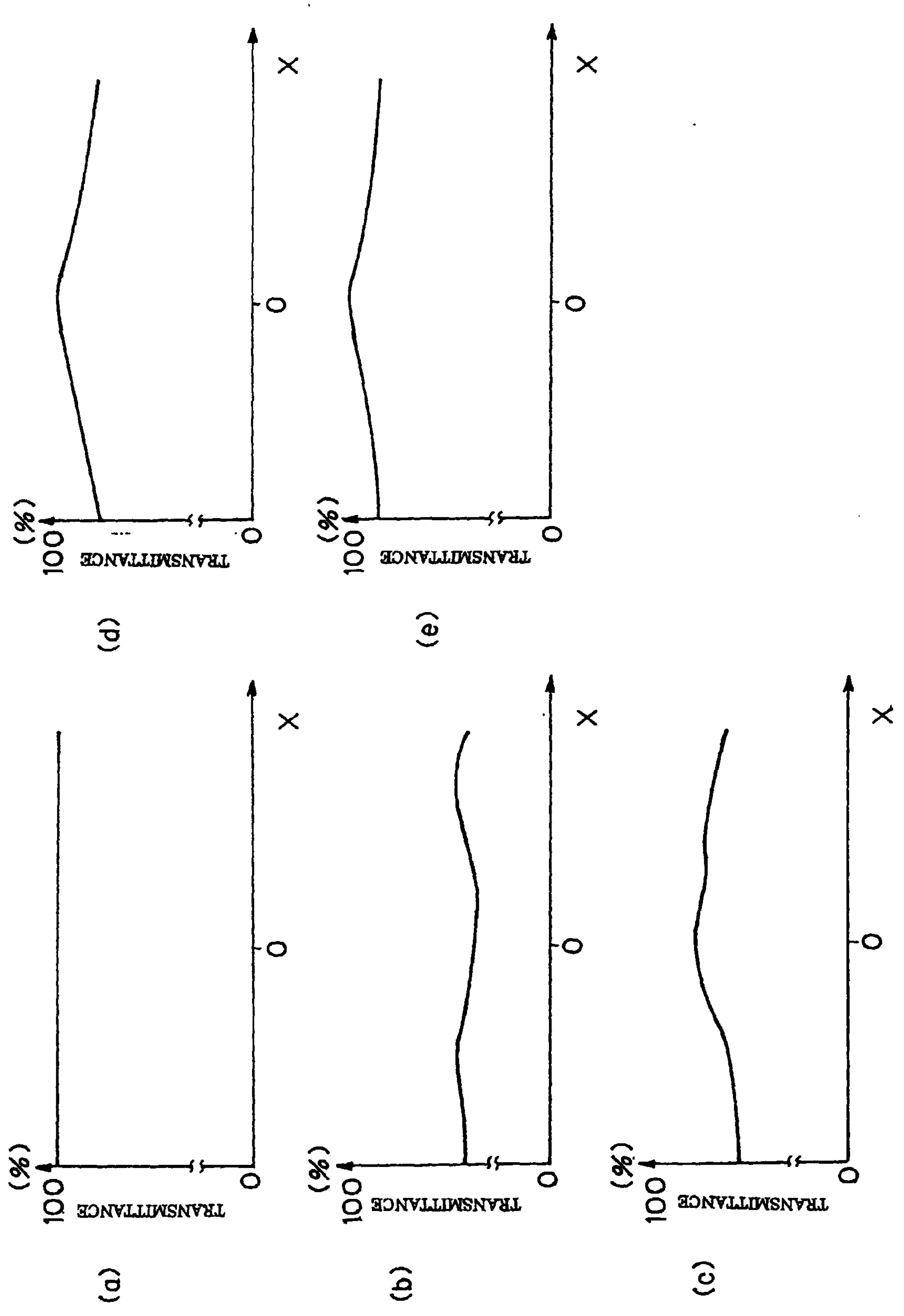

FIG. 34

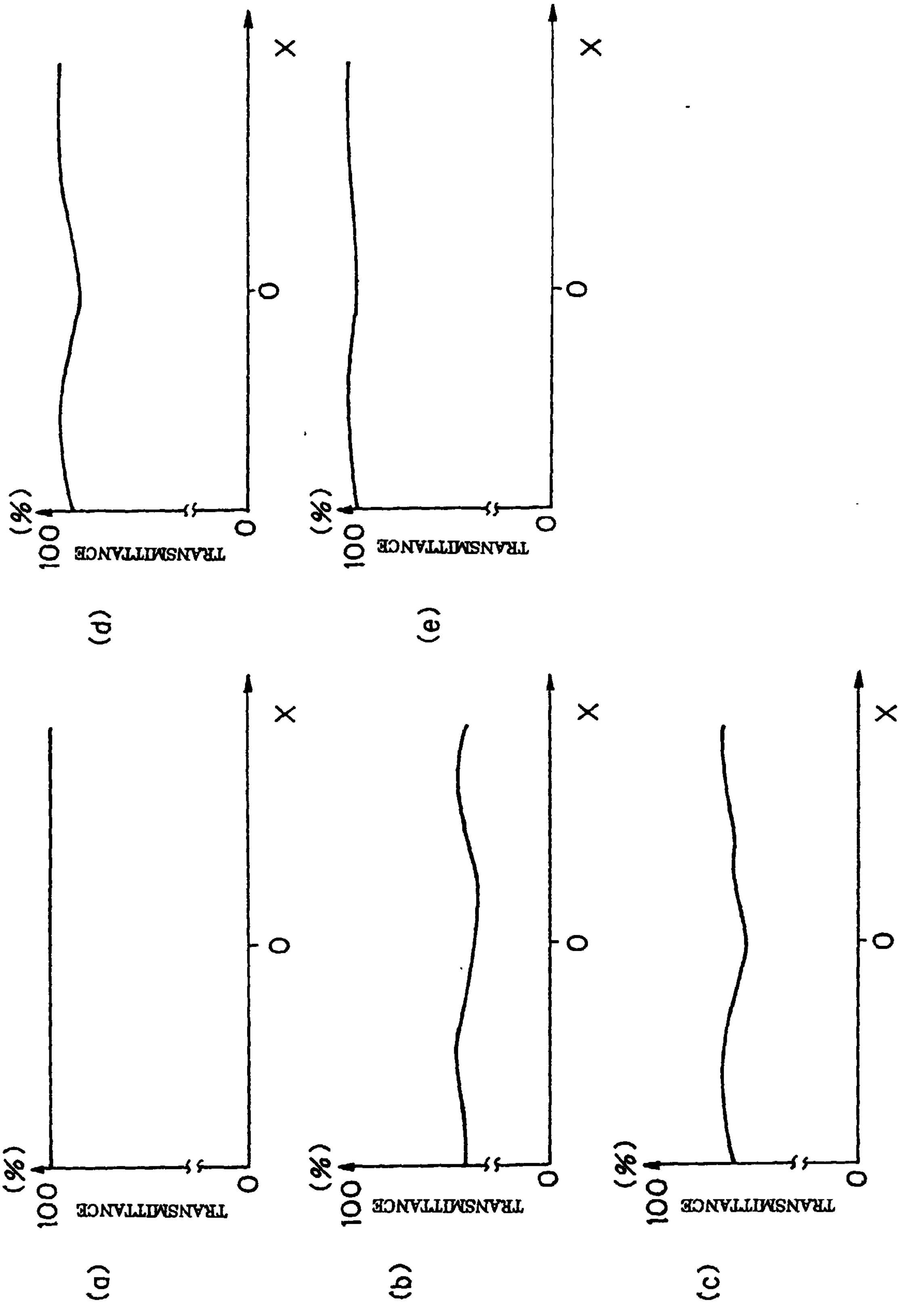

## INTERNATIONAL SEARCH REPORT

International application No.
PCT/JP98/01777

A. CLASSIFICATION OF SUBJECT MATTER
Int.Cl$^{6}$ H01L21/027, G03F7/20

According to International Patent Classification (IPC) or to both national classification and IPC

B. FIELDS SEARCHED

Minimum documentation searched (classification system followed by classification symbols)
Int.Cl$^{6}$ H01L21/027, G03F7/20

Documentation searched other than minimum documentation to the extent that such documents are included in the fields searched
Jitsuyo Shinan Koho 1922-1998 Toroku Jitsuyo Shinan Koho 1994-1998
Kokai Jitsuyo Shinan Koho 1971-1998

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP, 6-77107, A (Yamagata Nippon Denki K.K.), March 18, 1994 (18. 03. 94), Fig. 1 (Family: none) | 1-61 |
| A | JP, 2-106917, A (Nikon Corp.), April 19, 1990 (19. 04. 90), Fig. 2 (Family: none) | 1-61 |
| A | JP, 7-29810, A (Canon Inc.), January 31, 1995 (31. 01. 95), Fig. 1 & US, 5526093, A | 1-61 |
| A | JP, 5-335208, A (Nikon Corp.), December 17, 1993 (17. 12. 93), Fig. 1 (Family: none) | 1-61 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| July 14, 1998 (14. 07. 98) | July 21, 1998 (21. 07. 98) |
| Name and mailing address of the ISA/ Japanese Patent Office | Authorized officer |
| Facsimile No. | Telephone No. |

Form PCT/ISA/210 (second sheet) (July 1992)